# EUROPEAN PATENT SPECIFICATION

(11) **EP 4 253 389 B1**
(45) Date of publication and mention of the grant of the patent: **26.11.2025**
(21) Application number: 22776154.1
(22) Date of filing: 25.03.2022
(51) Int. Cl.: C07F 5/02, C09D 4/00, H10K 85/30, H10K 85/60, H10K 50/155, H10K 50/17

(54) **COMPOUND, COATING COMPOSITION COMPRISING SAME, ORGANIC LIGHT-EMITTING DEVICE USING SAME, AND MANUFACTURING METHOD THEREFOR**
VERBINDUNG, BESCHICHTUNGSZUSAMMENSETZUNG DAMIT, ORGANISCHE LICHTEMITTIERENDE VORRICHTUNG DAMIT UND HERSTELLUNGSVERFAHREN DAFÜR
COMPOSÉ, COMPOSITION DE REVÊTEMENT LE COMPRENANT, DISPOSITIF ÉLECTROLUMINESCENT ORGANIQUE L'UTILISANT ET PROCÉDÉ DE FABRICATION ASSOCIÉ

(30) Priority: 25.03.2021 KR 20210038765
(43) Date of publication of application: 04.10.2023
(73) Proprietor: LG Chem, Ltd., Seoul 07336 (KR)
(72) Inventor: LEE, Ho Gyu, Daejeon 34122 (KR); LEE, Jaechol, Daejeon 34122 (KR); LEE, Jiyoung, Daejeon 34122 (KR); KANG, Sungkyoung, Daejeon 34122 (KR); LEE, Keunsoo, Daejeon 34122 (KR); KANG, Eunhye, Daejeon 34122 (KR)
(74) Representative: Hoffmann Eitle
(86) International application number: PCT/KR2022/004232
(87) International publication number: WO 2022/203454

(56) References cited:
- WO-A1-2018/097659
- WO-A1-2019/059331
- JP-A- 2000 178 281
- JP-A- 2020 053 671
- JP-A- H08 127 611
- JP-A- H11 286 491
- KR-A- 20180 125 940

## Description

### [Technical Field]

The present specification claims priority to and the benefit of Korean Patent Application No. 10-2021-0038765 filed in the Korean Intellectual Property Office on March 25, 2021.

The present specification relates to a compound, a coating composition including the compound, an organic light emitting device formed by using the coating composition, and a method of manufacturing the same.

### [Background Art]

An organic light emission phenomenon is one of the examples of converting an electric current into visible rays through an internal process of a specific organic molecule. The principle of the organic light emission phenomenon is as follows. When an organic material layer is disposed between an anode and a cathode and an electric current is applied between the two electrodes, electrons and holes are injected into the organic material layer from the cathode and the anode, respectively. The electrons and the holes which are injected into the organic material layer are recombined to form an exciton, and the exciton falls down again to the ground state to emit light. An organic light emitting device using this principle may be generally composed of a cathode, an anode, and an organic material layer disposed therebetween, for example, an organic material layer including a hole injection layer, a hole transport layer, a light emitting layer, an electron transport layer, and the like.

In order to manufacture an organic light emitting device in the related art, a deposition process has been usually used. However, when an organic light emitting device is manufactured by a deposition process, there is a problem in that the loss of materials frequently occurs, so that in order to solve the problem, a technology of manufacturing a device by a solution process capable of increasing the production efficiency due to the low loss of materials has been developed, and there is a need for developing a material that may be used during the solution process.

A material used in an organic light emitting device for a solution process needs to have properties described below.

First, the material used in the organic light emitting device needs to be able to form a storable homogenous solution. Since a commercialized material for a deposition process has good crystallinity so that the material is not dissolved well in a solution or the crystals thereof are easily formed even though the material forms a solution, it is highly likely that according to the storage period, the concentration gradient of the solution varies or a defective device is formed.

Second, a material used for a solution process needs to be excellent in coatability such that during the formation of a thin film, a thin film having a uniform thickness may be formed without the occurrence of holes or an aggregation phenomenon.

Third, layers in which the solution process is performed needs to be resistant to the solvents and materials used in a process of forming other layers, and are required to have excellent current efficiency and excellent service life characteristics when an organic light emitting device is manufactured. Therefore, there is a need for developing a new organic material in the art.

JP 2020-053671 A and WO 2019/059331 A1 describe compositions for an organic electroluminescent element containing an electron acceptable compound and a charge transport compound. KR 2018 0125940 A describes a composition for a charge transport film comprising an electron-accepting compound.

### [Detailed Description of the Invention]

### [Technical Problem]

An object of the present specification is to provide a compound for a solution process and an organic light emitting device formed using the same.

### [Technical Solution]

An exemplary embodiment of the present specification provides a compound represented by the following Chemical Formula 1. 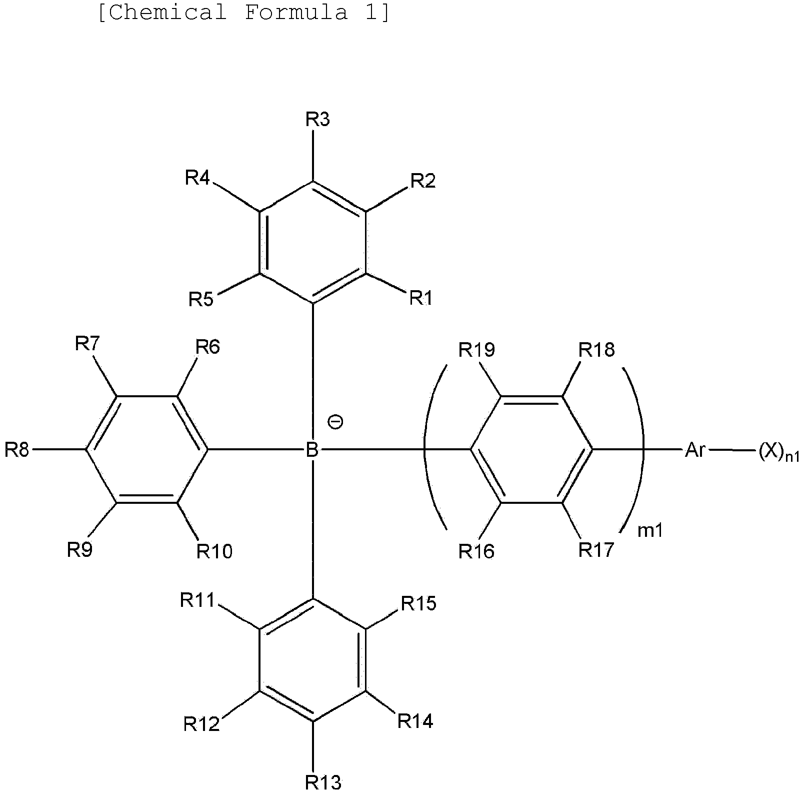 In Chemical Formula 1,
R1 to R19 are the same as or different from each other, and are each independently hydrogen, deuterium, a fluoro group, a fluoroalkyl group, a cyano group, or a substituted or unsubstituted alkyl group,
Ar is a substituted or unsubstituted (n1+1)-valent aryl group,
X is selected from the following structures: 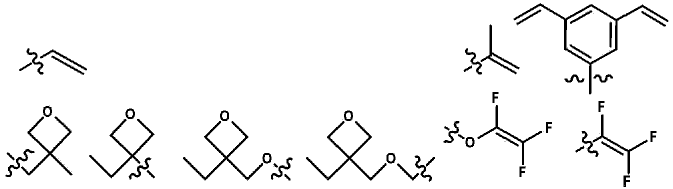 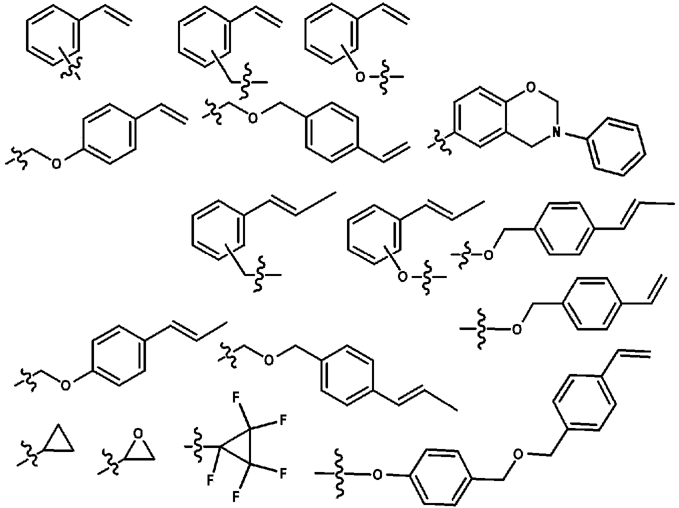 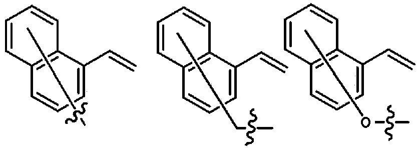 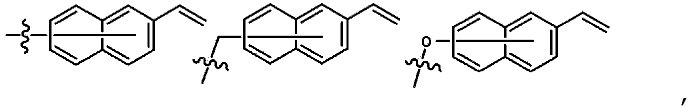 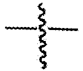 is a moiety to be bonded,
m1 is an integer from 1 to 3, and when m1 is 2 or higher, two or more substituents in the parenthesis are the same as or different from each other, and
n1 is an integer from 1 to 5, and when n1 is 2 or higher, two or more substituents in the parenthesis are the same as or different from each other.

Further, another exemplary embodiment of the present specification provides a coating composition including the compound.

In addition, still another exemplary embodiment of the present specification also provides an organic light emitting device including: a first electrode; a second electrode; and an organic material layer having one or more layers provided between the first electrode and the second electrode, in which one or more layers of the organic material layer include the above-described coating composition or a cured product thereof.

Finally, yet another exemplary embodiment of the present specification provides a method for manufacturing an organic light emitting device, the method including: preparing a substrate; forming a first electrode on the substrate; forming an organic material layer having one or more layers on the first electrode; and forming a second electrode on the organic material layer, in which the forming of the organic material layer includes forming the organic material layer having one or more layers by using the coating composition.

### [Advantageous Effects]

Since the compound according to an exemplary embodiment of the present invention can be used as a material for a solution process when an organic material layer of an organic light emitting device is manufactured, it is possible to provide a device which enables a large area of the device and has a low driving voltage, a high light emitting efficiency, and high service life characteristics.

The compound of the present disclosure is more suitable as a material for a solution process due to larger solubility for a solvent than a compound having a symmetric structure, in which all four substituents bonded at the center of a boron anion have the same structure, because one or more of the four substituents of the compound of the present disclosure have an asymmetric structure having a structure different from the other substituents.

Further, the compound of the present disclosure is advantageous for curing, because X, which is a substituent including a vinyl group, is bonded to Ar while the compound has an asymmetric structure, and thus X, which is a substituent including a vinyl group, is located in the outer shell of a single molecule to increase the probability of encountering and being bonded to a vinyl group of another single molecule.

### [Brief Description of Drawings]

FIG. 1 illustrates an example of an organic light emitting device according to an exemplary embodiment of the present specification.
FIG. 2 is a view of measuring the mass of a cation in Compound 1.
FIG. 3 is a view of measuring the mass of an anion in Compound 1.
FIG. 4 is a view of measuring the NMR of Compound 2.
FIG. 5 is a view of measuring the NMR of Compound 3.
FIG. 6 is a view of measuring the NMR of Compound 4.
FIG. 7 is a set of film retention rate-related data measured in Experimental Example 1.
FIG. 8 is an MS spectrum of Chemical Formula A-C.
FIG. 9 is an MS spectrum of Chemical Formula A.
FIG. 10 is a view of measuring the NMR of Compound 5.
FIG. 11 is a view of measuring the NMR of Compound 6.

### <Explanation of Reference Numerals and Symbols>

101: Substrate
201: Anode
301: Hole injection layer
401: Hole transport layer
501: Light emitting layer
601: Layer which simultaneously transports and injects electrons
701: Cathode

### [Best Mode]

Hereinafter, the present specification will be described in detail.

An exemplary embodiment of the present specification provides a compound represented by the following Chemical Formula 1. 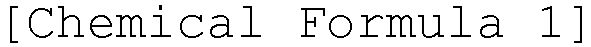 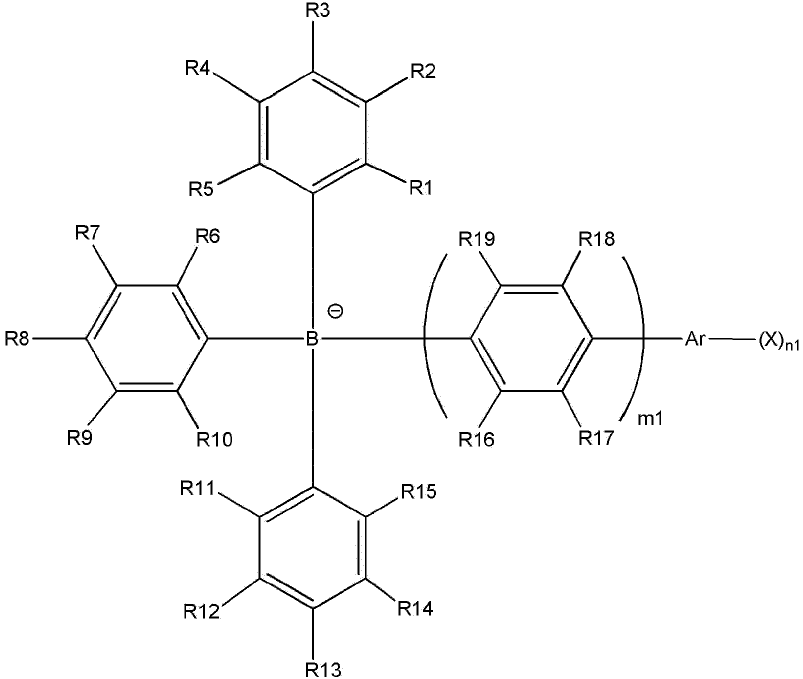 In Chemical Formula 1,
R1 to R19 are the same as or different from each other, and are each independently hydrogen, deuterium, a fluoro group, a fluoroalkyl group, a cyano group, or a substituted or unsubstituted alkyl group,
Ar is a substituted or unsubstituted (n1+1)-valent aryl group,
X is selected from the following structures: 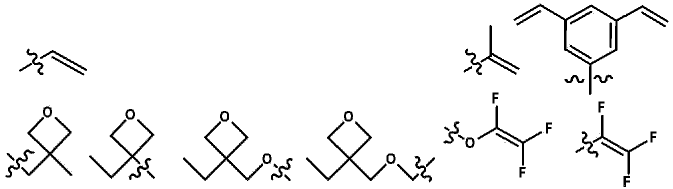 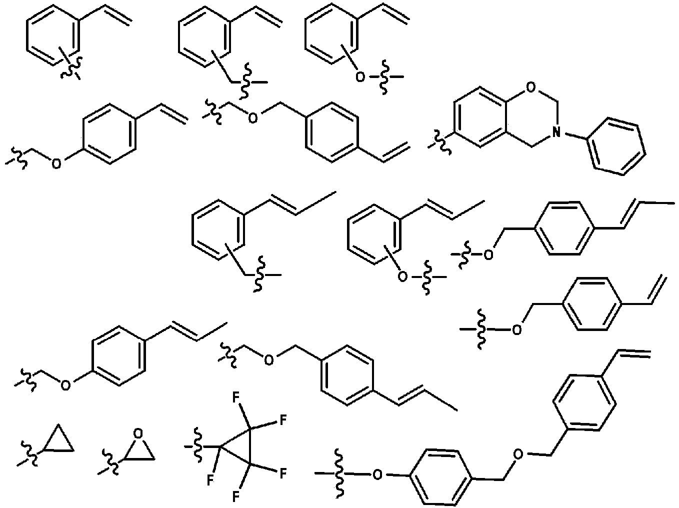 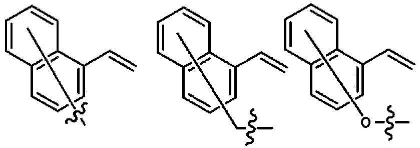 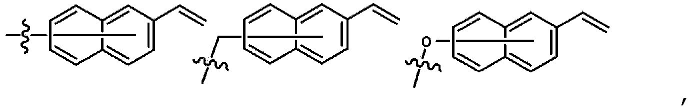 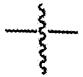 is a moiety to be bonded,
m1 is an integer from 1 to 3, and when m1 is 2 or higher, two or more substituents in the parenthesis are the same as or different from each other, and
n1 is an integer from 1 to 5, and when n1 is 2 or higher, two or more substituents in the parenthesis are the same as or different from each other.

When one member is disposed "on" another member in the present specification, this includes not only a case where the one member is brought into contact with another member, but also a case where still another member is present between the two members.

When one part "includes" one constituent element in the present specification, unless otherwise specifically described, this does not mean that another constituent element is excluded, but means that another constituent element may be further included.

In an exemplary embodiment of the present specification, the compound of Chemical Formula 1 takes electrons from a material used with the compound because a phenyl group, to which a fluoro group and/or a fluoroalkyl group are/is bonded, is bonded around a boron anion, resulting in a shortage of electrons in the compound. This has an effect of facilitating the production of holes in the material used with the compound of Chemical Formula 1.

In an exemplary embodiment of the present specification, the compound of Chemical Formula 1 is preferably compounds having solubility to a suitable organic solvent.

The compound according to an exemplary embodiment of the present specification is more suitable as a material for a solution process due to larger solubility for a solvent than a compound having a symmetric structure, in which all four substituents bonded at the center of a boron anion have the same structure, because one or more of the four substituents of the compound have an asymmetric structure having a structure different from the other substituents.

Furthermore, in the case of a compound according to an exemplary embodiment of the present specification, an organic light emitting device may be manufactured by a solution application method, thereby enabling a large area of the device to be implemented.

Further, the compound of the present disclosure is advantageous for curing, because X, which is a substituent including a vinyl group, is bonded to Ar while the compound has an asymmetric structure, and thus X, which is a substituent including a vinyl group, is located in the outer shell of a single molecule to increase the probability of encountering and being bonded to a vinyl group of another single molecule.

Hereinafter, the substituent of the present specification will be described in detail.

In the present specification, 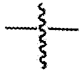 means a moiety bonded to another substituent or a bonding portion.

In the present specification, the term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more substituents are substituted, the two or more substituents may be the same as or different from each other.

In the present specification, the term "substituted or unsubstituted" means being substituted with one or more substituents selected from the group consisting of deuterium; a halogen group; a nitrile group; an alkyl group; a cycloalkyl group; an alkoxy group; an aryloxy group; an aryl group; and a heterocyclic group, or being substituted with a substituent to which two or more substituents among the substituents exemplified above are linked, or being unsubstituted. For example, "the substituent to which two or more substituents are linked" may be a biphenyl group. That is, the biphenyl group may also be an aryl group, and may be interpreted as a substituent to which two phenyl groups are linked.

In the present specification, a halogen group is a fluoro group (-F), a chloro group (-Cl), a bromo group (-Br), or an iodo group (-I).

In the present specification, the alkyl group may be straight-chained or branched, and the number of carbon atoms thereof is not particularly limited, but may be 1 to 60, and according to an exemplary embodiment, the number of carbon atoms of the alkyl group may be 1 to 40. According to another exemplary embodiment, the number of carbon atoms of the alkyl group is 1 to 20. Specific examples of the alkyl group include a methyl group, an ethyl group, a propyl group, an isopropyl group, an n-butyl group, an isobutyl group, a tert-butyl group, an n-pentyl group, an n-hexyl group, an n-heptyl group, and the like, but are not limited thereto.

In the present specification, the above-described description on the alkyl group can be referred to, except that the alkylene group is a divalent alkyl group.

In the present specification, a fluoroalkyl group means an alkyl group substituted with a fluoro group, and specific examples thereof include a fluoromethyl group, a difluoromethyl group, a trifluoromethyl group, a fluoroethyl group, and the like, but are not limited thereto.

In the present specification, a cycloalkyl group is not particularly limited, but may have 3 to 60 carbon atoms, and according to an exemplary embodiment, the number of carbon atoms of the cycloalkyl group is 3 to 40. According to another exemplary embodiment, the number of carbon atoms of the cycloalkyl group is 3 to 20. Specific examples of the cycloalkyl group include a cyclopropyl group, a cyclobutyl group, a cyclopentyl group, a cyclohexyl group, a cycloheptyl group, a cyclooctyl group, and the like, but are not limited thereto.

In the present specification, the alkoxy group may be straight-chained or branched. The number of carbon atoms of the alkoxy group is not particularly limited, but may be 1 to 20. Specific examples of the alkoxy group include a methoxy group, an ethoxy group, an n-propoxy group, an n-butoxy group, a tert-butoxy group, an n-pentyloxy group, an n-hexyloxy group, an n-octyloxy group, an n-nonyloxy group, an n-decyloxy group, and the like, but are not limited thereto.

In the present specification, the aryl group is not particularly limited, but may have 6 to 60 carbon atoms, and may be a monocyclic aryl group or a polycyclic aryl group. According to an exemplary embodiment, the number of carbon atoms of the aryl group is 6 to 30. According to an exemplary embodiment, the number of carbon atoms of the aryl group is 6 to 20. Examples of the monocyclic aryl group include a phenyl group, a biphenyl group, a terphenyl group, and the like, but are not limited thereto. Examples of the polycyclic aryl group include a naphthyl group, an anthracenyl group, a phenanthrenyl group, a pyrenyl group, a perylenyl group, a triphenylenyl group, a chrysenyl group, a fluorenyl group, and the like, but are not limited thereto.

In the present specification, a fluorenyl group may be substituted, and two substituents may be bonded to each other to form a spiro structure.

When the fluorenyl group is substituted, the fluorenyl group may be a spirofluorenyl group such as 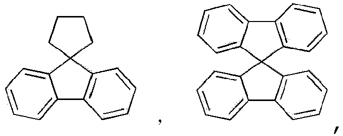 and a substituted fluorenyl group such as 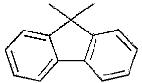 (a 9,9-dimethylfluorenyl group) and 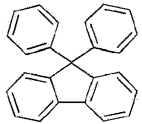 (a 9,9-diphenylfluorenyl group). However, the fluorenyl group is not limited thereto.

In the present specification, the above-described description on the aryl group can be referred to, except that the arylene group is a divalent aryl group.

In the present specification, a heterocyclic group is a heterocyclic group including one or more of N, O, P, S, Si, or Se as a heteroatom, and the number of carbon atoms thereof is not particularly limited, but may be 2 to 60. According to an exemplary embodiment, the number of carbon atoms of the heterocyclic group is 2 to 30. According to another exemplary embodiment, the number of carbon atoms of the heterocyclic group is 2 to 20. Examples of the heterocyclic group include a pyridyl group, a pyrrole group, a pyrimidyl group, a pyridazinyl group, a furanyl group, a thiophene group, a benzothiophene group, a benzofuran group, a dibenzothiophene group, a dibenzofuran group, and the like, but are not limited thereto.

In the present specification, the above-described description on the heterocyclic group may be applied to a heteroaryl group except for an aromatic heteroaryl group.

In the present specification, the above-described description on the aryl group is applied to an aryl group in the aryloxy group.

According to an exemplary embodiment of the present specification, R1 to R19 are the same as or different from each other, and are each independently hydrogen, deuterium, a fluoro group, a fluoroalkyl group, a cyano group, or a substituted or unsubstituted alkyl group.

In an exemplary embodiment of the present specification, R1 to R19 are the same as or different from each other, and are each independently hydrogen, deuterium, a fluoro group, a fluoroalkyl group having 1 to 10 carbon atoms, a cyano group, or a substituted or unsubstituted alkyl group having 1 to 10 carbon atoms.

In an exemplary embodiment of the present specification, R1 to R19 are the same as or different from each other, and are each independently a fluoro group or a fluoroalkyl group.

In another exemplary embodiment, R1 to R19 are the same as or different from each other, and are each independently a fluoro group or a fluoroalkyl group having 1 to 10 carbon atoms.

According to another exemplary embodiment, R1 to R19 are the same as or different from each other, and are each independently a fluoro group or a trifluoromethyl group.

According to still another exemplary embodiment, R1 to R15 are the same as or different from each other, and are each independently a fluoro group or a trifluoromethyl group.

According to yet another exemplary embodiment, R3, R8 and R13 are a trifluoromethyl group.

According to yet another exemplary embodiment, R1, R2, R4 to R7, R9 to R12, R14 and R15 are a fluoro group.

In an exemplary embodiment of the present specification, m1 is an integer from 1 to 3, and when m1 is 2 or higher, two or more substituents in the parenthesis are the same as or different from each other.

According to yet another exemplary embodiment, m1 is 1 or 2, and when m1 is 2, two substituents in the parenthesis are the same as or different from each other.

According to an exemplary embodiment of the present specification, Chemical Formula 1 is represented by the following Chemical Formula 2 or 3. 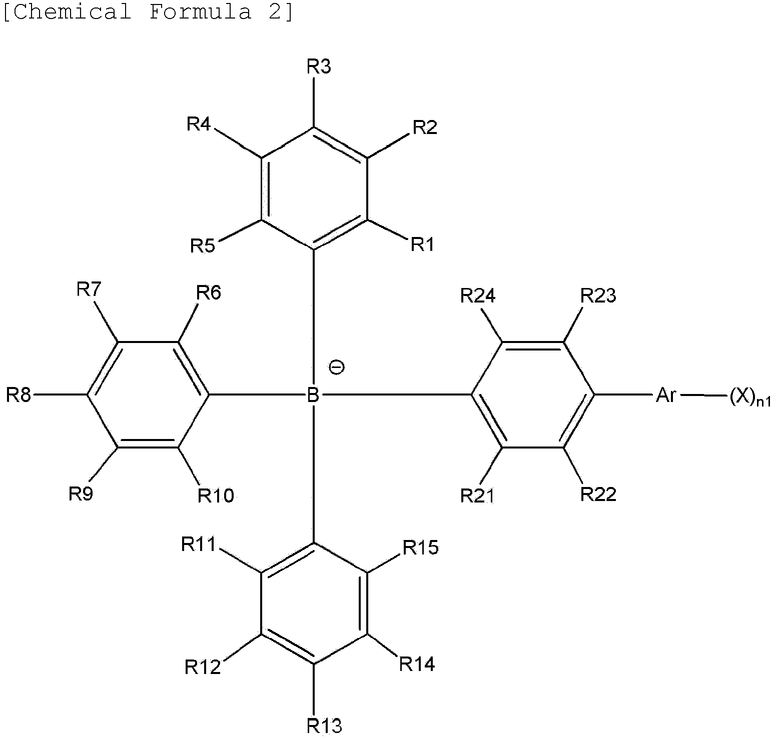 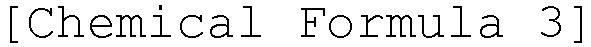 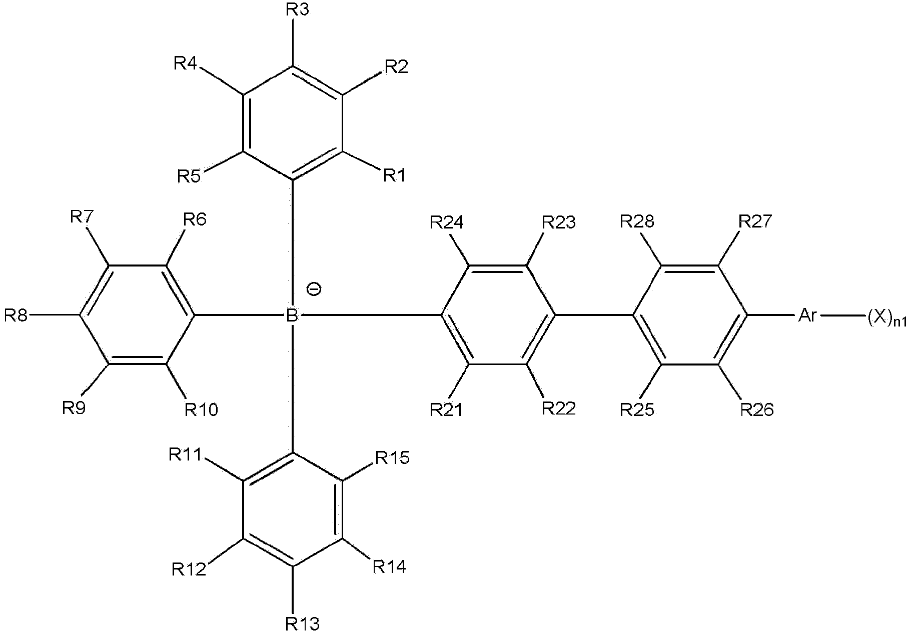 In Chemical Formulae 2 and 3,
R1 to R15, Ar, X and n1 are the same as those defined in Chemical Formula 1, and
R21 to R28 are the same as or different from each other, and are each independently hydrogen, deuterium, a fluoro group, a fluoroalkyl group, a cyano group, or a substituted or unsubstituted alkyl group.

According to an exemplary embodiment of the present specification, R21 to R28 are the same as or different from each other, and are each independently a fluoro group or a fluoroalkyl group.

According to another exemplary embodiment, R21 to R28 are the same as or different from each other, and are each independently a fluoro group or a fluoroalkyl group having 1 to 10 carbon atoms.

In another exemplary embodiment, R21 to R28 are the same as or different from each other, and are each independently a fluoro group or a trifluoromethyl group.

In still another exemplary embodiment, R21 to R28 are a fluoro group.

In an exemplary embodiment of the present specification, Ar is a substituted or unsubstituted (n1+1)-valent aryl group.

According to still another exemplary embodiment, Ar is a substituted or unsubstituted (n1+1)-valent aryl group having 6 to 30 carbon atoms.

In another exemplary embodiment, Ar is a (n1+1)-valent aryl group having 6 to 30 carbon atoms.

According to yet another exemplary embodiment, Ar is a substituted or unsubstituted (n1+1)-valent phenyl group.

In still another exemplary embodiment, Ar is a (n1+1)-valent phenyl group.

In an exemplary embodiment of the present specification, Chemical Formula 1 is represented by the following Chemical Formula 4. 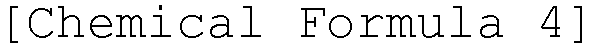 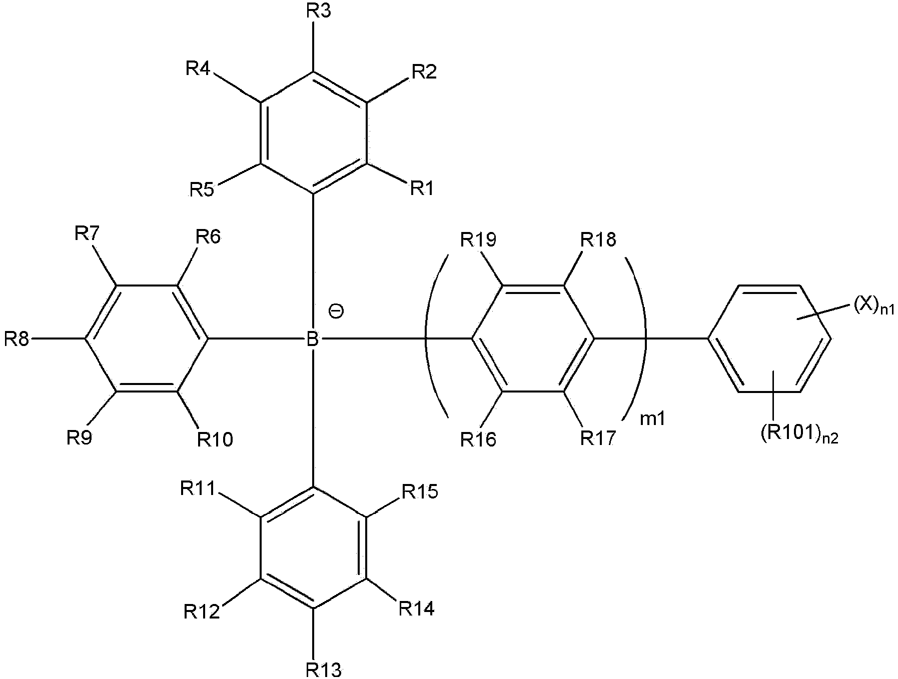 In Chemical Formula 4,
R1 to R19, X, n1 and m1 are the same as those defined in Chemical Formula 1,
R101 is hydrogen; deuterium; a halogen group; a substituted or unsubstituted alkyl group; a substituted or unsubstituted alkoxy group; a substituted or unsubstituted aryl group; or a substituted or unsubstituted heteroaryl group, and
n2 is an integer from 0 to 4, and when n2 is 2 or higher, two or more R101's are the same as or different from each other, and n1+n2 is 1 to 5.

According to an exemplary embodiment of the present specification, R101 is hydrogen or deuterium.

In an exemplary embodiment of the present specification, n2 is an integer from 0 to 3.

According to an exemplary embodiment of the present specification, Chemical Formula 2 is represented by the following Chemical Formula 5 or 6. 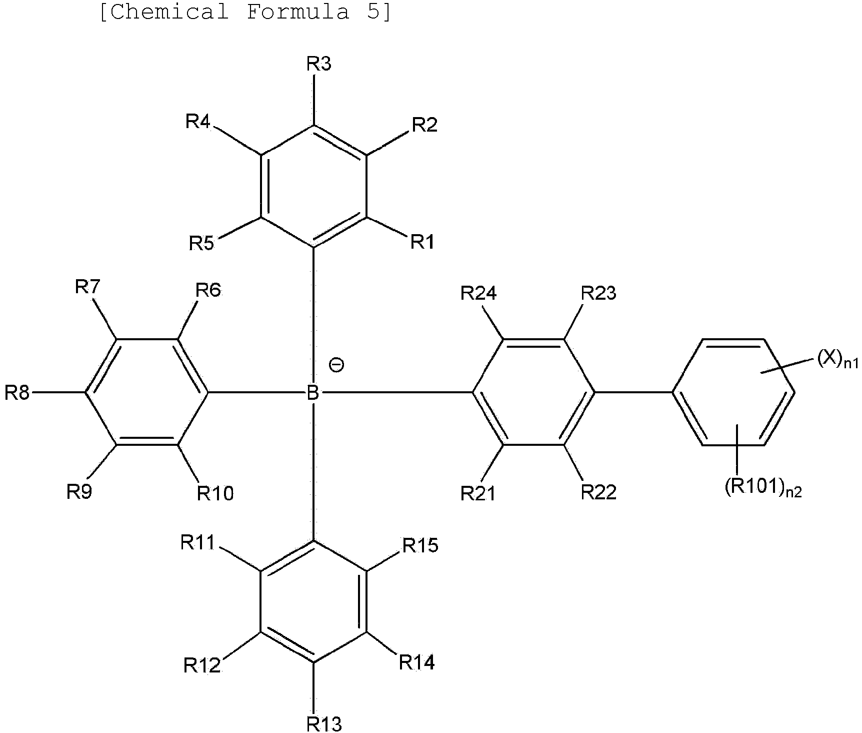 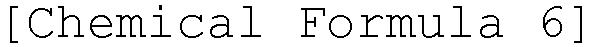 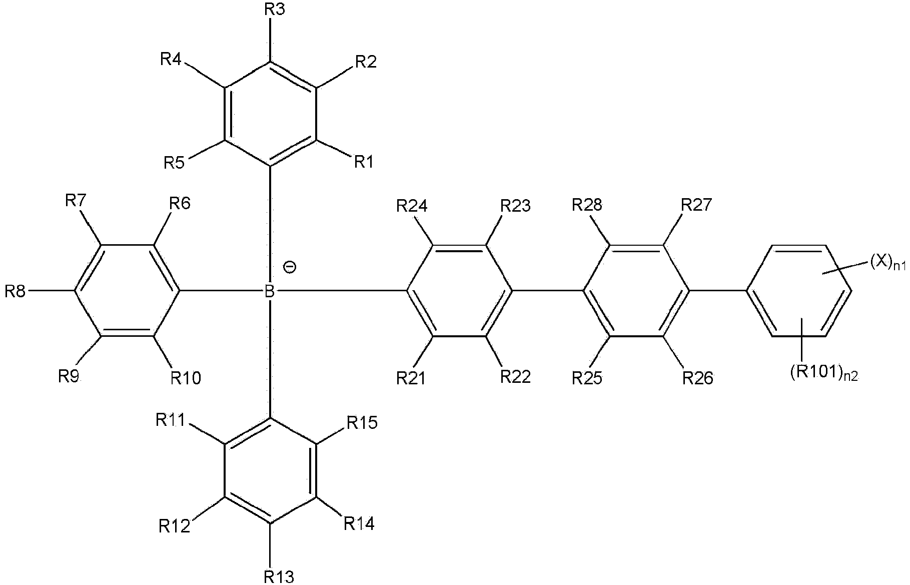 In Chemical Formulae 5 and 6,
R1 to R15, X and n1 are the same as those defined in Chemical Formula 1,
R21 to R28 are the same as or different from each other, and are each independently a fluoro group or a fluoroalkyl group,
R101 is hydrogen; deuterium; a halogen group; a substituted or unsubstituted alkyl group; a substituted or unsubstituted alkoxy group; a substituted or unsubstituted aryl group; or a substituted or unsubstituted heteroaryl group, and
n2 is an integer from 0 to 4, and when n2 is 2 or higher, two or more R101's are the same as or different from each other, and n1+n2 is 1 to 5.

In the present invention, X is selected from the following structures. 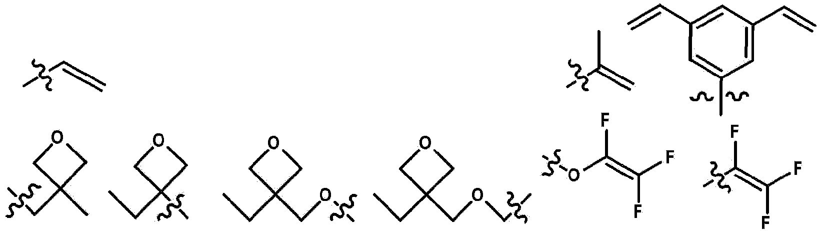 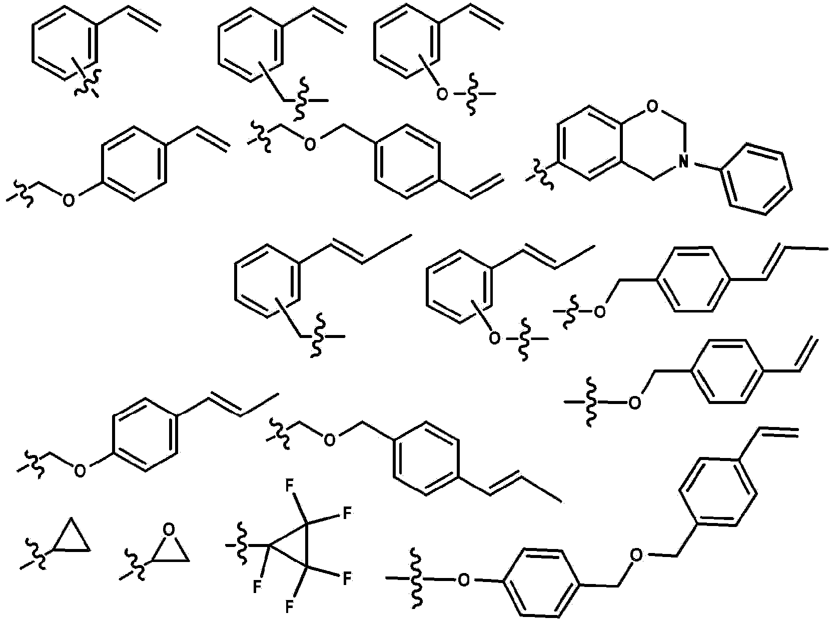 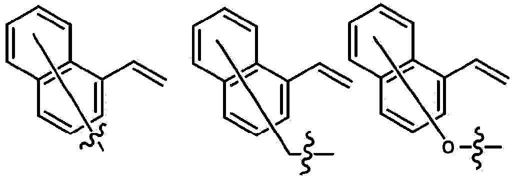 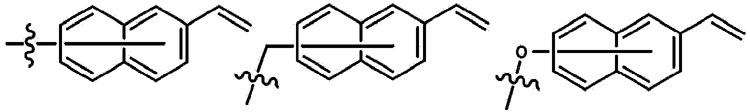 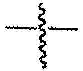 is a moiety to be bonded.

In the present specification, the compound of Chemical Formula 1 is characterized in that one of the four substituents bonded to boron is a boron compound having an end group of -Ar-(X)n1 (X = a curing group) and has an asymmetric structure by the end group. Since the curing group X is located in the outer shell, the compound of Chemical Formula 1 has a low curing temperature, and is easily cured and advantageous for maintaining curing compared to the symmetric compound. In particular, the case where the curing group X is a vinyl group or an aryl group which is substituted with a vinyl group has an advantage in that the compound is relatively easily cured. In particular, the case has an advantage of having a curing temperature lower than that of a vinyl group which is substituted with a methyl group 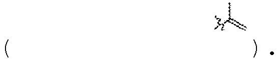 Specifically, a vinyl group, which is substituted with a methyl group, has a space occupied by a methyl group (steric hindrance) rather than a vinyl group substituted with hydrogen alone, and for this reason, the vinyl group is hindered by a methyl group in the curing process in which vinyl and vinyl are bonded, and is not easily cured compared to a vinyl group in which a methyl group is not substituted.

According to an exemplary embodiment of the present specification, n1 is an integer from 1 to 5, and when n1 is 2 or higher, two or more substituents in the parenthesis are the same as or different from each other.

In another exemplary embodiment, n1 is 1 or 2, and when n1 is 2, two X's are the same as or different from each other.

In an exemplary embodiment of the present specification, Chemical Formula 1 is represented by any one of the following compounds.

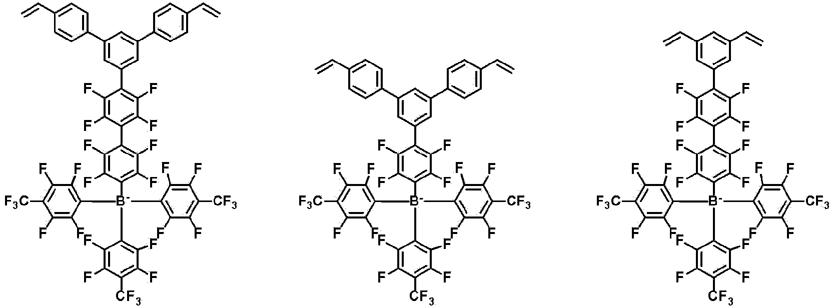

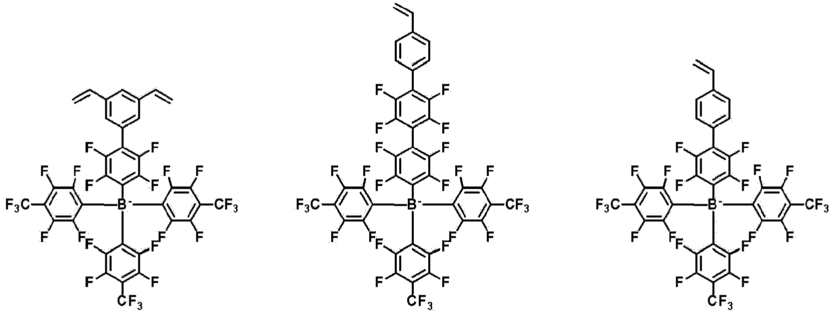

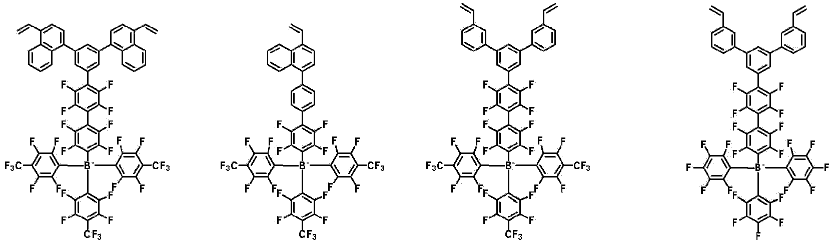

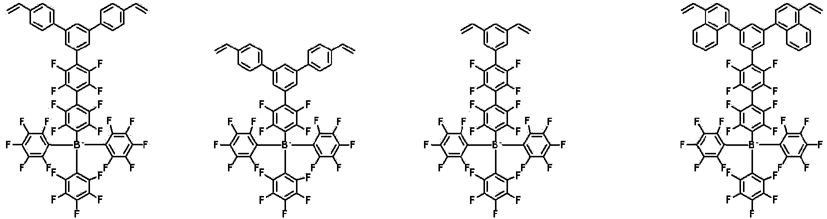

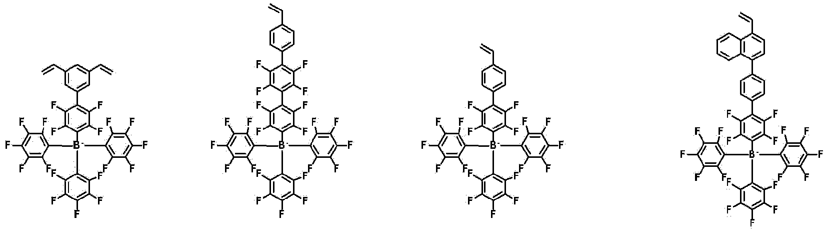

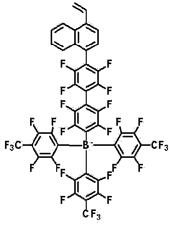

According to an exemplary embodiment of the present specification, the compound further includes a counterion. In this case, the type of counterion is not particularly limited, and may include any one cation from the following structural formulae.

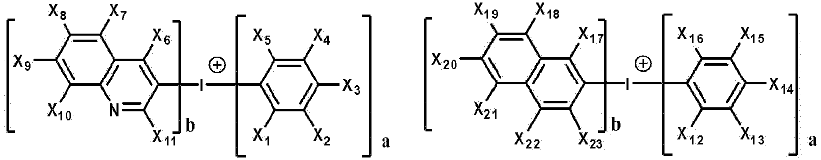

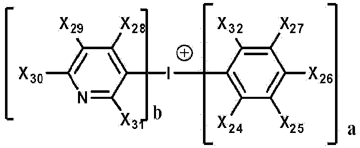

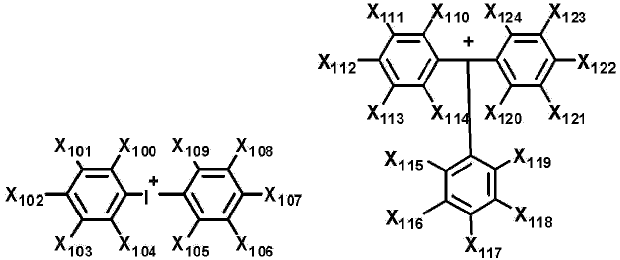

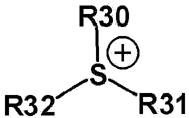

In the structural formulae, X₁ to X₃₂ are the same as or different from each other, and are each independently hydrogen; deuterium; a cyano group; a nitro group; a halogen group; -COOR₁₀₄; a substituted or unsubstituted alkyl group; a substituted or unsubstituted alkoxy group; a substituted or unsubstituted cycloalkyl group; a substituted or unsubstituted fluoroalkyl group; or a substituted or unsubstituted aryl group, or a curing group selected from the group of following curing groups, R₁₀₄ is hydrogen; deuterium; or a substituted or unsubstituted alkyl group,
a is 1 or 2, b is 0 or 1, and a + b =2,
X₁₀₀ to X₁₂₄ are the same as or different from each other, and are each independently hydrogen; deuterium; a cyano group; a nitro group; a halogen group; -COOR₁₀₅; a substituted or unsubstituted alkyl group; a substituted or unsubstituted alkoxy group; a substituted or unsubstituted cycloalkyl group; a substituted or unsubstituted fluoroalkyl group; or a substituted or unsubstituted aryl group, or a curing group selected from the group of the following curing groups,
R₁₀₅ is a substituted or unsubstituted alkyl group,

[Group of curing groups] 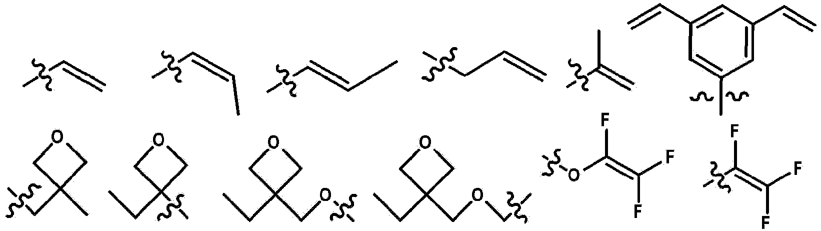 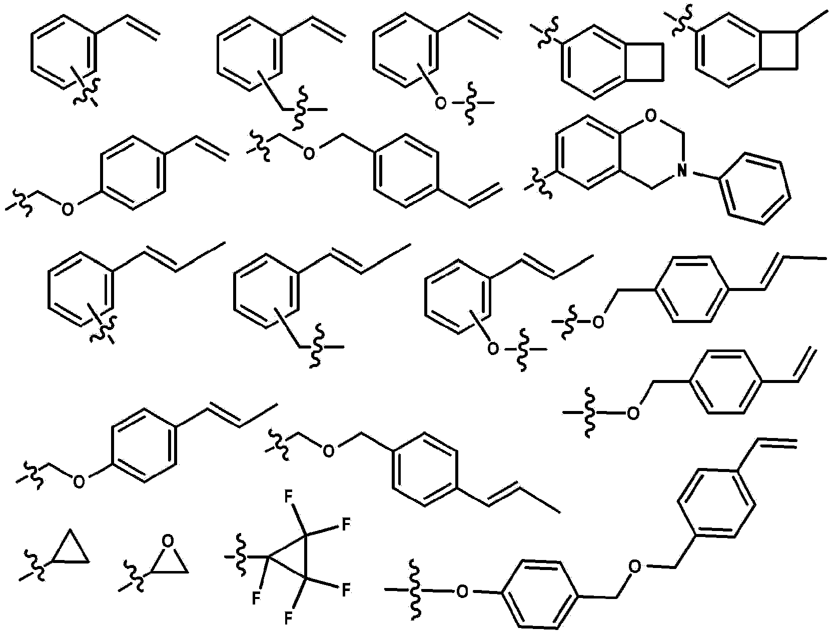 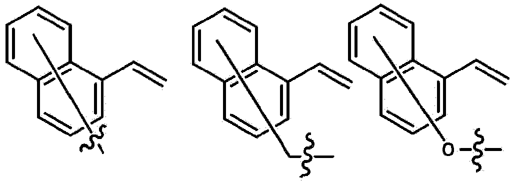 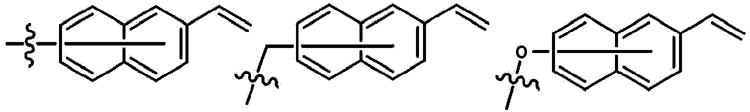
R30 to R32 are the same as or different from each other, and are each independently a substituted or unsubstituted alkyl group; a substituted or unsubstituted alkenyl group; a substituted or unsubstituted alkynyl group; a substituted or unsubstituted cycloalkyl group; a substituted or unsubstituted aryl group; or a substituted or unsubstituted heterocyclic group, or groups adjacent to each other are bonded to each other to form a substituted or unsubstituted ring, and 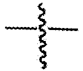
is a moiety to be bonded.

According to an exemplary embodiment of the present specification, R30 to R32 are a substituted or unsubstituted alkyl group having 1 to 10 carbon atoms; a substituted or unsubstituted alkenyl group having 2 to 10 carbon atoms; a substituted or unsubstituted alkynyl group having 2 to 10 carbon atoms; a substituted or unsubstituted cycloalkyl group having 3 to 10 carbon atoms; a substituted or unsubstituted aryl group having 6 to 20 carbon atoms; or a substituted or unsubstituted heterocyclic group having 2 to 20 carbon atoms, or groups adjacent to each other are bonded to each other to form a substituted or unsubstituted hetero ring.

According to an exemplary embodiment of the present specification, when groups adjacent to each other in R30 to R32 are bonded to each other, a hetero ring including a central S is formed by a hetero element, and the hetero ring may be substituted or unsubstituted.

According to an exemplary embodiment of the present specification, when groups adjacent to each other in R30 to R32 are bonded to each other, tetrahydrothiophene, thiophene, benzothiophene or dibenzothiophene may be formed, and the ring may be substituted or unsubstituted.

According to an exemplary embodiment of the present specification, the cation may include any one cation of the following structural formulae.

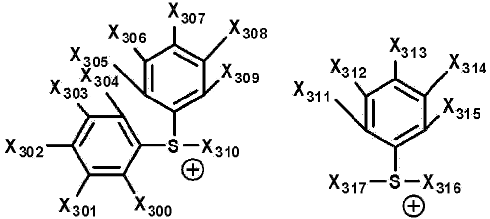

X₃₀₀ to X₃₁₇ are the same as or different from each other, and are each independently a substituted or unsubstituted alkyl group; a substituted or unsubstituted alkenyl group; a substituted or unsubstituted alkynyl group; a substituted or unsubstituted cycloalkyl group; a substituted or unsubstituted aryl group; or a substituted or unsubstituted heterocyclic group, or groups adjacent to each other are bonded to each other to form a substituted or unsubstituted ring.

According to an exemplary embodiment of the present specification, the structural formulae of the cation may be any one of the following cations.

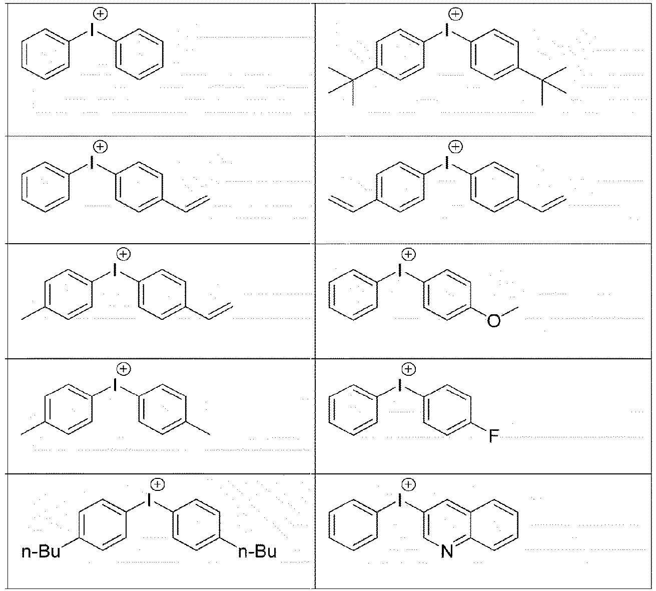

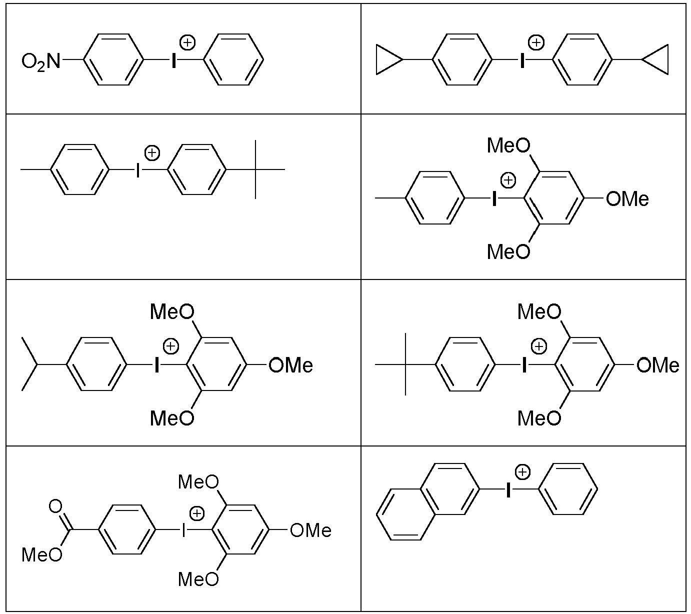

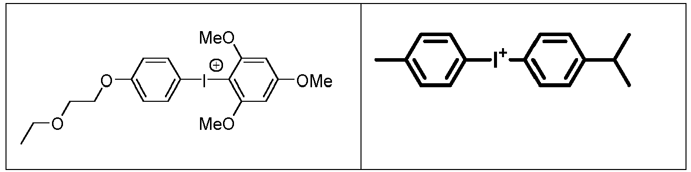

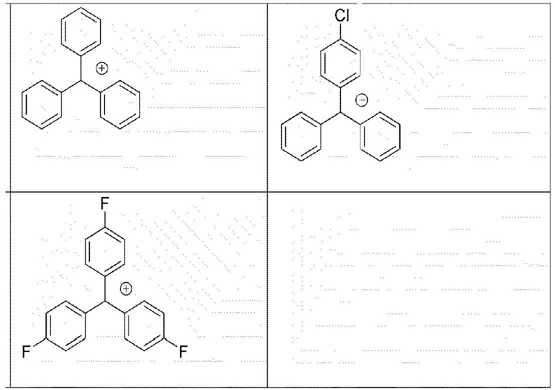

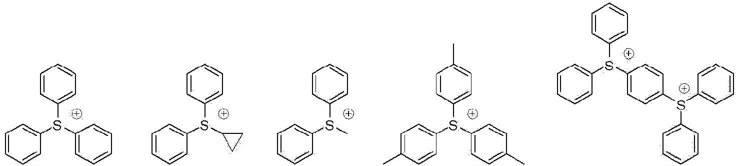

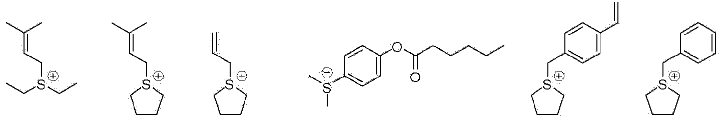

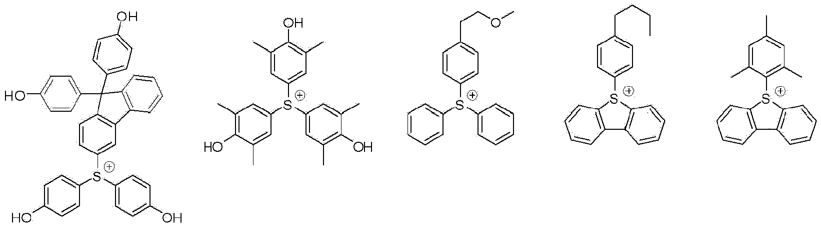

According to an exemplary embodiment of the present specification, the compound is represented by any one of the following structural formulae.

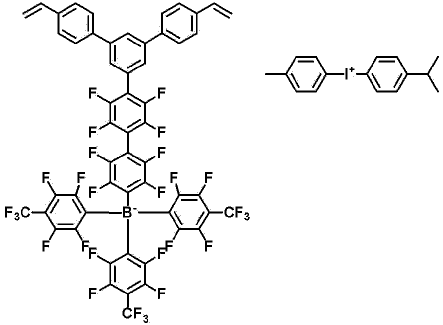

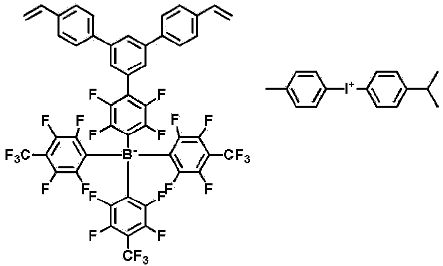

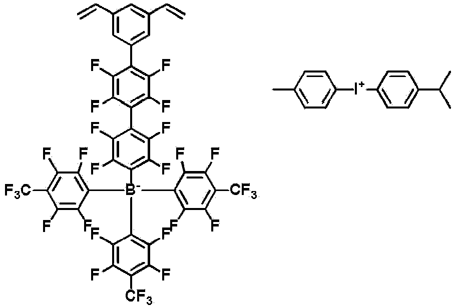

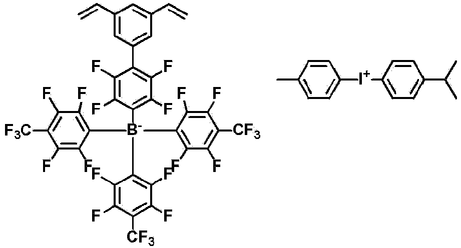

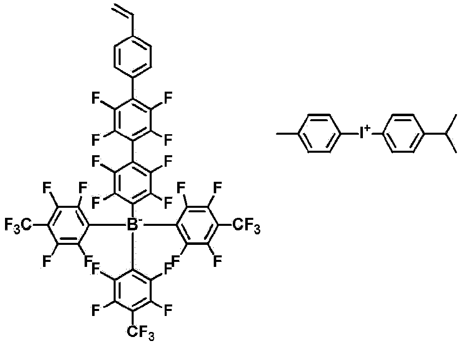

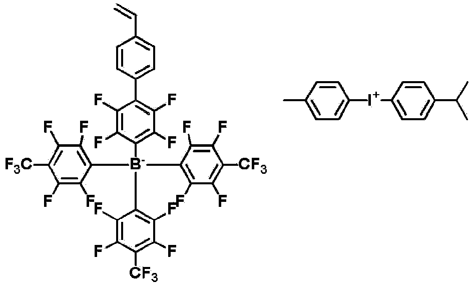

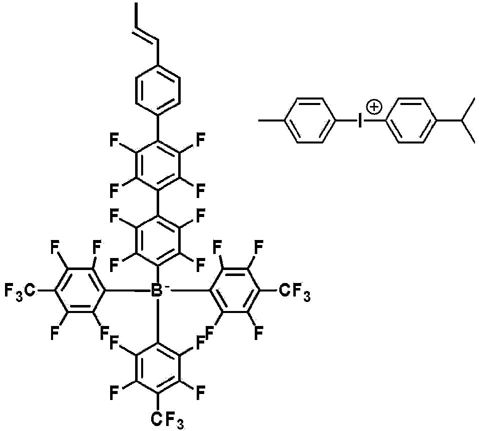

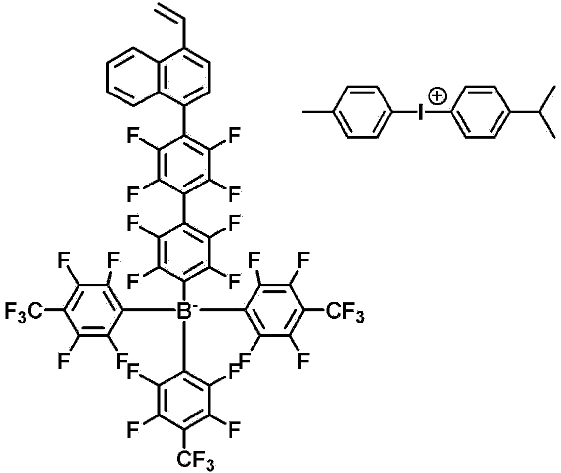

The compound according to an exemplary embodiment of the present specification may be prepared in the same manner as in a preparation method to be described below. In the preparation method to be described below, the substituent may be bonded by a method known in the art, and the type and position of the substituent or the number of substituents may be changed according to the technology known in the art.

In an exemplary embodiment of the present specification, provided is a coating composition including the above-described compound.

In an exemplary embodiment of the present specification, the coating composition includes the compound of Chemical Formula 1 and a solvent.

In an exemplary embodiment of the present specification, the coating composition may be in a liquid phase. The "liquid phase" means that the composition is in a liquid state at room temperature under atmospheric pressure.

In an exemplary embodiment of the present specification, the solvent is exemplified as, for example, a chlorine-based solvent such as chloroform, methylene chloride, 1,2-dichloroethane, 1,1,2-trichloroethane, chlorobenzene, and o-dichlorobenzene; an ether-based solvent such as tetrahydrofuran and dioxane; an aromatic hydrocarbon-based solvent such as toluene, xylene, trimethylbenzene, and mesitylene; an aliphatic hydrocarbon-based solvent such as cyclohexane, methylcyclohexane, n-pentane, n-hexane, n-heptane, n-octane, n-nonane, and n-decane; a ketone-based solvent such as acetone, methyl ethyl ketone, cyclohexanone, isophorone, tetralone, decalone, and acetylacetone; an ester-based solvent such as ethyl acetate, butyl acetate, and ethyl cellosolve acetate; a polyhydric alcohol such as ethylene glycol, ethylene glycol monobutyl ether, ethylene glycol monoethyl ether, ethylene glycol monomethyl ether, dimethoxy ethane, propylene glycol, diethoxymethane, triethylene glycol monoethyl ether, glycerin, and 1,2-hexanediol, and derivatives thereof; an alcohol-based solvent such as methanol, ethanol, propanol, isopropanol, and cyclohexanol; a sulfoxide-based solvent such as dimethyl sulfoxide; an amide-based solvent such as N-methyl-2-pyrrolidone and N,N-dimethylformamide; and tetralin, but the solvent is sufficient as long as the solvent may dissolve or disperse the compound of Chemical Formula 1 according to an exemplary embodiment of the present invention, and is not limited thereto.

In another exemplary embodiment, the solvents may be used either alone or in a mixture of two or more solvents.

In an exemplary embodiment of the present specification, the coating composition may further include an additional compound along with the compound of Chemical Formula 1.

According to another exemplary embodiment, the coating composition includes the compound of Chemical Formula 1 as a dopant, and includes the additional compound as a host. In this case, a mass ratio (compound of Chemical Formula 1 : additional compound) of the compound of Chemical Formula 1 and the additional compound may be 1 : 9 to 5 : 5.

In another exemplary embodiment, the additional compound may be an arylamine-based compound, and may be an arylamine-based compound in which a vinyl group is substituted. When the compound of Chemical Formula 1 and the arylamine-based compound in which a vinyl group is substituted are used together, there is an advantage in that reactivity is good because the curing temperatures are similar to each other.

An example of the additional compound includes the following compounds, but is not limited thereto.

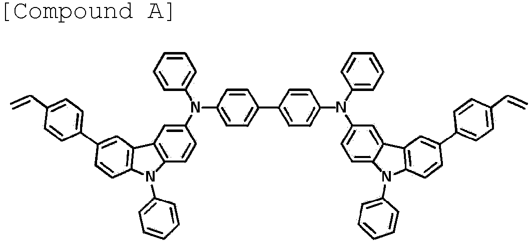

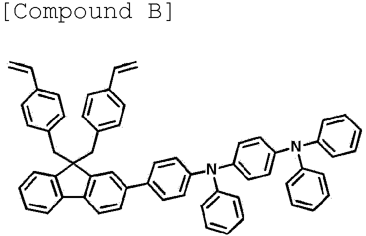

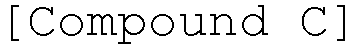

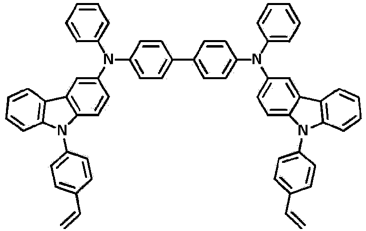

The viscosity of the coating composition is 2 cP to 15 cP at room temperature (about 25°C). When the above viscosity is satisfied, a device is easily manufactured.

The present specification also provides an organic light emitting device formed by using the coating composition.

The organic light emitting device according to the present specification may be included and used in various electronic devices. For example, the electronic device may be a display panel, a touch panel, a solar module, a lighting device, and the like, and is not limited thereto.

In an exemplary embodiment of the present specification, the organic light emitting device includes: a first electrode; a second electrode; and an organic material layer having one or more layers provided between the first electrode and the second electrode, in which one or more layers of the organic material layer include the coating composition or a cured product thereof, and the cured product of the coating composition is in a state where the coating composition is cured by a heat treatment or a light treatment.

In an exemplary embodiment of the present specification, the organic material layer including the coating composition or the cured product thereof is a hole transport layer or a hole injection layer.

In an exemplary embodiment of the present specification, the organic material layer including the coating composition or the cured product thereof is an electron transport layer or an electron injection layer.

In another exemplary embodiment, the organic material layer including the coating composition or the cured product thereof is a light emitting layer.

In still another exemplary embodiment, the organic material layer including the coating composition or the cured product thereof is a light emitting layer, and the light emitting layer includes the compound as a host of the light emitting layer.

In yet another exemplary embodiment, the organic material layer including the coating composition or the cured product thereof is a light emitting layer, and the light emitting layer includes the compound as a dopant of the light emitting layer.

In an exemplary embodiment of the present specification, the organic light emitting device further includes one or two or more layers selected from the group consisting of a hole injection layer, a hole transport layer, an electron transport layer, an electron injection layer, an electron blocking layer, a hole blocking layer, a layer which simultaneously transports and injects holes, and a layer which simultaneously transports and injects electrons.

In an exemplary embodiment of the present specification, the first electrode is an anode, and the second electrode is a cathode.

According to another exemplary embodiment, the first electrode is a cathode, and the second electrode is an anode.

In another exemplary embodiment, the organic light emitting device may be a normal type organic light emitting device in which an anode, an organic material layer having one or more layers, and a cathode are sequentially stacked on a substrate.

In still another exemplary embodiment, the organic light emitting device may be an inverted type organic light emitting device in which a cathode, an organic material layer having one or more layers, and an anode are sequentially stacked on a substrate.

The organic material layer of the organic light emitting device of the present specification may also be composed of a single-layered structure, but may be composed of a multi-layered structure in which two or more organic material layers are stacked. For example, the organic light emitting device of the present disclosure may have a structure including a hole injection layer, a hole transport layer, a light emitting layer, an electron transport layer, an electron injection layer, a hole blocking layer, an electron blocking layer, a layer which simultaneously transports and injects holes, a layer which simultaneously transports and injects electrons, and the like as an organic material layer. However, the structure of the organic light emitting device is not limited thereto, and may include a fewer number of organic layers.

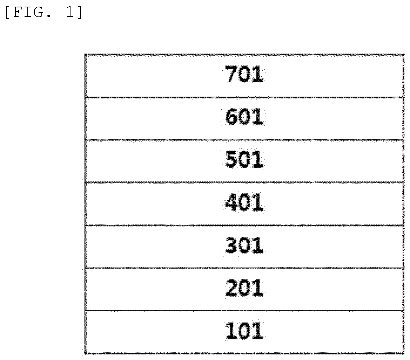

For example, the structure of the organic light emitting device according to an exemplary embodiment of the present specification is exemplified in FIG. 1.

FIG. 1 exemplifies a structure of an organic light emitting device in which an anode 201, a hole injection layer 301, a hole transport layer 401, a light emitting layer 501, a layer 601 which simultaneously transports and injects electrons, and a cathode 701 are sequentially stacked on a substrate 101.

FIG. 1 exemplifies an organic light emitting device, and the organic light emitting device is not limited thereto.

When the organic light emitting device includes a plurality of organic material layers, the organic material layers may be formed of the same material or different materials.

The organic light emitting device of the present specification may be manufactured by the materials and methods known in the art, except that one or more layers of the organic material layer are formed by using the coating composition including the compound of Chemical Formula 1.

For example, the organic light emitting device of the present specification may be manufactured by sequentially stacking an anode, an organic material layer, and a cathode on a substrate. In this case, the organic light emitting device may be manufactured by depositing a metal or a metal oxide having conductivity, or an alloy thereof on a substrate to form an anode, forming an organic material layer including a hole injection layer, a hole transport layer, a light emitting layer, and a layer which simultaneously transports and injects electrons thereon through a solution process, a deposition process, and the like, and then depositing a material, which may be used as a cathode, thereon, by using a physical vapor deposition (PVD) method such as sputtering or e-beam evaporation. In addition to the method described above, an organic light emitting device may be made by sequentially depositing a cathode material, an organic material layer, and an anode material on a substrate.

The present specification also provides a method for manufacturing an organic light emitting device formed by using the coating composition.

Specifically, in an exemplary embodiment of the present specification, the method includes: preparing a substrate; forming a first electrode on the substrate; forming an organic material layer having one or more layers on the first electrode; and forming a second electrode on the organic material layer, in which the forming of the organic material layer includes forming an organic material layer having one or more layers by using the coating composition.

In an exemplary embodiment of the present specification, the forming of the organic material layer having one or more layers by using the coating composition uses a spin coating method.

In another exemplary embodiment, the forming of the organic material layer having one or more layers by using the coating composition uses a printing method.

In an exemplary embodiment state of the present specification, examples of the printing method include inkjet printing, nozzle printing, offset printing, transfer printing or screen printing, and the like, but are not limited thereto.

A solution process is suitable for the coating composition according to an exemplary embodiment of the present specification due to the structural characteristics thereof, so that the organic material layer may be formed by a printing method, and as a result, there is an economic effect in terms of time and costs when a device is manufactured.

In an exemplary embodiment of the present specification, the forming of the organic material layer having one or more layers by using the coating composition includes: coating the coating composition on the first electrode or the organic material layer having one or more layers; and heat-treating or light-treating the coated coating composition.

In an exemplary embodiment of the present specification, the heat-treating of the coated coating composition may be performed through a heat treatment, and the heat treatment temperature in the heat-treating of the coated coating composition may be 85°C to 250°C, may be 100°C to 250°C according to an exemplary embodiment, and may be 150°C to 250°C in another exemplary embodiment.

In another exemplary embodiment, the heat treatment time in the heat-treating of the coated composition may be 1 minute to 2 hours, may be 10 minutes to 2 hours according to an exemplary embodiment, and may be 10 minutes to 90 minutes in another exemplary embodiment.

When the forming of the organic material layer formed by using the coating composition includes the heat-treating or light-treating of the coated coating composition, a plurality of the compounds included in the coating composition may form a cross-linkage, thereby providing an organic material layer including a thin-filmed structure. In this case, it is possible to prevent the organic material layer from being dissolved, morphologically affected or decomposed by a solvent when another layer is stacked on the surface of the organic material layer formed by using the coating composition.

Therefore, when the organic material layer formed by using the coating composition is formed by a method including the heat-treating or light-treating of the coated coating composition, resistance to a solvent is increased, so that a plurality of layers may be formed by repeatedly performing solution deposition and cross-linking methods, and stability is increased, so that the service life characteristic of the device may be increased.

As the anode material, materials having a high work function are usually preferred so as to facilitate the injection of holes into an organic material layer. Specific examples of the anode material which may be used in the present disclosure include: a metal such as vanadium, chromium, copper, zinc, and gold, or an alloy thereof; a metal oxide such as zinc oxide, indium oxide, indium tin oxide (ITO), and indium zinc oxide (IZO); a combination of a metal and an oxide, such as ZnO:Al or SnO₂:Sb; a conductive polymer such as poly(3-methylthiophene), poly[3,4-(ethylene-1,2-dioxy)thiophene] (PEDOT), polypyrrole, and polyaniline; and the like, but are not limited thereto.

As the cathode material, materials having a low work function are usually preferred so as to facilitate the injection of electrons into an organic material layer. Specific examples of the cathode material include: a metal such as barium, magnesium, calcium, sodium, potassium, titanium, indium, yttrium, lithium, gadolinium, aluminum, silver, tin, and lead, or an alloy thereof; a multi-layer structured material, such as LiF/Al or LiO₂/Al; and the like, but are not limited thereto.

The hole injection layer is a layer which injects holes from an electrode, and a hole injection material is preferably a compound which has a capability of transporting holes, and thus has an effect of injecting holes at an anode and an excellent effect of injecting holes into a light emitting layer or a light emitting material, prevents excitons produced from the light emitting layer from moving to an electron injection layer or an electron injection material, and is also excellent in the ability to form a thin film. The highest occupied molecular orbital (HOMO) of the hole injection material is preferably a value between the work function of the anode material and the HOMO of the neighboring organic material layer. Specific examples of the hole injection material include the above-described compound of Chemical Formula 1, metal porphyrin, oligothiophene, arylamine-based organic materials, hexanitrile hexaazatriphenylene-based organic materials, quinacridone-based organic materials, perylene-based organic materials, anthraquinone, polyaniline-based and polythiophene-based electrically conductive polymers, and the like, but are not limited thereto.

The hole transport layer is a layer which accepts holes from a hole injection layer and transports the holes to a light emitting layer, and a hole transport material is suitably a material having high hole mobility which may accept holes from an anode or a hole injection layer and transfer the holes to a light emitting layer. Specific examples thereof include arylamine-based organic materials, conductive polymers, block copolymers having both conjugated portions and non-conjugated portions, and the like, but are not limited thereto.

The layer which simultaneously transports and injects holes may include materials for the hole transport layer and the hole injection layer described above.

The light emitting material is a material which may accept holes and electrons from a hole transport layer and an electron transport layer, respectively, and combine the holes and the electrons to emit light in a visible ray region, and is preferably a material having high quantum efficiency to fluorescence or phosphorescence. Specific examples thereof include: 8-hydroxy-quinoline aluminum complexes (Alq₃); carbazole-based compounds; dimerized styryl compounds; BAlq; 10-hydroxybenzoquinoline-metal compounds; benzoxazole-based, benzothiazole-based and benzimidazole-based compounds; poly(p-phenylenevinylene) (PPV)-based polymers; spiro compounds; polyfluorene, lubrene, and the like, but are not limited thereto.

The light emitting layer may include a host material and a dopant material. Examples of the host material include fused aromatic ring derivatives, or hetero ring-containing compounds, and the like. Specifically, examples of the fused aromatic ring derivatives include anthracene derivatives, pyrene derivatives, naphthalene derivatives, pentacene derivatives, phenanthrene compounds, fluoranthene compounds, and the like, and examples of the hetero ring-containing compounds include carbazole derivatives, dibenzofuran derivatives, ladder-type furan compounds, pyrimidine derivatives, and the like, but the examples thereof are not limited thereto.

Examples of the dopant material include an aromatic amine derivative, a styrylamine compound, a boron complex, a fluoranthene compound, a metal complex, and the like. Specifically, the aromatic amine derivative is a fused aromatic ring derivative having a substituted or unsubstituted arylamino group, and examples thereof include a pyrene, an anthracene, a chrysene, a periflanthene, and the like, which have an arylamino group, and the styrylamine compound is a compound in which a substituted or unsubstituted arylamine is substituted with at least one arylvinyl group, and one or two or more substituents selected from the group consisting of an aryl group, a silyl group, an alkyl group, a cycloalkyl group, and an arylamino group is or are substituted or unsubstituted. Specific examples thereof include styrylamine, styryldiamine, styryltriamine, styryltetramine, and the like, but are not limited thereto. Further, examples of the metal complexes include an iridium complex, a platinum complex, and the like, but are not limited thereto.

The electron transport layer is a layer which accepts electrons from an electron injection layer and transports the electrons to a light emitting layer, and an electron transport material is suitably a material having high electron mobility which may proficiently accept electrons from a cathode and transfer the electrons to a light emitting layer. Specific examples thereof include: Al complexes of 8-hydroxyquinoline; complexes including Alq₃; organic radical compounds; hydroxyflavone-metal complexes, and the like, but are not limited thereto. The electron transport layer may be used with any desired cathode material, as used according to the related art. In particular, appropriate examples of the cathode material are a typical material which has a low work function, followed by an aluminum layer or a silver layer. Specific examples thereof include cesium, barium, calcium, ytterbium, and samarium, in each case followed by an aluminum layer or a silver layer.

The electron injection layer is a layer which injects electrons from an electrode, and an electron injection material is preferably a compound which has a capability of transporting electrons, has an effect of injecting electrons from a cathode and an excellent effect of injecting electrons into a light emitting layer or a light emitting material, prevents excitons produced from the light emitting layer from moving to a hole injection layer, and is also excellent in the ability to form a thin film. Specific examples thereof include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, metal complex compounds, nitrogen-containing 5-membered ring derivatives, and the like, but are not limited thereto.

The layer which simultaneously transports and injects electrons may include materials for the electron transport layer and the electron injection layer described above.

Examples of the metal complex compounds include 8-hydroxyquinolinato lithium, bis(8-hydroxyquinolinato) zinc, bis(8-hydroxyquinolinato) copper, bis(8-hydroxyquinolinato) manganese, tris(8-hydroxyquinolinato) aluminum, tris(2-methyl-8-hydroxyquinolinato) aluminum, tris(8-hydroxyquinolinato) gallium, bis(10-hydroxybenzo[h]quinolinato) beryllium, bis(10-hydroxybenzo[h]quinolinato) zinc, bis(2-methyl-8-quinolinato) chlorogallium, bis(2-methyl-8-quinolinato) (o-cresolato) gallium, bis(2-methyl-8-quinolinato) (1-naphtholato) aluminum, bis(2-methyl-8-quinolinato) (2-naphtholato) gallium, and the like, but are not limited thereto.

The hole blocking layer is a layer which blocks holes from reaching a cathode, and may be generally formed under the same conditions as those of the hole injection layer. Specific examples thereof include oxadiazole derivatives or triazole derivatives, phenanthroline derivatives, BCP, aluminum complexes, and the like, but are not limited thereto.

The electron blocking layer is a layer which blocks electrons from reaching an anode, and materials known in the art may be used.

The organic light emitting device according to the present specification may be a top emission type, a bottom emission type, or a dual emission type according to the materials to be used.

### [Mode for Invention]

Hereinafter, the present specification will be described in detail with reference to Examples for specifically describing the present specification. However, the Examples according to the present specification may be modified in various forms, and it is not interpreted that the scope of the present specification is limited to the Examples described below. The Examples of the present specification are provided to more completely explain the present specification to a person with ordinary skill in the art.

### <Synthesis Examples>

### Synthesis Example 1. Synthesis of Compound 1

### 1) Synthesis Example 1-1

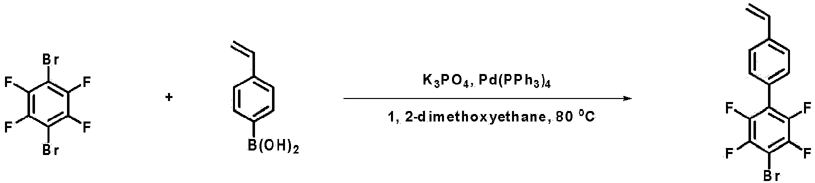

5 g (16.2406 mmol) of 1,4-dibromotetrafluorobenzene, 1,201 mg (8.1203 mmol) of 4-vinylphenylboronic acid, 4,137 mg (19.4487 mmol, 10 mL of distilled water) of potassium phosphate tribasic (K₃PO₄) and 40 mL of 1,2-dimethoxyethane were put into a flask, and the atmosphere of the flask was substituted with nitrogen for 30 minutes. 375 mg (0.3248 mmol) of tetrakis(triphenylphosphine)palladium(0) (Pd(PPh₃)₄) was added to the flask, and the resulting mixture was stirred under a condition of 80°C for 8 hours. The flask was cooled to room temperature, 40 mL of water was added thereto, and the product was extracted three times with 30 mL of ethyl acetate to obtain an organic layer. The resulting organic layer was dried over magnesium sulfate and filtered to obtain a filtrate. An organic solvent was removed and a residue was purified by column with 100% hexane to obtain 1.7 g of a target compound 4-bromo-2,3,5,6-tetrafluoro-4'-vinyl-1,1'-biphenyl.

### 2) Synthesis Example 1-2

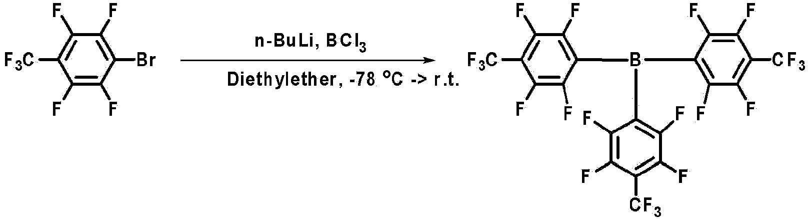

4,574 mg (15.4026 mmol) of 1-bromo-2,3,5,6-tetrafluoro-4-(trifluoromethyl)benzene and 50 mL of diethyl ether were put into a flask, and the resulting mixture was stirred under a condition of -78°C for 1 hour. 6.16 mL (15.4206 mmol, 2.5 M) of n-butyllithium (n-BuLi) was slowly added to the flask, and the resulting mixture was stirred under a condition of -78°C for 1 hour. 5.13 mL (5.1342 mmol, 1 M heptane) of trichloroborane was slowly added thereto at -78°C and the resulting mixture was stirred for 1 hour to obtain a tris(2,3,5,6-tetrafluoro-4-(trifluoromethyl)phenyl)borane solution. This solution was used in the next reaction at -78°C without any purification process.

### 3) Synthesis Example 1-3

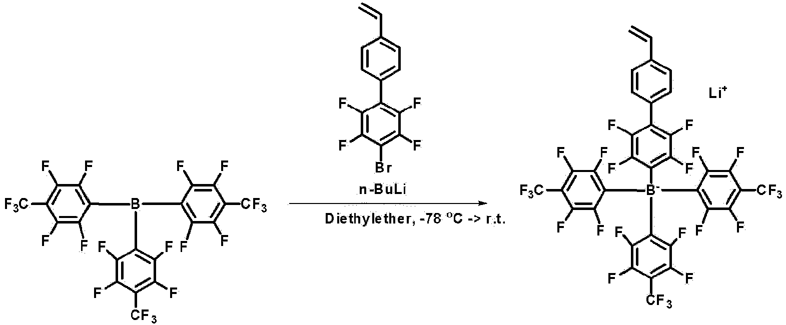

1.7 g (5.1342 mmol) of 4-bromo-2,3,5,6-tetrafluoro-4'-vinyl-1,1'-biphenyl and 17 mL of diethyl ether were put into a flask, and the resulting mixture was stirred under a condition of -78°C for 30 minutes. 2.05 mL (5.1342 mmol, 2.5 M) of n-butyllithium was added thereto at -78°C, and the resulting mixture was stirred under a condition of - 78°C for 1 hour. This solution was added to the previously prepared tris(2,3,5,6-tetrafluoro-4-(trifluoromethyl)phenyl)borane solution under a condition of -78°C. The mixture was stirred overnight while being slowly and naturally warmed to room temperature. The reaction was terminated by adding 50 mL of water thereto, and the resulting product was extracted three times with 50 mL of dichloromethane to obtain an organic layer. The organic layer was dried and a residue was purified by column while changing an eluting solution from 50% and 100% ethyl acetate/hexane to 100% dichloromethane to obtain 2.6 g of a target compound lithium(2,3,5,6-tetrafluoro-4'-vinyl-[1,1'-biphenyl]-4-yl)tris(2,3,5,6-tetrafluoro-4-(trifluoromethyl)phenyl)borate.

### 4) Synthesis Example 1-4

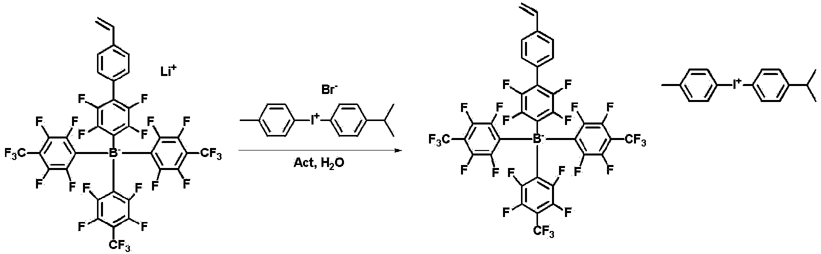

2.6 g (2.8256 mmol) of lithium(2,3,5,6-tetrafluoro-4'-vinyl-[1,1'-biphenyl]-4-yl)tris(2,3,5,6-tetrafluoro-4-(trifluoromethyl)phenyl)borate, 15 mL of acetone (Act) and 15 mL of water were put into a flask, and the resulting mixture was stirred for 30 minutes. 1,180 mg (2.8256 mmol) of (4-isopropylphenyl)(p-tolyl)iodonium bromide was added to the flask, and the resulting mixture was vigorously stirred for 2 hours. The resulting product was extracted three times with 15 mL of dichloromethane to obtain an organic layer, and an organic solvent was removed. A residue could be purified by column sequentially with 50% and 100% ethyl acetate/hexane and 100% dichloromethane to obtain 2.5 g of Compound 1 (4-isopropylphenyl)(p-tolyl)iodonium (2,3,5,6-tetrafluoro-4'-vinyl-[1,1'-biphenyl]-4-yl)tris(2,3,5,6-tetrafluoro-4-(trifluoromethyl)phenyl)borate.

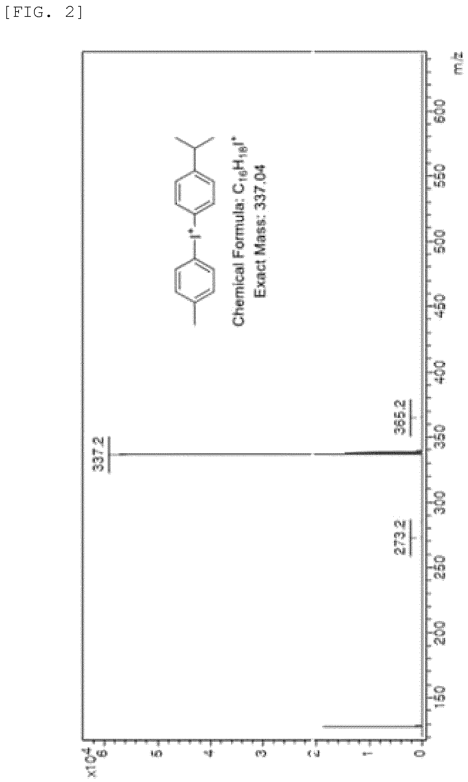

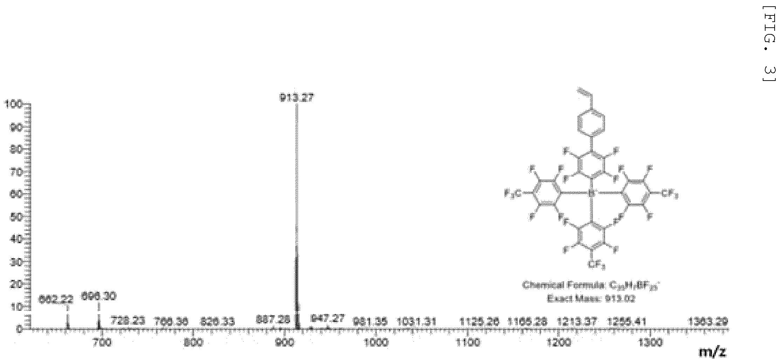

In Compound 1, a view of measuring the mass of a cation is illustrated in the following FIG. 2, and a view of measuring the mass of an anion is illustrated in the following FIG. 3.

### Synthesis Example 2. Synthesis of Compound 2

### 1) Synthesis Example 2-1

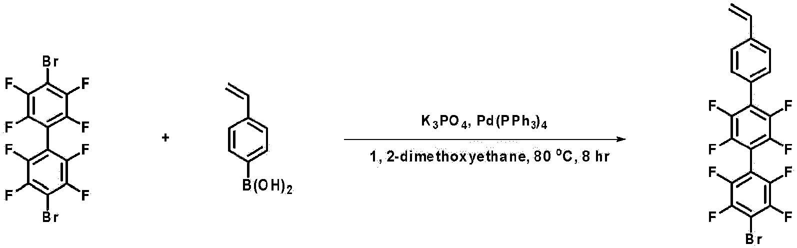

5 g (10.9666 mmol) of 4,4'-dibromooctafluorobiphenyl, 1,623 mg (10.9666 mmol) of 4-vinylphenylboronic acid, 2,793 mg (13.1599 mmol, 7 mL of distilled water) of potassium phosphate tribasic and 30 mL of 1,2-dimethoxyethane were put into a flask, and the atmosphere of the flask was substituted with nitrogen for 30 minutes. 253 mg (0.2193 mmol) of tetrakis(triphenylphosphine)palladium(0) was added to the flask, and the resulting mixture was stirred under a condition of 80°C for 8 hours. The flask was cooled to room temperature, 30 mL of water was added thereto, and the product was extracted three times with 30 mL of ethyl acetate to obtain an organic layer. The resulting organic layer was dried over magnesium sulfate and filtered to obtain a filtrate. An organic solvent was removed and a residue was purified by column with 100% hexane to obtain 3 g of a target compound 4-bromo-2,2',3,3',5,5',6,6'-octafluoro-4"-vinyl-1,1':4',1"-terphenyl).

### 2) Synthesis Example 2-2

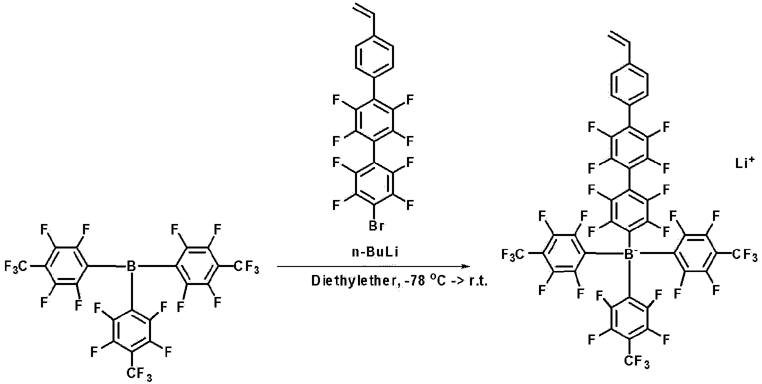

A tris(2,3,5,6-tetrafluoro-4-(trifluoromethyl)phenyl)borane solution was prepared as in the above-described Synthesis Example 1-2.

3 g (6.2608 mmol) of 4-bromo-2,2',3,3',5,5',6,6'-octafluoro-4"-vinyl-1,1":4",1"-terphenyl and 20 mL of diethyl ether were put into a flask, and the resulting mixture was stirred under a condition of -78°C for 30 minutes. 2.50 mL (6.2608 mmol, 2.5 M) of n-butyllithium was added to the flask at -78°C, and the resulting mixture was stirred for 1 hour. The solution of the flask was slowly added to the tris(2,3,5,6-tetrafluoro-4-(trifluoromethyl)phenyl)borane solution at -78°C prepared in another flask. The mixture was stirred overnight while being slowly and naturally warmed to room temperature. The reaction was terminated by adding 20 mL of water thereto, and the resulting product was extracted three times with 20 mL of dichloromethane to obtain an organic layer. The organic layer was dried and a residue was purified by column while changing an eluting solution from 50% and 100% ethyl acetate/hexane to 100% dichloromethane to obtain 4.1 g of a target compound lithium(2,2',3,3',5,5',6,6'-octafluoro-4"-vinyl-[1,1':4',1"-terphenyl]-4-yl)tris(2,3,5,6-tetrafluoro-4-(trifluoromethyl)phenyl)borate.

### 3) Synthesis Example 2-3

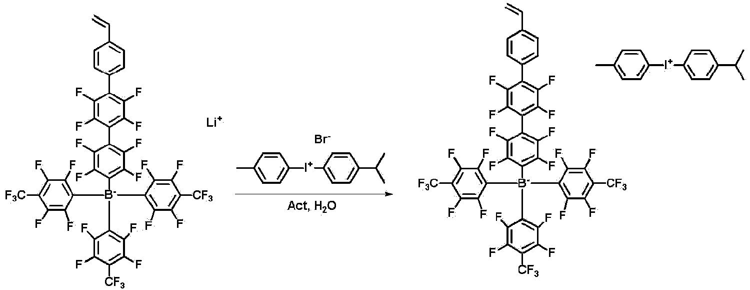

4.1 g (3.8382 mmol) of lithium(2,2',3,3',5,5',6,6'-octafluoro-4"-vinyl-[1,1':4',1"-terphenyl]-4-yl)tris(2,3,5,6-tetrafluoro-4-(trifluoromethyl)phenyl)borate, 30 mL of acetone and 30 mL of water were put into a flask, and the resulting mixture was stirred for 30 minutes. 1,430 mg (3.8382 mmol) of (4-isopropylphenyl) (p-tolyl)iodonium bromide was added to the flask, and the resulting mixture was vigorously stirred for 2 hours. The resulting product was extracted three times with 30 mL of dichloromethane to obtain an organic layer, and an organic solvent was removed. A residue could be purified by column sequentially with 50% and 100% ethyl acetate/hexane and 100% dichloromethane to obtain 4.2 g of Compound 2 (4-isopropylphenyl) (p-tolyl)iodonium (2,2',3,3',5,5',6,6'-octafluoro-4',-vinyl-[1,1':4',1',-terphenyl]-4-yl)tris(2,3,5,6-tetrafluoro-4-(trifluoromethyl)phenyl)borate.

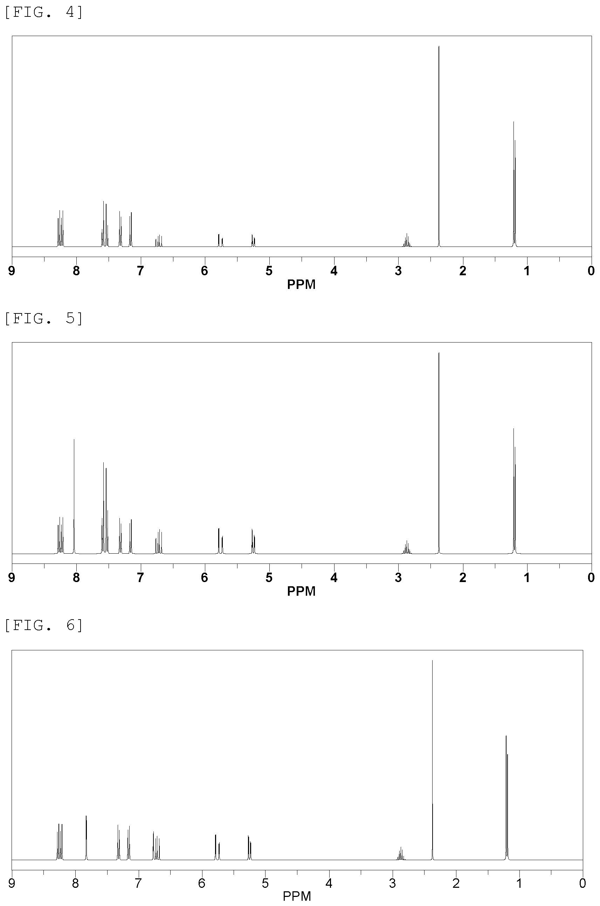

A view of measuring the NMR of Compound 2 is illustrated in FIG. 4.

m/z: 1061.02 (100.0%), 1062.02 (44.3%), 1060.02 (24.8%), 1061.03 (11.0%), 1063.03 (5.0%), 1063.03 (4.6%), 1062.03 (1.8%), 1064.03 (1.3%)

### Synthesis Example 3. Synthesis of Compound 3

### 1) Synthesis Example 3-1

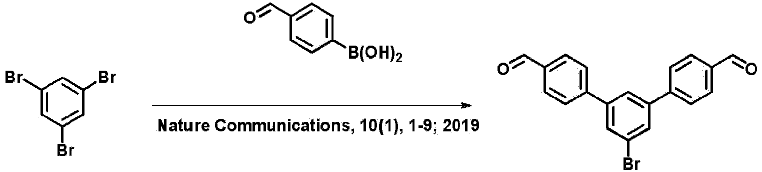

The 5'-bromo-[1,1':3',1"-terphenyl]-4,4"-dicarbaldehyde compound was synthesized with reference to the literature "Nature Communications, 10(1), 1-9, 2019".

### 2) Synthesis Example 3-2

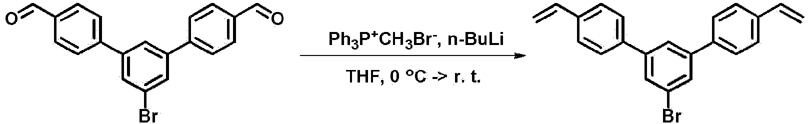

11,248 mg (31.4870mmol) of methyltriphenylphosphonium bromide (CH₃PPh₃Br) and 80 mL of tetrahydrofuran (THF) were put into a flask, and the resulting mixture was stirred under a condition of 0°C for 30 minutes. 12.05 mL (30.118 mmol, 2.5 M) of n-butyllithium was slowly added to the flask, and the resulting mixture was stirred at 0°C for 1 hour. 5 g (13.6900 mmol) of the prepared 5'-bromo-[1,1':3',1"-terphenyl]-4,4"-dicarbaldehyde and 50 mL of an aqueous solution of tetrahydrofuran were slowly added to the flask, and the resulting mixture was stirred at 0°C for 30 minutes. The mixture was stirred for 2 hours while slowly warming the flask to room temperature. The reaction was terminated by adding 100 mL of water thereto, and the resulting product was extracted three times with 100 mL of ethyl acetate. The product was dried over sodium sulfate and filtered. An organic solvent was removed and a residue was purified by silica column with 10% ethyl acetate/hexane to obtain 4,580 mg of a target compound 5'-bromo-4,4"-divinyl-1,1':3',1"-terphenyl.

### 3) Synthesis Example 3-3

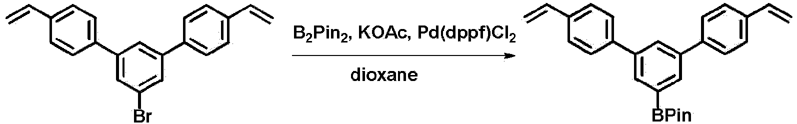

4,580 mg (12.6771 mmol) of 5'-bromo-4,4"-divinyl-1,1':3',1''-terphenyl, 4,185 mg (16.4803 mmol) of bis(pinacolato)diboron (B₂Pin₂), 3,732 mg (38.0138 mmol) of potassium acetate (KOAc) and 42 mL of dioxane were put into a flask, and the flask was filled with nitrogen. 311 mg (0.3803 mmol) of [1,1'-bis(diphenylphosphino)ferrocene]dichloropalladium(II) (Pd(dppf)Cl₂) was added to the flask, and the resulting mixture was stirred under a condition of 80°C for 16 hours. The flask was cooled to room temperature, and 40 mL of water was added thereto. The resulting product was extracted three times with 40 mL of ethyl acetate. An organic layer was dried over sodium sulfate and filtered. An organic solvent was removed and a residue was purified by silica column with 20% ethyl acetate/hexane to obtain 4,600 mg of a target compound 2-(4,4"-divinyl-[1,1':3',1"-terphenyl]-5'-yl)-4,4,5,5-tetramethyl-1,3,2-dioxaborolane.

### 4) Synthesis Example 3-4

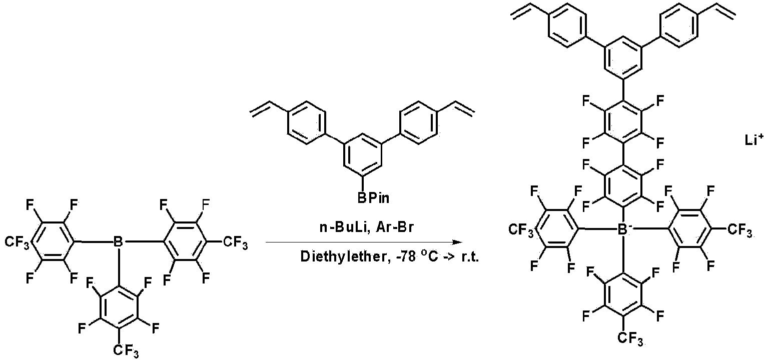

A tris(2,3,5,6-tetrafluoro-4-(trifluoromethyl)phenyl)borane solution was prepared as in the above-described Synthesis Example 1-2.

4,600 mg (11.2648 mmol) of 2-(4,4''-divinyl-[1,1':3',1"-terphenyl]-5'-yl)-4,4,5,5-tetramethyl-1,3,2-dioxaborolane and 38 mL of diethyl ether were put into a flask, and the resulting mixture was stirred at -78°C for 30 minutes. 4.51 mL (11.2648 mmol, 2.5 M) of n-butyllithium was added to the flask at -78°C, and the resulting mixture was stirred for 1 hour. The solution of the flask was slowly added to the tris(2,3,5,6-tetrafluoro-4-(trifluoromethyl)phenyl)borane solution at -78°C prepared in another flask. The mixture was stirred overnight while being slowly and naturally warmed to room temperature. The reaction was terminated by adding 38 mL of water thereto, and the resulting product was extracted three times with 30 mL of dichloromethane to obtain an organic layer. The organic layer was dried and a residue was purified by column while changing an eluting solution from 50% and 100% ethyl acetate/hexane to 100% dichloromethane to obtain 8.2 g of a target compound lithium(2",2‴,3",3‴,5",5‴,6",6‴-octafluoro-4-vinyl-5'-(4-vinylphenyl)-[1,1':3',1":4",1‴-quaterphenyl]-4‴-yl)tris(2,3,5,6-tetrafluoro-4-(trifluoromethyl)phenyl)borate.

### 5) Synthesis Example 3-5

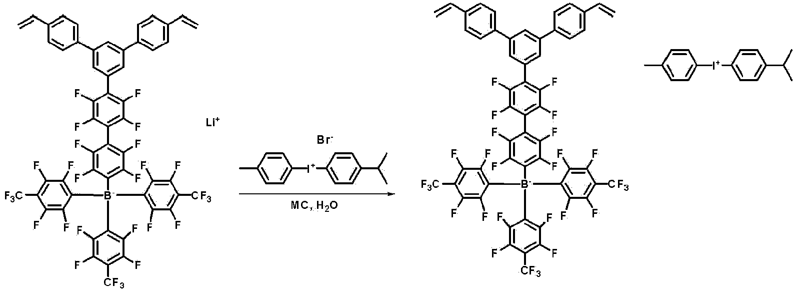

8.2 g (6.5787 mmol) of lithium(2",2‴,3",3‴,5",5‴,6",6‴-octafluoro-4-vinyl-5'-(4-vinylphenyl)-[1,1':3',1":4",1‴-quarterphenyl]-4‴-yl)tris(2,3,5,6-tetrafluoro-4-(trifluoromethyl)phenyl)borate, 33 mL of dichloromethane (MC) and 33 mL of water were put into a flask, and the resulting mixture was stirred for 30 minutes. 2,748 mg (6.5787 mmol) of (4-isopropylphenyl)(p-tolyl)iodonium bromide was added to the flask, and the resulting mixture was vigorously stirred for 2 hours. The resulting product was extracted three times with 30 mL of dichloromethane to obtain an organic layer, and an organic solvent was removed. A residue was purified by column sequentially with 50% and 100% ethyl acetate/hexane and 100% dichloromethane to obtain 6.7 g of Compound 3 (4-isopropylphenyl) (p-tolyl)iodonium (2",2‴,3",3‴,5",5‴,6",6‴-octafluoro-4-vinyl-5'-(4-vinylphenyl)-[1,1':3',1":4",1‴-quarterphenyl]-4‴-yl)tris(2,3,5,6-tetrafluoro-4-(trifluoromethyl)phenyl)borate.

A view of measuring the NMR of Compound 3 is illustrated in FIG. 5.

m/z: 1239.10 (100.0%), 1240.10 (59.5%), 1238.10 (24.8%), 1241.10 (17.4%), 1239.10 (14.8%), 1242.11 (3.3%), 1240.11 (2.9%), 1240.11 (1.4%)

### Synthesis Example 4. Synthesis of Compound 4

### 1) Synthesis Example 4-1

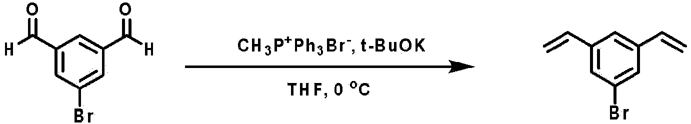

5-Bromoisophthaldehyde (5 g, 23.4709 mmol) and CH₃BrPPh₃(30.75 g, 70.4126 mmol) were put into tetrahydrofuran [THF], subsequently, potassium tert-butoxide [t-BuOK] (8.0 g, 70.4126 mmol) was added thereto at 0°C, and the resulting mixture was stirred at 0°C for 1 hour. The reaction was stopped with water, and the product was extracted with ethyl acetate (EA). After magnesium sulfate (MgSO₄) was added to the collected organic solution and the resulting mixture was dried and filtered, the organic solvent was removed by a vacuum rotary evaporator. A residue was purified by column to obtain 4.1 g of a target compound.

### 2) Synthesis Example 4-2

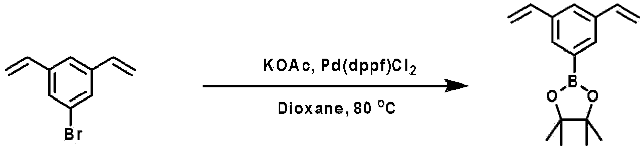

1-Bromo-3,5-divinylbenzene (4.1 g, 19.6088 mmol) was put into dioxane, potassium acetate (KOAc) (5.8 g, 58.8264 mmol) and bis(pinacolato)diboron (6.5 g, 25.4914 mmol) were additionally added thereto, and then the resulting mixture was bubbled with nitrogen at room temperature for 30 minutes. [1,1'-Bis(diphenylphosphino)ferrocene]dichloropalladium(II) (717 mg, 0.9804 mmol) was added thereto, and the resulting mixture was stirred under a condition of 80°C for 16 hours. The reaction was stopped with water, and the product was extracted with ethyl acetate. After the collected organic solution was dried by adding magnesium sulfate thereto and filtered, the organic solvent was removed by a vacuum rotary evaporator. A residue was purified by column to obtain 3.9 g of a target compound.

### 3) Synthesis Example 4-3

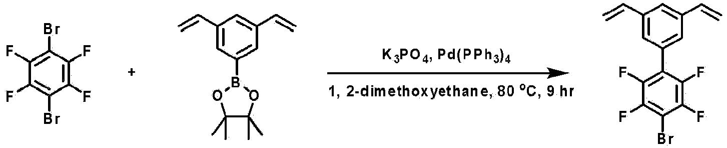

2-(3,5-Divinylphenyl)-4,4,5,5-tetramethyl-1,3,2-dioxaborolane (3.9 g, 15.2255 mmol) was put into 1,2-dimethoxyethane, potassium phosphate tribasic (K₃PO₄, 8.2 g, 38.6727 mmol) and 1,4-dibromo-2,3,5,6-tetrafluorobenzene (9.4 g, 30.4509 mmol) were additionally added thereto, and the resulting mixture was bubbled with nitrogen for 30 minutes. Tetrakis(triphenylphosphine)palladium(0) (Pd(PPh₃)₄, 704 mg, 0.6090 mmol) was added thereto, and the resulting mixture was stirred under a condition of 80°C for 9 hours. The reaction was stopped with water, and the product was extracted with ethyl acetate. After the collected organic solution was dried by adding magnesium sulfate thereto and filtered, the organic solvent was removed by a vacuum rotary evaporator. A residue was purified by column to obtain 3.4 g of a target compound.

### 4) Synthesis Example 4-4

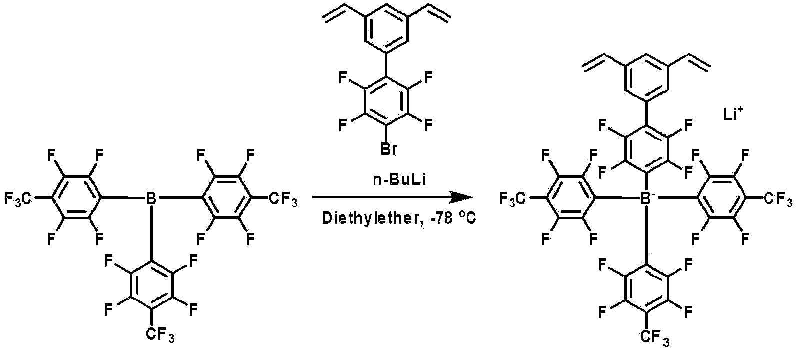

A tris(2,3,5,6-tetrafluoro-4-(trifluoromethyl)phenyl)borane solution was prepared as in the above-described Synthesis Example 1-2.

4-Bromo-2,3,5,6-tetrafluoro-3',5'-divinyl-1,1'-biphenyl (2 g, 5.5999 mmol) was put into diethyl ether, and the resulting mixture was stirred under a condition of - 78°C for 1 hour. n-Butyllithium (2.35 mL, 5.8799 mmol, 2.5 M) was slowly added thereto, and the resulting mixture was stirred under a condition of -78°C for 1 hour. The produced solution was slowly added to the prepared tris(2,3,5,6-tetrafluoro-4-(trifluoromethyl)phenyl)borane solution, and the resulting mixture was stirred overnight while being slowly warmed from -78°C to room temperature. The reaction was stopped with water, and the product was extracted with ethyl acetate. The solvent of the collected organic solution was removed by a vacuum rotary evaporator. A residue was purified by column sequentially with 50% ethyl acetate, 100% ethyl acetate, and 100% dichloromethane to obtain 3.2 g of a target compound.

### 5) Synthesis Example 4-5

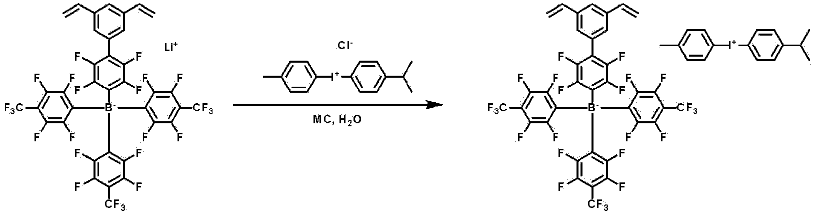

Lithium(2,3,5,6-tetrafluoro-3 ' ,5 ' -divinyl-[1,1'-biphenyl]-4-yl)tris(2,3,5,6-tetrafluoro-4-(trifluoromethyl)phenyl)borate (3.2 g, 3.3820 mmol) was put into 36 ml of a mixed solvent of dichloromethane and water (volume ratio = 1 : 1), and the resulting mixture was stirred for 30 minutes. (4-Isopropylphenyl)(p-tolyl)iodonium chloride (1260 mg, 3.3820 mmol) was added thereto, and the resulting mixture was vigorously stirred for 1 hour. The reaction was stopped with water, and the product was extracted with dichloromethane. The solvent of the collected organic solution was removed by a vacuum rotary evaporator. A residue was purified by column sequentially with 50% ethyl acetate, 100% ethyl acetate, and 100% dichloromethane to obtain 3 g of a final compound.

A view of measuring the NMR of Compound 4 is illustrated in FIG. 6.

m/z: 939.04 (100.0%), 940.04 (30.3%), 938.04 (24.8%), 940.04 (9.7%), 939.05 (5.6%), 939.05 (4.3%), 941.05 (4.1%), 941.05 (3.6%), 940.05 (1.6%)

### Synthesis Example 5. Synthesis of Comparative Compound 1

### 1) Synthesis Example 5-1

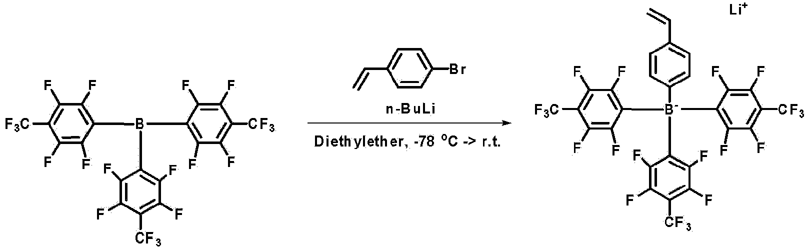

A tris(2,3,5,6-tetrafluoro-4-(trifluoromethyl)phenyl)borane solution was prepared as in the above-described Synthesis Example 1-2. 5 g (27.3149 mmol) of 4-bromostyrene and 90 mL of diethyl ether were put into a flask, and the resulting mixture was stirred at - 78°C for 30 minutes. 10.9 mL (27.3149 mmol, 2.5 M) of n-butyllithium was added to the flask at -78°C, and the resulting mixture was stirred for 1 hour. The solution of the flask was slowly added to the tris(2,3,5,6-tetrafluoro-4-(trifluoromethyl)phenyl)borane solution at -78°C prepared in another flask. The mixture was stirred overnight while being slowly and naturally warmed to room temperature. The reaction was terminated by adding 90 mL of water thereto, and the resulting product was extracted three times with 90 mL of dichloromethane to obtain an organic layer. The organic layer was dried and a residue was purified by column while changing an eluting solution from 50% and 100% ethyl acetate/hexane to 100% dichloromethane to obtain 7.5 g of a target compound lithium tris(2,3,5,6-tetrafluoro-4-(trifluoromethyl) phenyl) (4-vinylphenyl)borate.

### 2) Synthesis Example 5-2

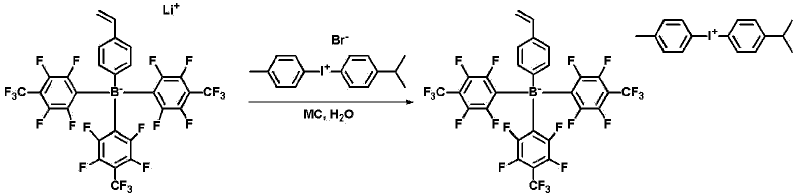

7.5 g (9.7139 mmol) of lithium tris(2,3,5,6-tetrafluoro-4-(trifluoromethyl)phenyl) (4-vinylphenyl)borate, 50 mL of dichloromethane, and 50 mL of water were put into a flask, and the resulting mixture was stirred for 30 minutes. 4,508 mg (9.7139 mmol) of (4-isopropylphenyl) (p-tolyl)iodonium bromide was added to the flask, and the resulting mixture was vigorously stirred for 2 hours. The resulting product was extracted three times with 50 mL of dichloromethane to obtain an organic layer, and an organic solvent was removed. A residue was purified by column sequentially with 50% and 100% ethyl acetate/hexane and 100% dichloromethane to obtain 7.3 g of Comparative Compound 1 ((4-isopropylphenyl) (p-tolyl)iodonium tris(2,3,5,6-tetrafluoro-4-(trifluoromethyl)phenyl) (4-vinylphenyl)borate.

### Synthesis Example 6. Synthesis of Comparative Compound 2

### 1) Synthesis Example 6-1

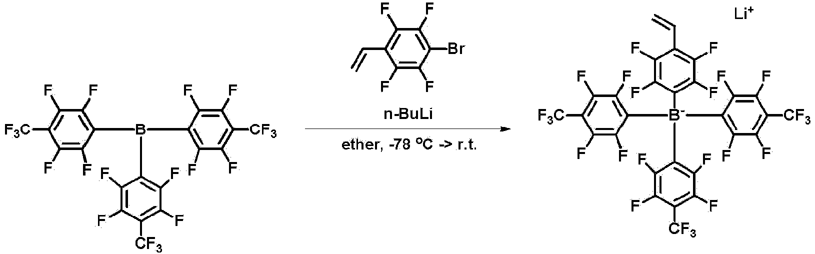

A tris(2,3,5,6-tetrafluoro-4-(trifluoromethyl)phenyl)borane solution was prepared as in the above-described Synthesis Example 1-2. 5 g (19.6071 mmol) of 1-bromo-2,3,5,6-tetrafluoro-4-vinylbenzene and 65 mL of diethyl ether were put into a flask, and the resulting mixture was stirred under a condition of -78°C for 30 minutes. 7.84 mL (19.6071 mmol, 2.5 M) of n-butyllithium was added to the flask at -78°C, and the resulting mixture was stirred for 1 hour. The solution of the flask was slowly added to the tris(2,3,5,6-tetrafluoro-4-(trifluoromethyl)phenyl)borane solution at -78°C prepared in another flask. The mixture was stirred overnight while being slowly and naturally warmed to room temperature. The reaction was terminated by adding 60 mL of water thereto, and the resulting product was extracted three times with 60 mL of dichloromethane to obtain an organic layer. The organic layer was dried and a residue was purified by column while changing an eluting solution from 50% and 100% ethyl acetate/hexane to 100% dichloromethane to obtain 10 g of a target compound lithium tris(2,3,5,6-tetrafluoro-4-(trifluoromethyl)phenyl)(2,3,5,6-tetrafluoro-4-vinylphenyl) borate).

### 2) Synthesis Example 6-2

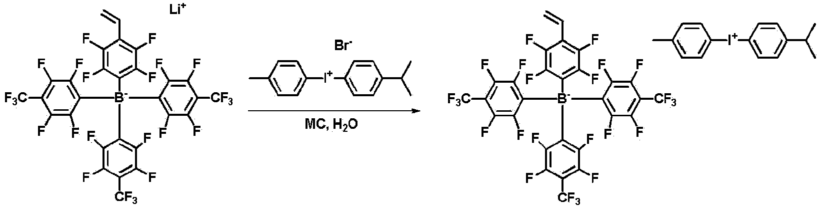

10 g (8.6488 mmol) of lithium tris(2,3,5,6-tetrafluoro-4-(trifluoromethyl)phenyl) (2,3,5,6-tetrafluoro-4-vinylphenyl)borate, 43 mL of dichloromethane, and 43 mL of water were put into a flask, and the resulting mixture was stirred for 30 minutes. 3,613 mg (8.6488 mmol) of (4-isopropylphenyl) (p-tolyl)iodonium bromide was added to the flask, and the resulting mixture was vigorously stirred for 2 hours. The resulting product was extracted three times with 40 mL of dichloromethane to obtain an organic layer, and an organic solvent was removed. A residue was purified by column sequentially with 50% and 100% ethyl acetate/hexane and 100% dichloromethane to obtain 6.5 g of Comparative Compound 2 (4-isopropylphenyl) (p-tolyl)iodonium tris(2,3,5,6-tetrafluoro-4-(trifluoromethyl)phenyl)(2,3,5,6-tetrafluoro-4-vinylphenyl)borate.

### Synthesis Example 7. Synthesis of Comparative Compound 3

### 1) Synthesis Example 7-1

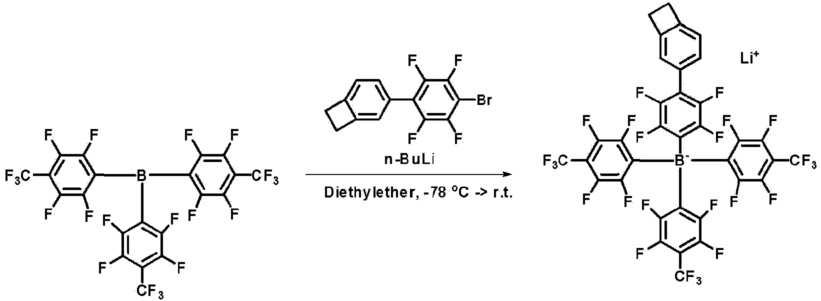

A tris(2,3,5,6-tetrafluoro-4-(trifluoromethyl)phenyl)borane solution was prepared as in the above-described Synthesis Example 1-2. 5 g (15.1007 mmol) of 3-(4-bromo-2,3,5,6-tetrafluorophenyl)bicyclo[4.2.0]octa-1,3,5-triene and 50 mL of diethyl ether were put into a flask, and the resulting mixture was stirred at -78°C for 30 minutes. 6.04 mL (15.1007 mmol, 2.5 M) of n-butyllithium was added to the flask at -78°C, and the resulting mixture was stirred for 1 hour. The solution of the flask was slowly added to the tris(2,3,5,6-tetrafluoro-4-(trifluoromethyl)phenyl)borane solution at -78°C prepared in another flask. The mixture was stirred overnight while being slowly and naturally warmed to room temperature. The reaction was terminated by adding 50 mL of water thereto, and the resulting product was extracted three times with 50 mL of dichloromethane to obtain an organic layer. The organic layer was dried and a residue was purified by column while changing an eluting solution from 50% and 100% ethyl acetate/hexane to 100% dichloromethane to obtain 9.8 g of a target compound lithium (4-(bicyclo[4.2.0]octa-1,3,5-trien-3-yl)-2,3,5,6-tetrafluorophenyl)tris(2,3,5,6-tetrafluoro-4-(trifluoromethyl)phenyl)borate.

### 2) Synthesis Example 7-2

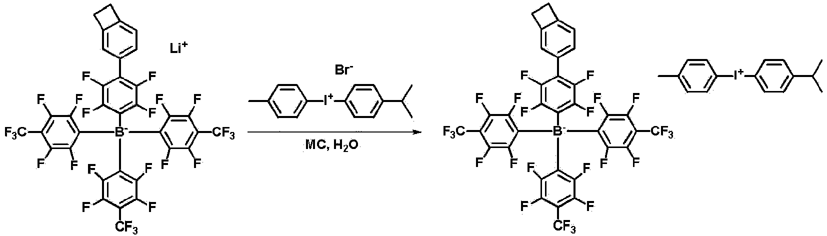

9.8 g (10.6504 mmol) of lithium (4-(bicyclo[4.2.0]octa-1,3,5-trien-3-yl)-2,3,5,6-tetrafluorophenyl)tris(2,3,5,6-tetrafluoro-4-(trifluoromethyl)phenyl)borate, 50 mL of dichloromethane and 50 mL of water were put into a flask, and the resulting mixture was stirred for 30 minutes. 4,449 mg (10.6504 mmol) of (4-isopropylphenyl) (p-tolyl)iodonium bromide was added to the flask, and the resulting mixture was vigorously stirred for 2 hours. The resulting product was extracted three times with 50 mL of dichloromethane to obtain an organic layer, and an organic solvent was removed. A residue was purified by column sequentially with 50% and 100% ethyl acetate/hexane and 100% dichloromethane to obtain 7.2 g of Comparative Compound 3 (4-isopropylphenyl) (p-tolyl)iodonium(4-(bicyclo[4.2.0]octa-1,3,5-trien-3-yl)-2,3,5,6-tetrfluorophenyl)tris(2,3,5,6-tetrafluoro-4-(trifluoromethyl)phenyl)borate.

### Synthesis Example 8. Synthesis of Comparative Compound 4

### 1) Synthesis Example 8-1

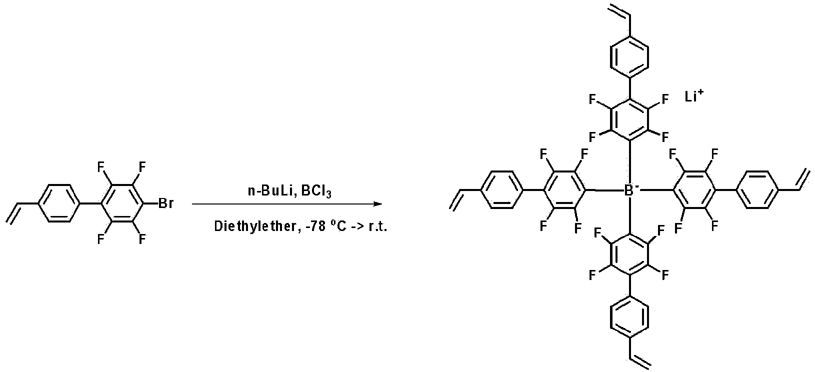

10 g (30.2014 mmol) of 4-bromo-2,3,5,6-tetrafluoro-4'-vinyl-1,1'-biphenyl and 100 mL of diethyl ether were put into a flask, and the resulting mixture was stirred under a condition of -78°C for 30 minutes. 12.08 mL (30.2014 mmol) of n-butyllithium was slowly added to the flask, and the resulting mixture was stirred under a condition of -78°C for 1 hour. 6.95 mL (6.9463 mmol, 1 M) of boron trichloride was slowly added thereto, and the resulting mixture was stirred overnight while being slowly warmed from -78°C to room temperature. 100 mL of water was added to the flask, and the resulting product was extracted three times with 100 mL of ethyl acetate to obtain an organic layer. The organic layer was removed and a residue was purified by column while changing an eluting solution from 50% and 100% ethyl acetate/hexane to 100% dichloromethane to obtain 6.3 g of a target compound lithium tetrakis(2,3,5,6-tetrafluoro-4'-vinyl-[1,1'-biphenyl]-4-yl)borate.

### 2) Synthesis Example 8-2

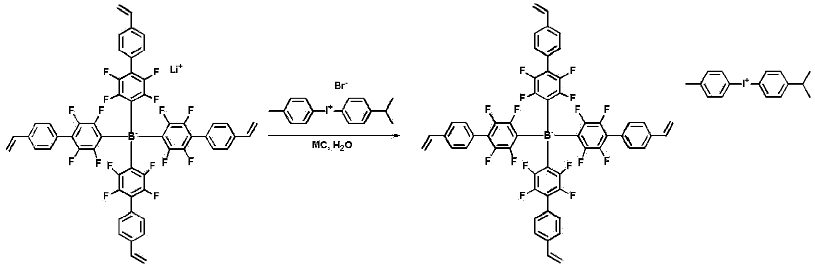

6.3 g (6.1610 mmol) of lithium tetrakis(2,3,5,6-tetrafluoro-4'-vinyl-[1,1'-biphenyl]-4-yl)borate, 30 mL of dichloromethane, and 30 mL of water were put into a flask, and the resulting mixture was stirred for 30 minutes. 2,574 mg (6.1610 mmol) of (4-isopropylphenyl) (p-tolyl)iodonium bromide was added to the flask, and the resulting mixture was vigorously stirred for 2 hours. The resulting product was extracted three times with 30 mL of dichloromethane to obtain an organic layer, and an organic solvent was removed. A residue was purified by column sequentially with 50% and 100% ethyl acetate/hexane and 100% dichloromethane to obtain 7.2 g of Comparative Compound 4 (4-isopropylphenyl) (p-tolyl)iodonium tetrakis(2,3,5,6-tetrafluoro-4'-vinyl-[1,1'-biphenyl]-4-yl)borate.

### Synthesis Example 9. Synthesis of Compound A

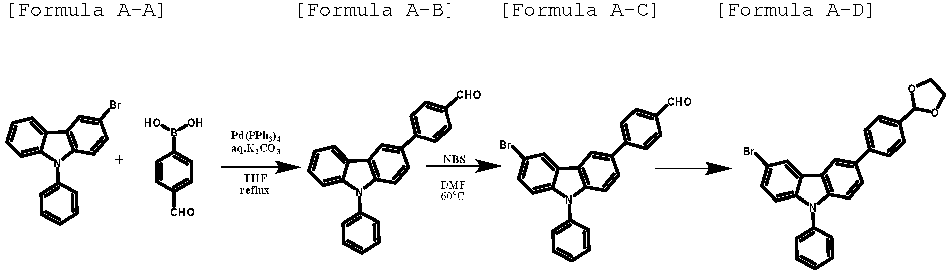

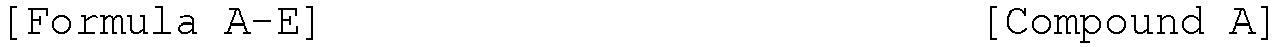

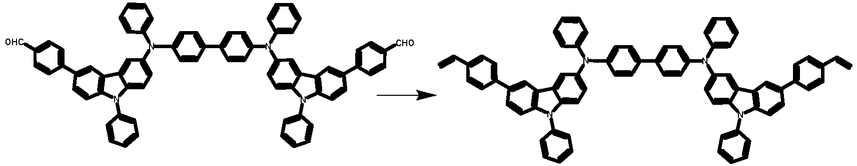

### 1) Preparation of Chemical Formula A-B

After Chemical Formula A-A (9 g, 27.9mmol) and 4-formylbenzene boric acid (4.18 g, 27.9 mmol) were dissolved in anhydrous tetrahydrofuran (THF) (100 mL), Pd(PPh₃)₄ (0.32 g, 0.28 mmol) and 70 ml of a 2 M potassium carbonate (K₂CO₃ /H₂0) aqueous solution were added thereto, and the resulting mixture was refluxed for 6 hours. After the reaction solution was cooled to room temperature, the organic layer was extracted. The reaction solution was concentrated and recrystallized with ethyl alcohol (EtOH) to obtain Chemical Formula A-B (8.9 g, yield 92%). MS: [M+H]+ = 348

### 2) Preparation of Chemical Formula A-C

Chemical Formula A-B (8.2 g, 23.6 mmol) prepared in Step 1) was dissolved in chloroform (200 mL), N-bromosuccinimide (4.15 g, 23.6 mmol) was added thereto, and then the resulting mixture was stirred at room temperature for 5 hours. Distilled water was put into the reaction solution, the reaction was terminated, and the organic layer was extracted. The reaction solution was concentrated and recrystallized with ethyl alcohol (EtOH) to obtain Chemical Formula A-C (8.25 g, yield 82%). MS: [M+H]+ = 427

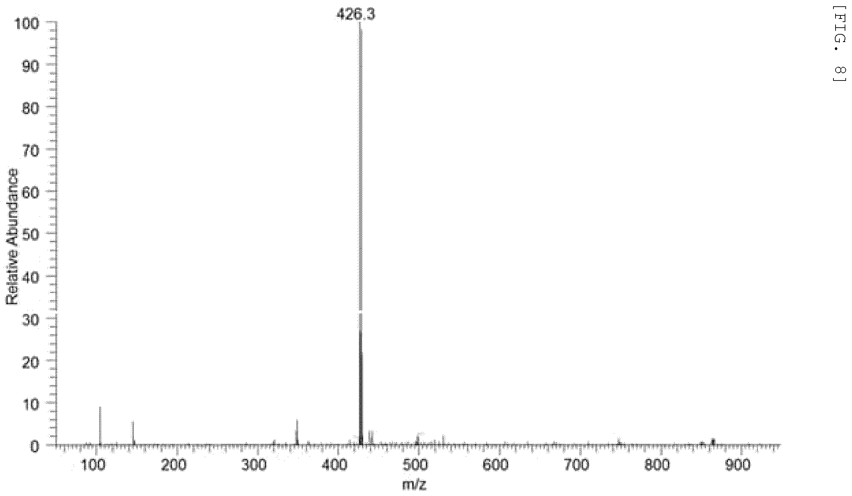

FIG. 8 is a view illustrating an MS spectrum of Chemical Formula A-C.

### 3) Preparation of Chemical Formula A-D

After dihydroxyethene (1.1 g, 17.7 mmol) was dissolved in 50 ml of toluene in Chemical Formula A-C (3.1 g, 8.85 mmol) prepared in Step 2), the resulting solution was stirred at 150°C for 48 hours. After ethanol was added to the reaction solution, a precipitate was formed. A formed ivory solid was filtered, washed with ethanol, and then dried under vacuum to obtain Chemical Formula A-D (2.8 g, yield 80.2%). MS: [M+H]+ = 469

### 4) Preparation of Chemical Formula A-E

Chemical Formula A-D (3 g, 7.04 mmol) prepared in Step 3) and N4,N4'-diphenyl-[1,1'-biphenyl]-4,4'-diamine (0.99 g, 2.93 mmol) were dissolved in 40 ml of xylene, sodium-tertiary-butoxide (0.68 g , 7.04 mmol), 0.13 g (0.23 mmol) of bis(dibenzylideneacetone)palladium(0), and 0.11 ml (0.23 mmol) of a 50 wt% tri-tertiary-butylphosphine toluene solution were added thereto, and then the resulting mixture was refluxed under nitrogen flow for 5 hours.

Distilled water was put into the reaction solution, the reaction was terminated, and the organic layer was extracted. After column separation was performed with a normal-hexane/tetrahydrofuran = 6/1 solvent, the resulting product was stirred in ethyl acetate (EtOH), filtered, and then dried under vacuum to obtain Chemical Formula A-E (2.92 g, yield 48 %). MS: [M+H]+ = 1027

### 5) Preparation of Chemical Formula A

After (bromomethyl)triphenylphosphonium bromide (2.55 g, 5.85 mmol) was dissolved in 100 mL of tetrahydrofuran (THF), 1 eq. of n-butyllithium (n-BuLi) (2.5M in HEX, 2.34 mL, 5.85 mmol) was added thereto at -78°C, and the resulting mixture was stirred for 20 minutes. After the reaction temperature was increased to 0°C, Chemical Formula A-E (2 g, 1.95 mmol) prepared in Step 4) was added to the reactant, and the resulting mixture was stirred at the same temperature for 1 hour. Distilled water was put into the reaction solution, the reaction was terminated, and the organic layer was extracted. The reaction solution was concentrated, dissolved in methylene chloride (MC), and then recrystallized with ethyl alcohol (EtOH) to obtain Chemical Formula A (1.28 g, yield 64%). MS: [M+H]+ = 1023

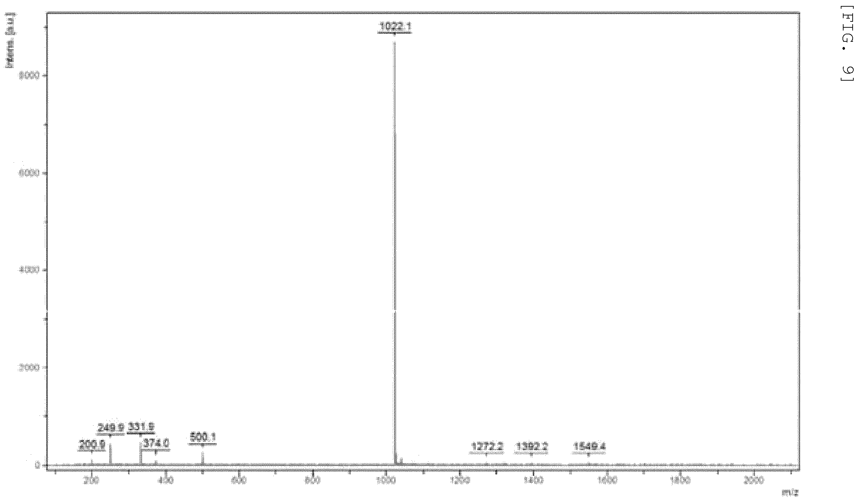

FIG. 9 is a view illustrating an MS spectrum of Chemical Formula A.

### Synthesis Example 10. Synthesis of Compound 5

### 1) Synthesis Example 10-1

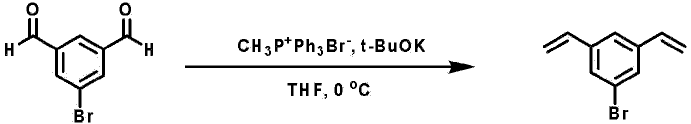

5-Bromoisophthaldehyde (5 g, 23.4709 mmol) and CH₃BrPPh₃(30.75 g, 70.4126 mmol) were put into tetrahydrofuran [THF], subsequently, potassium tert-butoxide [t-BuOK] (8.0 g, 70.4126 mmol) was added thereto at 0°C, and the resulting mixture was stirred at 0°C for 1 hour. The reaction was stopped with water, and the product was extracted with ethyl acetate (EA). After magnesium sulfate (MgSO₄) was added to the collected organic solution and the resulting mixture was dried and filtered, the organic solvent was removed by a vacuum rotary evaporator. A residue was purified by column to obtain 4.1 g of a target compound.

### 2) Synthesis Example 10-2

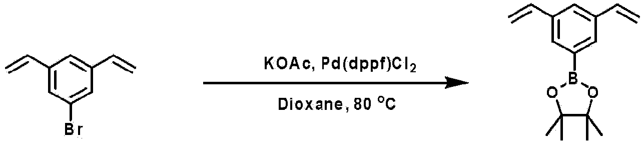

1-Bromo-3,5-divinylbenzene (4.1 g, 19.6088 mmol) was put into dioxane, potassium acetate (KOAc) (5.8 g, 58.8264 mmol) and bis(pinacolato)diboron (6.5 g, 25.4914 mmol) were additionally added thereto, and then the resulting mixture was bubbled with nitrogen at room temperature for 30 minutes. [1,1'-Bis(diphenylphosphino)ferrocene]dichloropalladium(II) (717 mg, 0.9804 mmol) was added thereto, and the resulting mixture was stirred under a condition of 80°C for 16 hours. The reaction was stopped with water, and the product was extracted with ethyl acetate. After the collected organic solution was dried by adding magnesium sulfate thereto and filtered, the organic solvent was removed by a vacuum rotary evaporator. A residue was purified by column to obtain 3.9 g of a target compound.

### 3) Synthesis Example 10-3

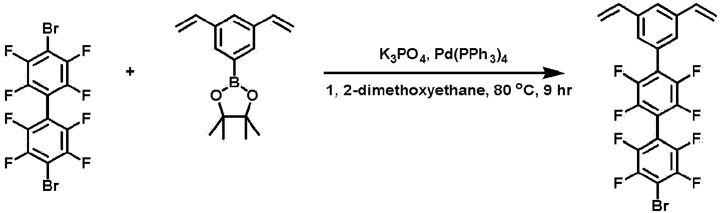

2-(3,5-Divinylphenyl)-4,4,5,5-tetramethyl-1,3,2-dioxaborolane (3.9 g, 15.2255 mmol) was put into 1,2-dimethoxyethane, potassium phosphate tribasic (K₃PO₄, 8.2 g, 38.6727 mmol) and 4,4'-dibromo-2,2',3,3',5,5',6,6'-octafluoro-1,1'-biphenyl (13.883 g, 30.4509 mmol) were additionally added thereto, and the resulting mixture was bubbled with nitrogen for 30 minutes. Tetrakis(triphenylphosphine)palladium(0) (704 mg, 0.6090 mmol) was added thereto, and the resulting mixture was stirred under a condition of 80°C for 9 hours. The reaction was stopped with water, and the product was extracted with ethyl acetate. After the collected organic solution was dried by adding magnesium sulfate thereto and filtered, the organic solvent was removed by a vacuum rotary evaporator. A residue was purified by column to obtain 4.1 g of 4-bromo-2,2',3,3',5,5',6,6'-octafluoro-3",5"-divinyl-1,1':4',1"-terphenyl.

### 4) Synthesis Example 10-4

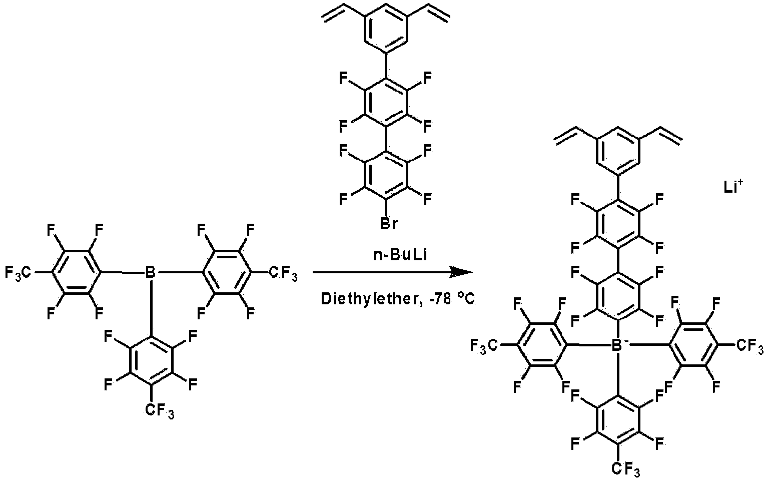

A tris(2,3,5,6-tetrafluoro-4-(trifluoromethyl)phenyl)borane solution was prepared as in the above-described Synthesis Example 1-2.

4-Bromo-2,2',3,3',5,5',6,6'-octafluoro-3",5"-divinyl-1,1':4',1"-terphenyl (2.829 g, 5.5999 mmol) was put into diethyl ether, and the resulting mixture was stirred under a condition of -78°C for 1 hour. n-Butyllithium (2.35 mL, 5.8799 mmol, 2.5 M) was slowly added thereto, and the resulting mixture was stirred under a condition of -78°C for 1 hour. The produced solution was slowly added to the prepared tris(2,3,5,6-tetrafluoro-4-(trifluoromethyl)phenyl)borane solution, and the resulting mixture was stirred overnight while being slowly warmed from -78°C to room temperature. The reaction was stopped with water, and the product was extracted with ethyl acetate. The solvent of the collected organic solution was removed by a vacuum rotary evaporator. A residue was purified by column sequentially with 50% ethyl acetate, 100% ethyl acetate, and 100% dichloromethane to obtain 3.0 g of a target compound.

### 5) Synthesis Example 10-5

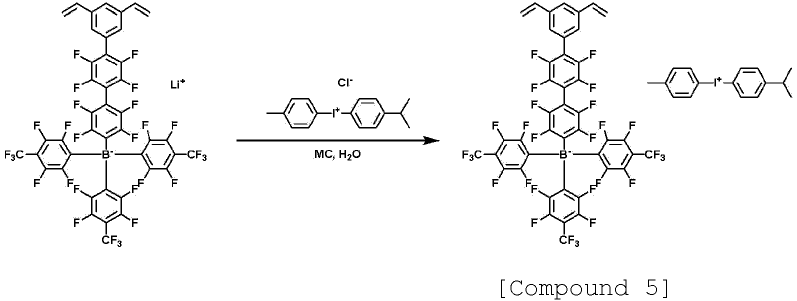

Lithium (2,2',3,3',5,5',6,6'-octafluoro-3",5"-divinyl-[1,1':4',1"-terphenyl]-4-yl)tris(2,3,5,6-tetrafluoro-4-(trifluoromethyl)phenyl)borate (3.0 g, 2.7416 mmol) was put into 36 ml of a mixed solvent of dichloromethane and water (volume ratio = 1 : 1), and the resulting mixture was stirred for 30 minutes. (4-Isopropylphenyl) (p-tolyl)iodonium chloride (1022 mg, 2.7416 mmol) was added thereto, and the resulting mixture was vigorously stirred for 1 hour. The reaction was stopped with water, and the product was extracted with dichloromethane. The solvent of the collected organic solution was removed by a vacuum rotary evaporator. A residue was purified by column sequentially with 50% ethyl acetate, 100% ethyl acetate, and 100% dichloromethane to obtain 3.4 g of [Compound 5].

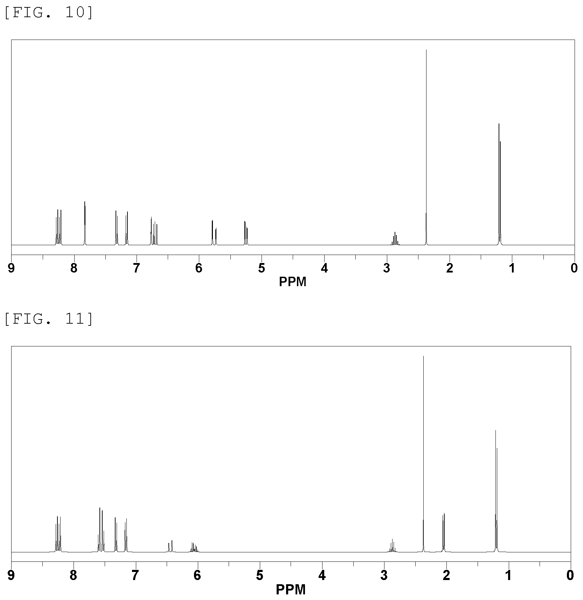

A view of measuring the NMR of Compound 5 is illustrated in FIG. 10.

m/z: 1424.08 (100.0%), 1425.08 (63.8%), 1423.08 (24.8%), 1426.09 (17.1%), 1424.09 (15.9%), 1427.09 (4.1%), 1425.09 (3.3%), 1426.09 (2.9%), 1425.09 (1.7%), 1426.09 (1.0%)

### Synthesis Example 11. Synthesis of Reference Compound 6

### 1) Synthesis Example 11-1

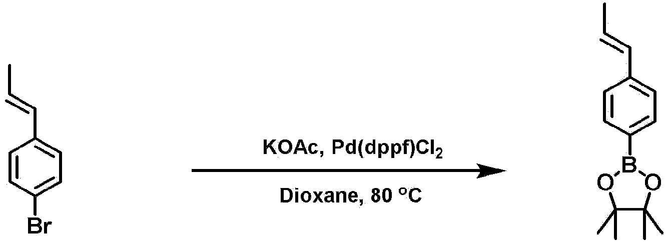

(E)-1-bromo-4-(prop-1-en-1-yl)benzene (5.0 g, 25.3704 mmol) was put into dioxane, potassium acetate (KOAc) (7.47 g, 76.1112 mmol) and bis(pinacolato)diboron (8.38 g, 32.9815 mmol) were additionally added thereto, and then the resulting mixture was bubbled with nitrogen at room temperature for 30 minutes. [1,1'-Bis(diphenylphosphino)ferrocene]dichloropalladium(II) (1035 mg, 1.2685 mmol) was added thereto, and the resulting mixture was stirred under a condition of 80°C for 16 hours. The reaction was stopped with water, and the product was extracted with ethyl acetate. After the collected organic solution was dried by adding magnesium sulfate thereto and filtered, the organic solvent was removed by a vacuum rotary evaporator. A residue was purified by column to obtain 4.5 g of a target compound.

### 2) Synthesis Example 11-2

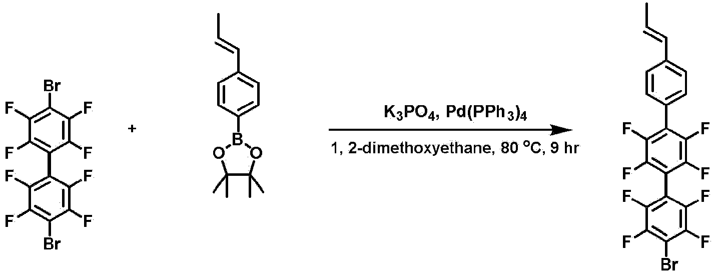

(E)-4,4,5,5-tetramethyl-2-(4-(prop-1-en-1-yl)phenyl)-1,3,2-dioxaborolane (4.5 g, 18.4320 mmol) was put into 1,2-dimethoxyethane, potassium phosphate tribasic (K₃PO₄, 9.9 g, 46.8174 mmol) and 4,4'-dibromo-2,2',3,3',5,5',6,6'-octafluoro-1,1'-biphenyl (16.807 g, 36.8640 mmol) were additionally added thereto, and the resulting mixture was bubbled with nitrogen for 30 minutes. Tetrakis(triphenylphosphine)palladium(0) (852 mg, 0.7373 mmol) was added thereto, and the resulting mixture was stirred under a condition of 80°C for 9 hours. The reaction was stopped with water, and the product was extracted with ethyl acetate. After the collected organic solution was dried by adding magnesium sulfate thereto and filtered, the organic solvent was removed by a vacuum rotary evaporator. A residue was purified by column to obtain 5.6 g of (E)-4-bromo-2,2',3,3',5,5',6,6'-octafluoro-4"-(prop-1-en-1-yl)-1,1':4',1"-terphenyl.

### 3) Synthesis Example 11-3

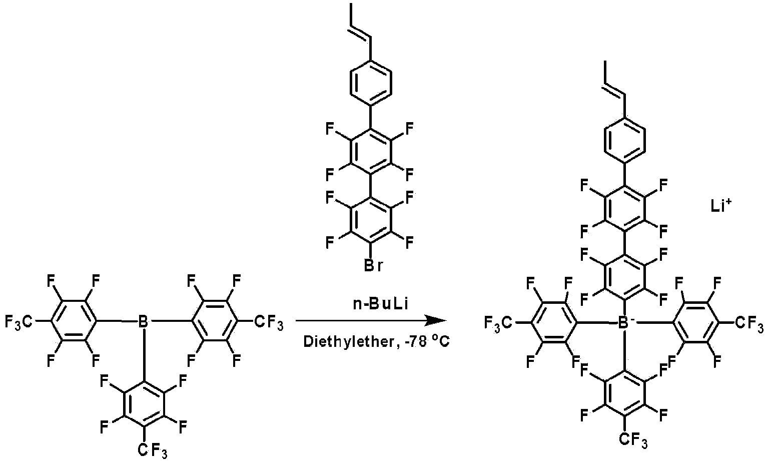

A tris(2,3,5,6-tetrafluoro-4-(trifluoromethyl)phenyl)borane solution was prepared as in the above-described Synthesis Example 1-2.

(E)-4-bromo-2,2',3,3',5,5',6,6'-octafluoro-4"-(prop-1-en-1-yl)-1,1':4',1"-terphenyl (5.6 g, 11.3547 mmol) was put into diethyl ether, and the resulting mixture was stirred under a condition of -78°C for 1 hour. n-Butyllithium (4.77 mL, 11.9224 mmol, 2.5 M) was slowly added thereto, and the resulting mixture was stirred under a condition of -78°C for 1 hour. The produced solution was slowly added to the prepared tris(2,3,5,6-tetrafluoro-4-(trifluoromethyl)phenyl)borane solution, and the resulting mixture was stirred overnight while being slowly warmed from -78°C to room temperature. The reaction was stopped with water, and the product was extracted with ethyl acetate. The solvent of the collected organic solution was removed by a vacuum rotary evaporator. A residue was purified by column sequentially with 50% ethyl acetate, 100% ethyl acetate, and 100% dichloromethane to obtain 7.4 g of a target compound.

### 4) Synthesis Example 11-4

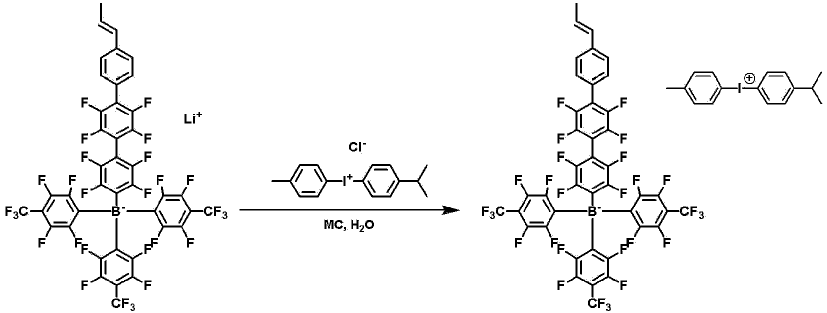

Lithium (E)-(2,2',3,3',5,5',6,6'-octafluoro-4"-(prop-1-en-1-yl)-[1,1':4',1"-terphenyl]-4-yl)tris(2,3,5,6-tetrafluoro-4-(trifluoromethyl)phenyl)borate (7.4 g, 6.8377 mmol) was put into 36 ml of a mixed solvent of dichloromethane (MC) and water (volume ratio = 1 : 1), and the resulting mixture was stirred for 30 minutes. (4-Isopropylphenyl) (p-tolyl)iodonium chloride (2548 mg, 6.8377 mmol) was added thereto, and the resulting mixture was vigorously stirred for 1 hour. The reaction was stopped with water, and the product was extracted with dichloromethane. The solvent of the collected organic solution was removed by a vacuum rotary evaporator. A residue was purified by column sequentially with 50% ethyl acetate, 100% ethyl acetate, and 100% dichloromethane to obtain 5.4 g of [Reference Compound 6].

A view of measuring the NMR of Reference Compound 6 is illustrated in FIG. 11.

m/z: 1412.08 (100.0%), 1413.08 (62.7%), 1411.08 (24.8%), 1414.09 (16.5%), 1412.09 (15.6%), 1415.09 (3.9%), 1413.09 (3.2%), 1414.09 (2.8%), 1413.09 (1.6%)

### <Examples>

### Example 1

As a coating composition, a coating composition was mixed as described in the following Table 1, and specifically, Coating Composition 1 was produced by mixing a p-doping material represented by the following Compound 1 of the present disclosure and a host compound [Compound A] and cyclohexanone. In this case, the coating composition was produced by mixing Compound 1, Compound A and the organic solvent at a weight ratio of 2 : 8 : 490.

A coating layer was formed by spin-coating Coating Composition 1, and the film was fired at 250°C or less.

### Example 2

Coating Composition 2 was produced in the same manner as in Coating Composition 1, except that Compound 2 was used instead of Compound 1 of the present disclosure, a coating layer was formed by spin-coating Coating Composition 2, and the film was fired at 250°C or less.

### Example 3

Coating Composition 3 was produced in the same manner as in Coating Composition 1, except that Compound 3 was used instead of Compound 1 of the present disclosure, a coating layer was formed by spin-coating Coating Composition 3, and the film was fired at 250°C or less.

### Example 4

Coating Composition 4 was produced in the same manner as in Coating Composition 1, except that Compound 4 was used instead of Compound 1 of the present disclosure, a coating layer was formed by spin-coating Coating Composition 4, and the film was fired at 250°C or less.

### Example 5

Coating Composition 5 was produced in the same manner as in Coating Composition 1, except that Compound 5 was used instead of Compound 1 of the present disclosure, a coating layer was formed by spin-coating Coating Composition 5, and the film was fired at 250°C or less.

### Comparative Example 1

Coating Composition 6 was produced in the same manner as in Coating Composition 1, except that Comparative Compound 1 was used instead of Compound 1 of the present disclosure, a coating layer was formed by spin-coating Coating Composition 6, and the film was fired at 250°C or less.

### Comparative Example 2

Coating Composition 7 was produced in the same manner as in Coating Composition 1, except that Comparative Compound 2 was used instead of Compound 1 of the present disclosure, a coating layer was formed by spin-coating Coating Composition 7, and the film was fired at 250°C or less.

### Comparative Example 3

Coating Composition 8 was produced in the same manner as in Coating Composition 1, except that Comparative Compound 3 was used instead of Compound 1 of the present disclosure, a coating layer was formed by spin-coating Coating Composition 8, and the film was fired at 250°C or less.

### Comparative Example 4

Coating Composition 9 was produced in the same manner as in Coating Composition 1, except that Comparative Compound 4 was used instead of Compound 1 of the present disclosure, a coating layer was formed by spin-coating Coating Composition 9, and the film was fired at 250°C or less.

### Reference Example 6

Coating Composition 10 was produced in the same manner as in Coating Composition 1, except that Reference Compound 6 was used instead of Compound 1 of the present disclosure, a coating layer was formed by spin-coating Coating Composition 10, and the film was fired at 250°C or less.

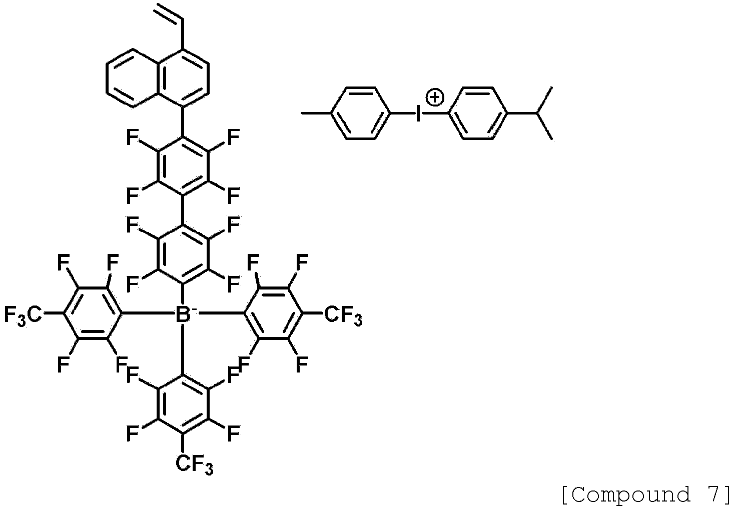

### Example 7

Coating Composition 11 was produced in the same manner as in Coating Composition 1, except that Compound 7 was used instead of Compound 1 of the present disclosure, a coating layer was formed by spin-coating Coating Composition 11, and the film was fired at 250°C or less.

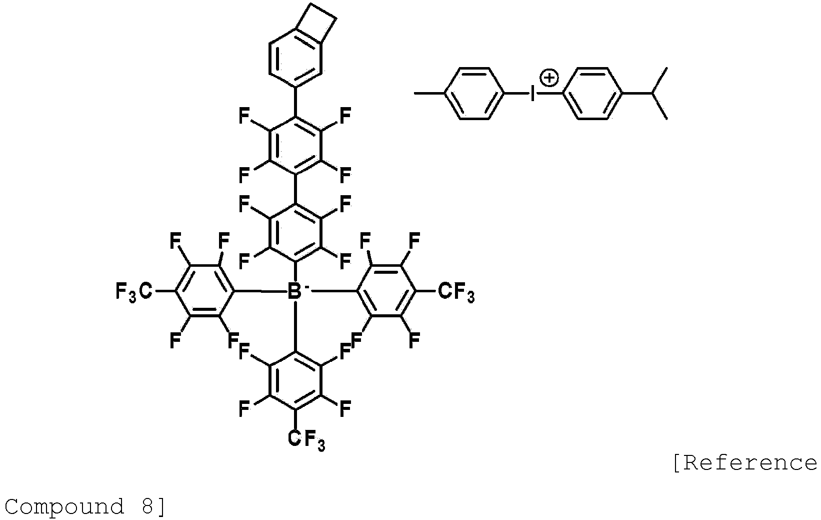

### Reference Example 8

Coating Composition 12 was produced in the same manner as in Coating Composition 1, except that Reference Compound 8 was used instead of Compound 1 of the present disclosure, a coating layer was formed by spin-coating Coating Composition 12, and the film was fired at 250°C or less.

**[Table 1]**

| Coating Composition | Host | p-doping material | Spin speed (rpm) /Time (s) | Firing temperature (°C) /Time (min) |
|---|---|---|---|---|
| 1 | Compound A | Compound 1 | 1000/60 | 230/30 |
| 2 | Compound A | Compound 2 | 1000/60 | 230/30 |
| 3 | Compound A | Compound 3 | 1000/60 | 230/30 |
| 4 | Compound A | Compound 4 | 1000/60 | 230/30 |
| 5 | Compound A | Compound 5 | 1000/60 | 230/30 |
| 6 | Compound A | Comparative Compound 1 | 1000/60 | 230/30 |
| 7 | Compound A | Comparative Compound 2 | 1000/60 | 230/30 |
| 8 | Compound A | Comparative Compound 3 | 1000/60 | 230/30 |
| 9 | Compound A | Comparative Compound 4 | 1000/60 | 230/30 |
| 10 | Compound A | Reference Compound 6 | 1000/60 | 230/30 |
| 11 | Compound A | Compound 7 | 1000/60 | 230/30 |
| 12 | Compound A | Reference Compound 8 | 1000/60 | 230/30 |

Through Examples 1 to 5 and 7, Reference Examples 6 and 8 and Comparative Examples 1 to 4, it was confirmed that a film was formed.

### <Experimental Example 1>

In order to confirm the film retention rates of Compound 1, Compound 3, Compound 5, Reference Compound 6, Compound 7, Reference Compound 8 and Comparative Compounds 1 to 4, the UV-vis absorption spectrum of the film formed by the following method was measured.

For the film retention rate, the solvent resistances of Compound 1, Compound 3, Compound 5, Reference Compound 6, Compound 7, Reference Compound 8 and Comparative Compounds 1 to 4 were evaluated using cyclohexanone. Specifically, a solution, in which 4 wt% of each of Compound 1, Compound 3, Compound 5, Reference Compound 6, Compound 7, Reference Compound 8 and Comparative Compounds 1 to 4 prepared above was dissolved in cyclohexanone, was prepared, and then a quartz substrate was spin-coated with the solution to have a thickness of 100 nm. Thereafter, after the substrate was heat-treated at a temperature of 190°C to 200°C in a nitrogen atmosphere for 30 minutes, the UV-vis absorption spectrum was measured. Subsequently, the same sample was immersed in cyclohexanone for 10 minutes and remove, the solvent was dried from the sample, and then the UV-vis absorption spectrum was also measured.

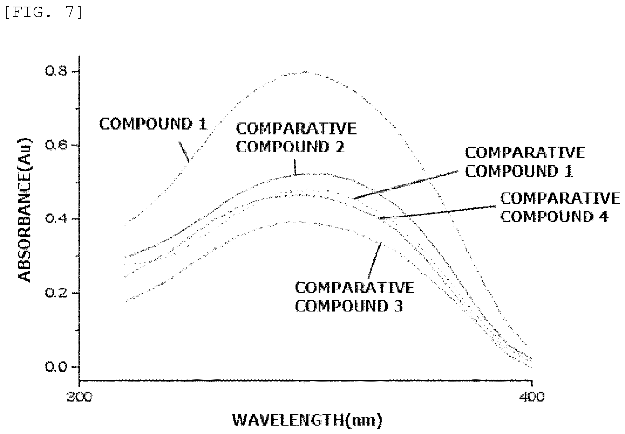

In this case, the UV-vis absorption spectra for Compound 1 and Comparative Compounds 1 to 4 after immersion in the solvent, which are capable of confirming the film retention rates, are illustrated in FIG. 7, and the absorbances at 350 nm, which is the maximum absorption wavelength for Compound 1, Compound 3, Compound 5, Reference Compound 6, Compound 7, Reference Compound 8 and Comparative Compounds 1 to 4, are compared in the following Table 2.

**[Table 2]**

| Classification | p-doping material | Absorbance @ 350nm |
|---|---|---|
| Example 1 | Compound 1 | 0.802 |
| Example 3 | Compound 3 | 0.813 |
| Example 5 | Compound 5 | 0.801 |
| Comparative Example 1 | Comparative Compound 1 | 0.483 |
| Comparative Example 2 | Comparative Compound 2 | 0.526 |
| Comparative Example 3 | Comparative Compound 3 | 0.392 |
| Comparative Example 4 | Comparative Compound 4 | 0.467 |
| Reference Example 6 | Reference Compound 6 | 0.524 |
| Example 7 | Compound 7 | 0.603 |
| Reference Example 8 | Reference Compound 8 | 0.546 |

In the process of manufacturing the device, the film is retained while being cured during the heat treatment. The higher absorbance means that a relatively more residue remains on the film. Through FIG. 7 and Table 2, it could be confirmed that in the case of Comparative Examples 1 to 4 where the comparative compounds were used, the absorbance was relatively low because the film was not retained compared to Example 1 where Compound 1 was used and there was a portion which was washed off.

### <Experimental Example 2>

Solubilities were confirmed by dissolving Compounds 1 to 3, Compound 5 and Comparative Compound 4 synthesized as p-doping materials at a weight ratio of 5 wt% relative to each solvent shown in the following Table 3.

**[Table 3]**

| Solvent | Toluene | Dichloromet hane | Acetone |
|---|---|---|---|
| Compound 1 | Dissolved | Dissolved | Dissolved |
| Compound 2 | Dissolved | Dissolved | Dissolved |
| Compound 3 | Dissolved | Dissolved | Dissolved |
| Compound 5 | Dissolved | Dissolved | Dissolved |
| Comparative Compound 4 | Insoluble | Dissolved | Dissolved |

Through the experimental results, it can be confirmed that the compound of the present specification having asymmetry compared to Comparative Compound 4 has a property of being dissolved relatively well in a non-polar solvent. In a solution process organic light emitting device, when an ink solvent is selected for the process, the ink solvent needs to dissolve both a host and a dopant. In this regard, the solubility of the dopant is important, and the compound of the present specification has solubility for a wider variety of solvents, and thus has an advantage in that a wider variety of solvents can be selected.

## Claims

1. A compound represented by the following Chemical Formula 1: 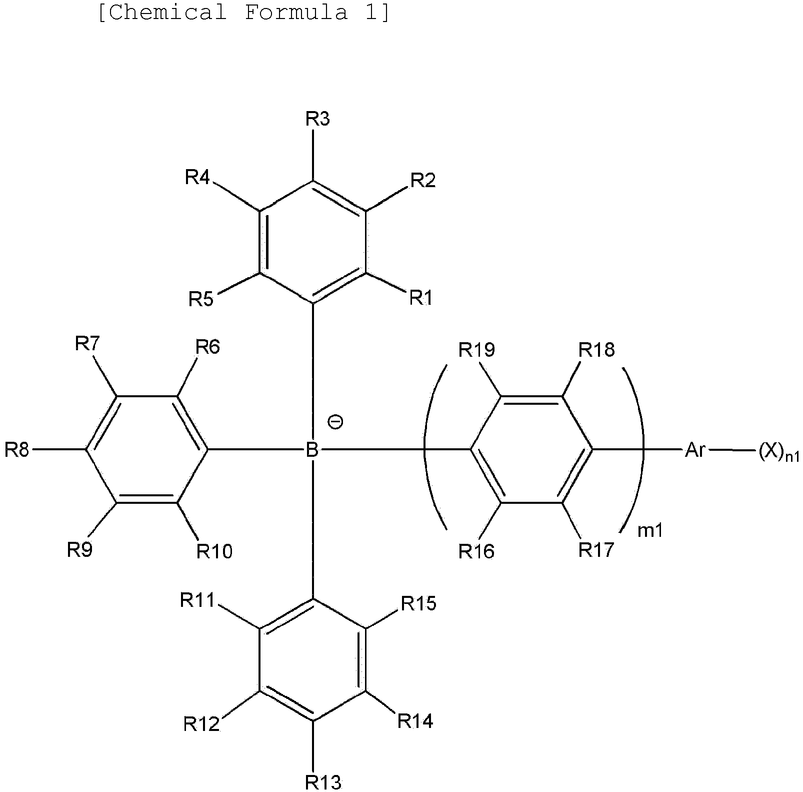 in Chemical Formula 1,
R1 to R19 are the same as or different from each other, and are each independently hydrogen, deuterium, a fluoro group, a fluoroalkyl group, a cyano group, or a substituted or unsubstituted alkyl group,
Ar is a substituted or unsubstituted (n1+1)-valent aryl group,
X is selected from the following structures: 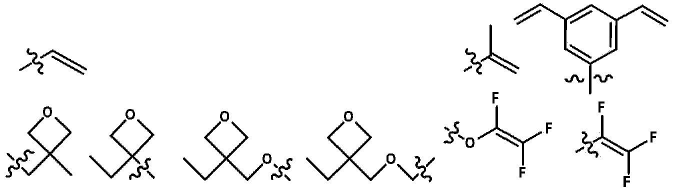 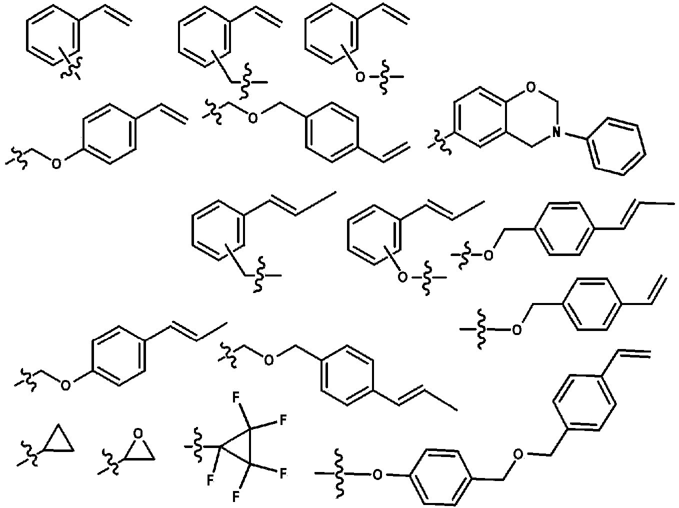 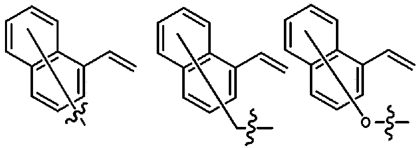 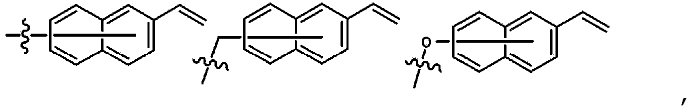 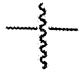
is a moiety to be bonded,
m1 is an integer from 1 to 3, and when m1 is 2 or higher, two or more substituents in the parenthesis are the same as or different from each other, and
n1 is an integer from 1 to 5, and when n1 is 2 or higher, two or more substituents in the parenthesis are the same as or different from each other.

2. The compound of claim 1, wherein Chemical Formula 1 is represented by the following Chemical Formula 2 or 3: 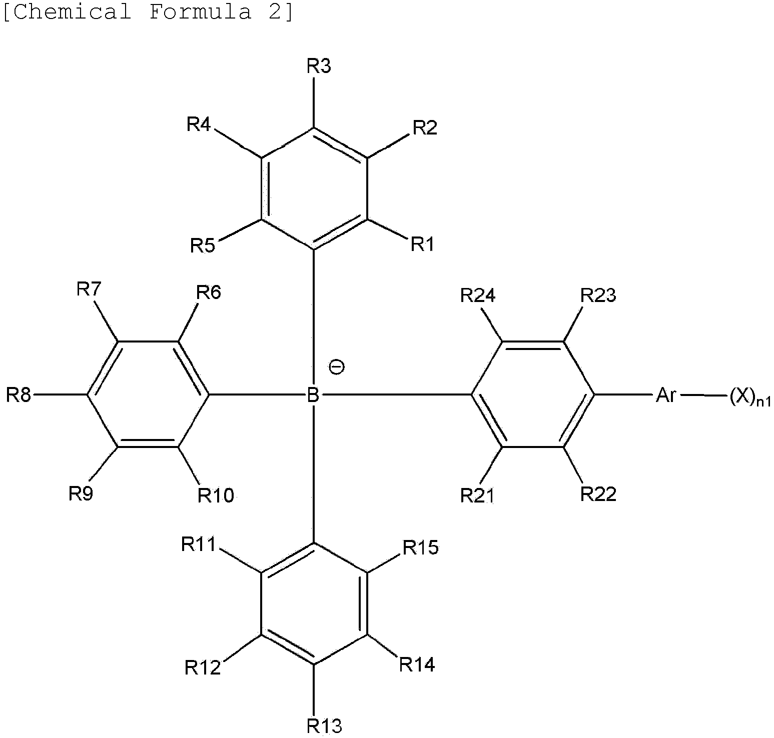 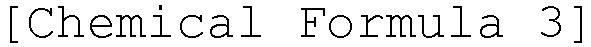 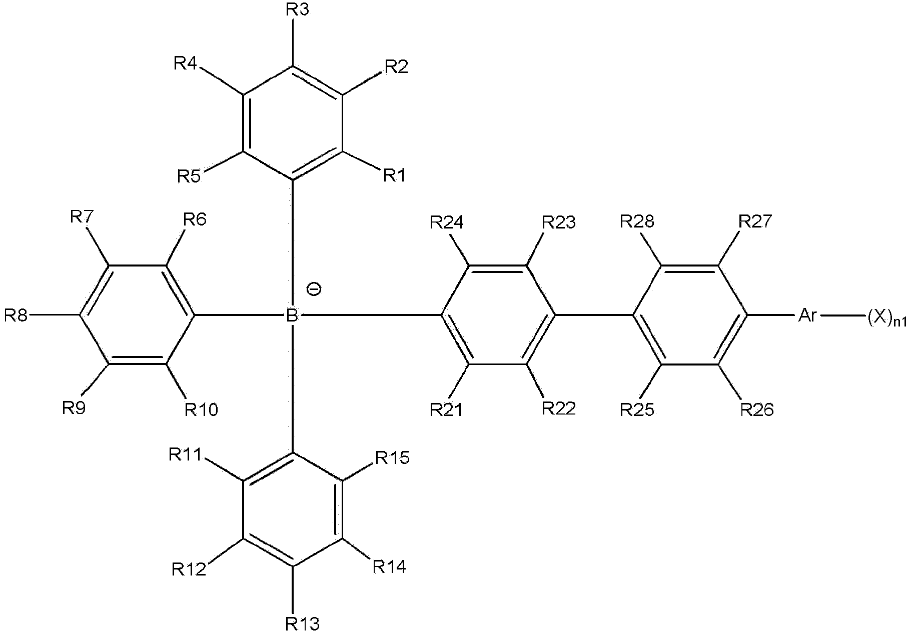 in Chemical Formulae 2 and 3,
R1 to R15, Ar, X and n1 are the same as those defined in Chemical Formula 1, and
R21 to R28 are the same as or different from each other, and are each independently hydrogen, deuterium, a fluoro group, a fluoroalkyl group, a cyano group, or a substituted or unsubstituted alkyl group.

3. The compound of claim 1, wherein Ar is a substituted or unsubstituted (n1+1)-valent aryl group having 6 to 30 carbon atoms.

4. The compound of claim 1, wherein Chemical Formula 1 is represented by the following Chemical Formula 4: 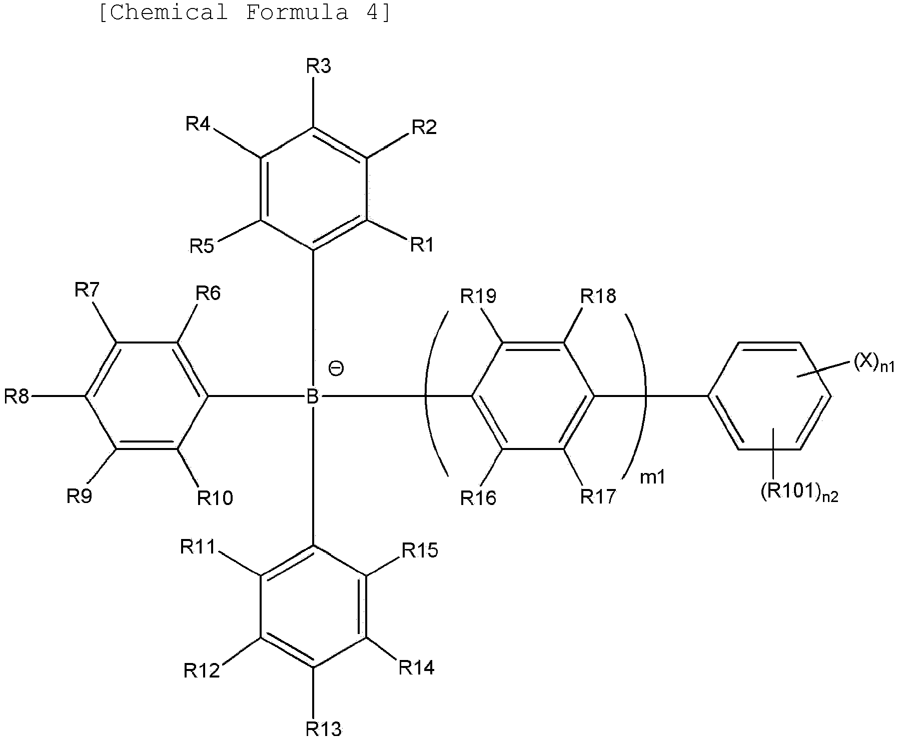 in Chemical Formula 4,
R1 to R19, X, n1 and m1 are the same as those defined in Chemical Formula 1,
R101 is hydrogen; deuterium; a halogen group; a substituted or unsubstituted alkyl group; a substituted or unsubstituted alkoxy group; a substituted or unsubstituted aryl group; or a substituted or unsubstituted heteroaryl group, and
n2 is an integer from 0 to 4, and when n2 is 2 or higher, two or more R101's are the same as or different from each other, and n1+n2 is 1 to 5.

5. The compound of claim 1, wherein Chemical Formula 1 is represented by the following Chemical Formula 5 or 6: 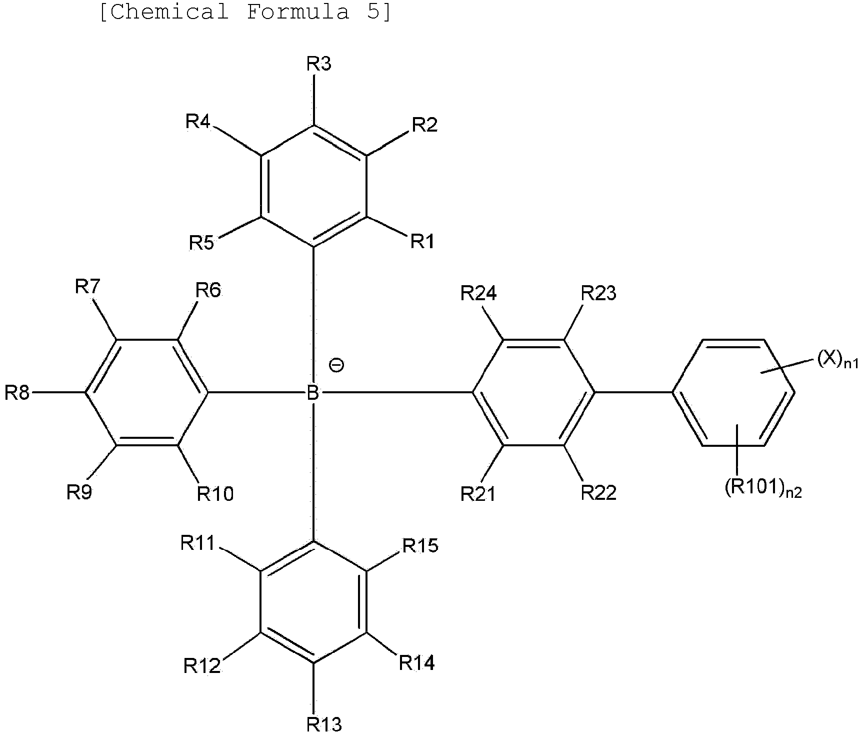 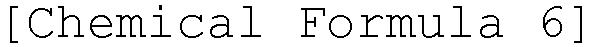 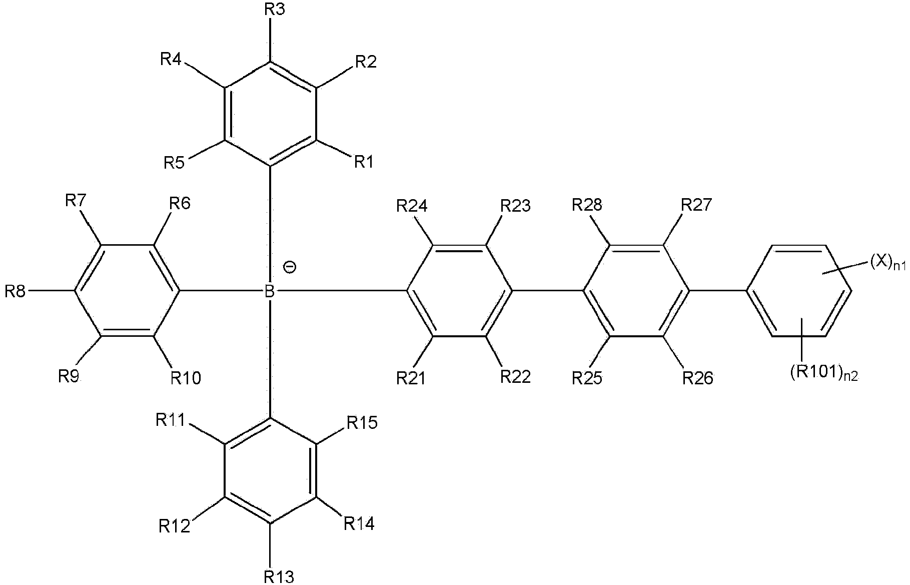 in Chemical Formulae 5 and 6,
R1 to R15, X and n1 are the same as those defined in Chemical Formula 1,
R21 to R28 are the same as or different from each other, and are each independently hydrogen, deuterium, a fluoro group, a fluoroalkyl group, a cyano group, or a substituted or unsubstituted alkyl group,
R101 is hydrogen; deuterium; a halogen group; a substituted or unsubstituted alkyl group; a substituted or unsubstituted alkoxy group; a substituted or unsubstituted aryl group; or a substituted or unsubstituted heteroaryl group, and
n2 is an integer from 0 to 4, and when n2 is 2 or higher, two or more R101's are the same as or different from each other, and n1+n2 is 1 to 5.

6. The compound of claim 1, wherein R1 to R19 are the same as or different from each other, and are each independently a fluoro group or a fluoroalkyl group.

7. The compound of claim 1, further comprising a counterion.

8. The compound of claim 1, wherein Chemical Formula 1 is represented by any one of the following compounds:

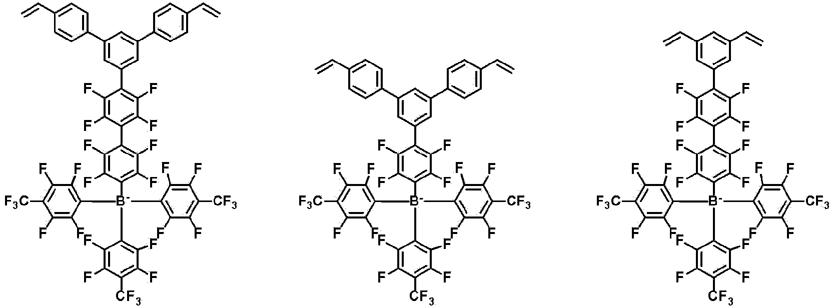

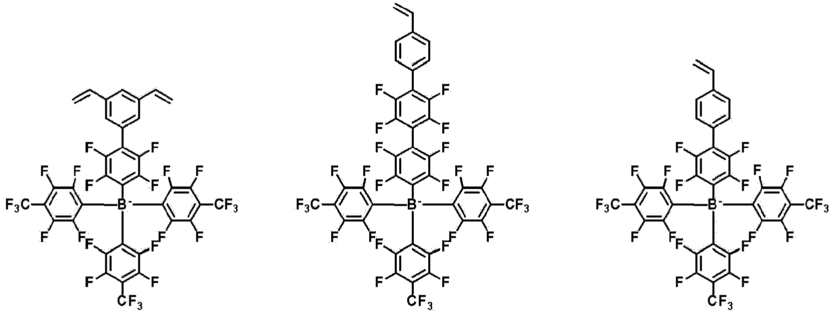

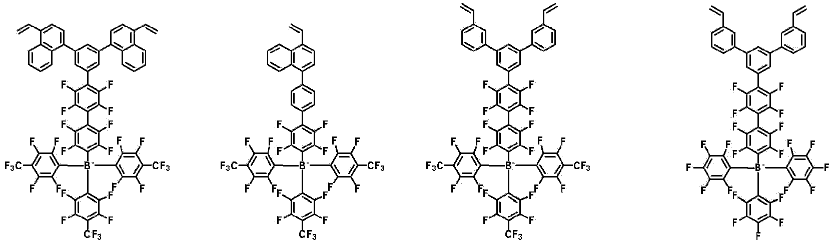

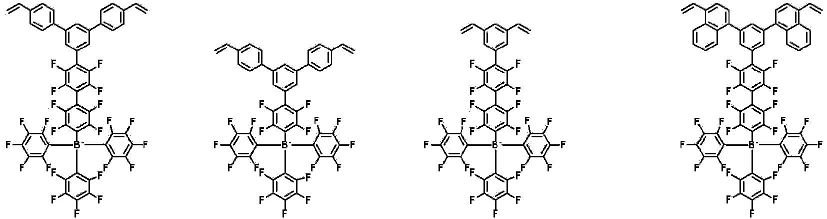

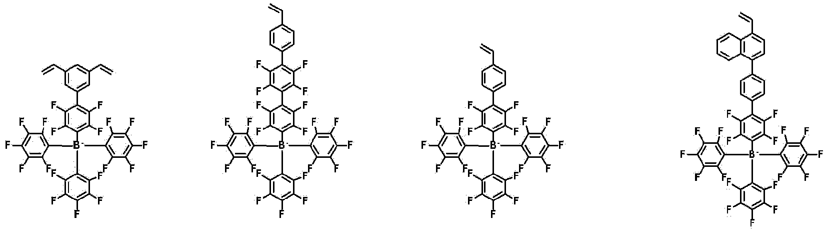

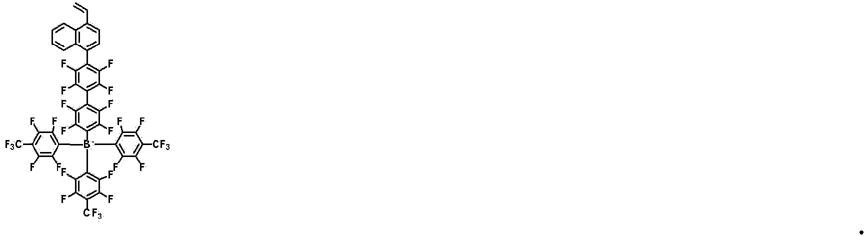

9. A coating composition comprising the compound of any one of claims 1 to 8.

10. An organic light emitting device comprising:
a first electrode;
a second electrode; and
an organic material layer having one or more layers provided between the first electrode and the second electrode,
wherein one or more layers of the organic material layer comprise the coating composition of claim 9 or a cured product thereof.

11. The organic light emitting device of claim 10, wherein the organic material layer comprising the coating composition or the cured product thereof is a hole transport layer or a hole injection layer.

12. A method of manufacturing an organic light emitting device, the method comprising:
preparing a substrate;
forming a first electrode on the substrate;
forming an organic material layer having one or more layers on the first electrode; and
forming a second electrode on the organic material layer,
wherein the forming of the organic material layer comprises forming an organic material layer having one or more layers by using the coating composition of claim 9.

13. The method of claim 12, wherein the forming of the organic material layer having one or more layers by using the coating composition comprises:
coating the coating composition on the first electrode; and
heat-treating or light-treating the coated coating composition.

## Patentansprüche

1. Verbindung, die durch die folgende chemische Formel 1 dargestellt ist: 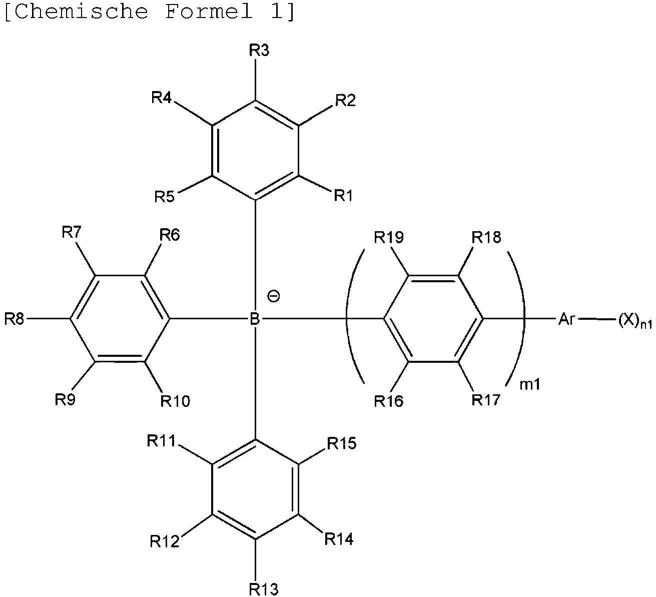 worin, in der chemischen Formel 1,
R1 bis R19 sind gleich oder verschieden und jeweils unabhängig Wasserstoff, Deuterium, eine Fluorgruppe, eine Fluoralkylgruppe, eine Cyanogruppe oder eine substituierte oder unsubstituierte Alkylgruppe,
Ar ist eine substituierte oder unsubstituierte (n1+1)-wertige Arylgruppe,
X ist aus den folgenden Strukturen ausgewählt: 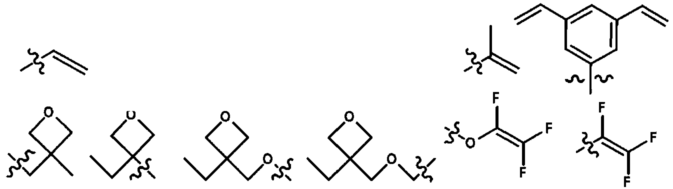 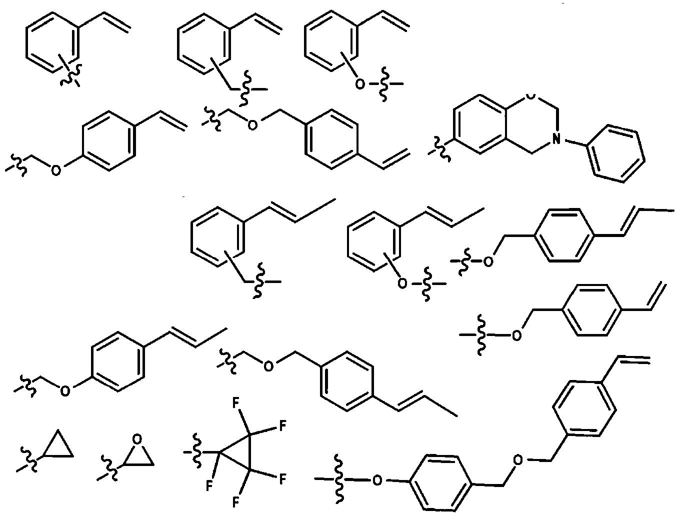 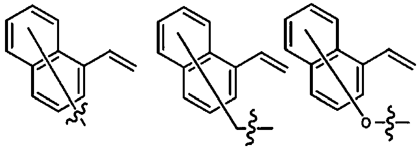 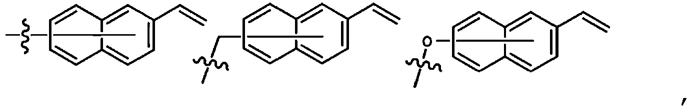 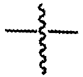
ist eine zu bindende Einheit,
m1 ist eine ganze Zahl von 1 bis 3, und wenn m1 2 oder höher ist, sind zwei oder mehr Substituenten in der Klammer gleich oder verschieden, und
n1 ist eine ganze Zahl von 1 bis 5, und wenn n1 2 oder höher ist, sind zwei oder mehr Substituenten in der Klammer gleich oder verschieden.

2. Verbindung nach Anspruch 1, wobei die chemische Formel 1 durch die folgende chemische Formel 2 oder 3 dargestellt ist: 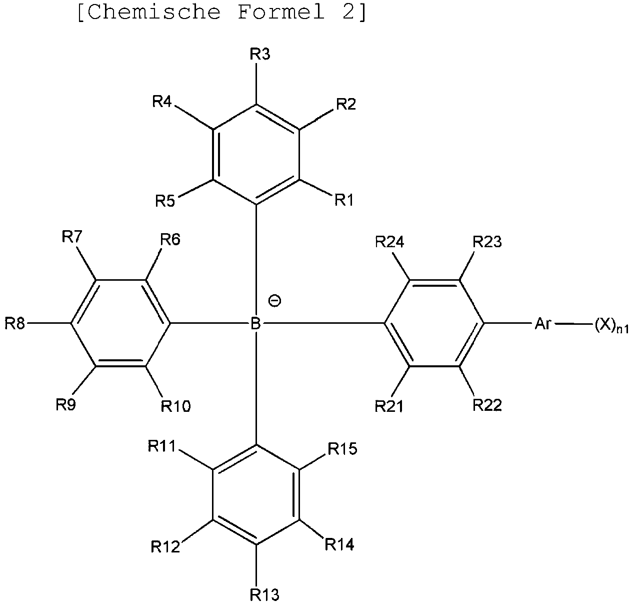 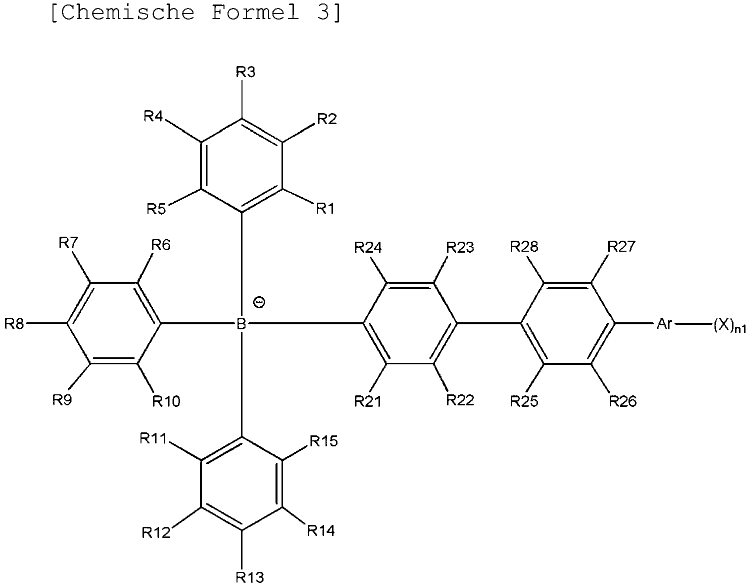 worin, in den chemischen Formeln 2 und 3,
R1 bis R15, Ar, X und n1 sind die gleichen wie in der chemischer Formel 1 definiert, und
R21 bis R28 sind gleich oder verschieden und sind jeweils unabhängig Wasserstoff, Deuterium, eine Fluorgruppe, eine Fluoralkylgruppe, eine Cyanogruppe oder eine substituierte oder unsubstituierte Alkylgruppe.

3. Verbindung nach Anspruch 1, wobei Ar eine substituierte oder unsubstituierte (n1+1)-wertige Arylgruppe mit 6 bis 30 Kohlenstoffatomen ist.

4. Verbindung nach Anspruch 1, wobei die chemische Formel 1 durch die folgende chemische Formel 4 dargestellt ist: 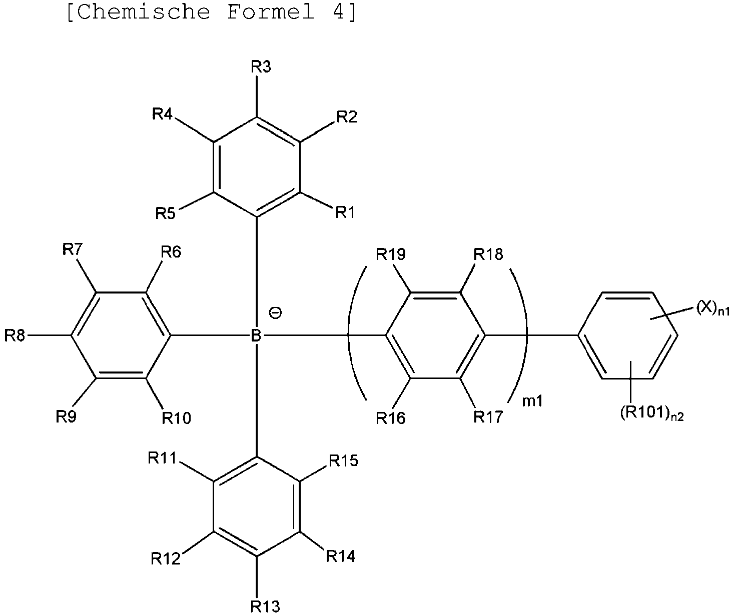 worin, in der chemischen Formel 4,
R1 bis R19, X, n1 und m1 sind die gleichen wie in der chemischen Formel 1 definiert,
R101 ist Wasserstoff; Deuterium; eine Halogengruppe; eine substituierte oder unsubstituierte Alkylgruppe; eine substituierte oder unsubstituierte Alkoxygruppe; eine substituierte oder unsubstituierte Arylgruppe; oder eine substituierte oder unsubstituierte Heteroarylgruppe, und
n2 ist eine ganze Zahl von 0 bis 4, und wenn n2 2 oder höher ist, sind zwei oder mehr R101 gleich oder verschieden und n1+n2 ist 1 bis 5.

5. Verbindung nach Anspruch 1, wobei die chemische Formel 1 durch die folgende chemische Formel 5 oder 6 dargestellt ist: 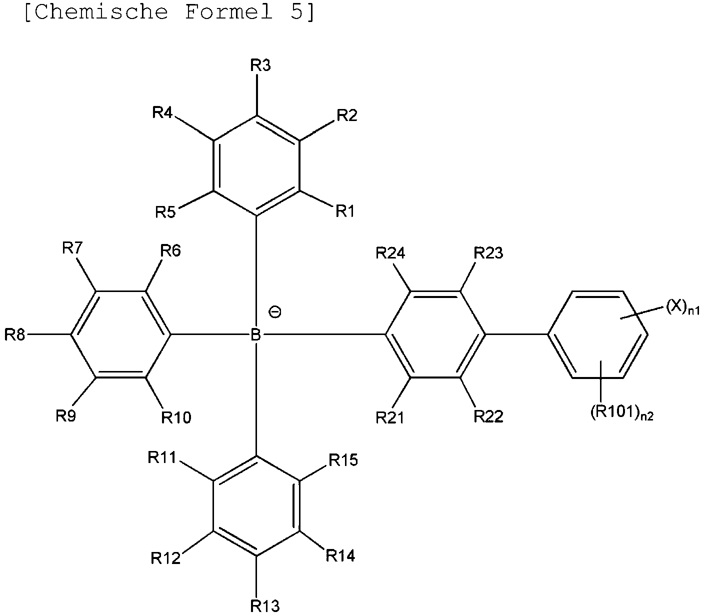 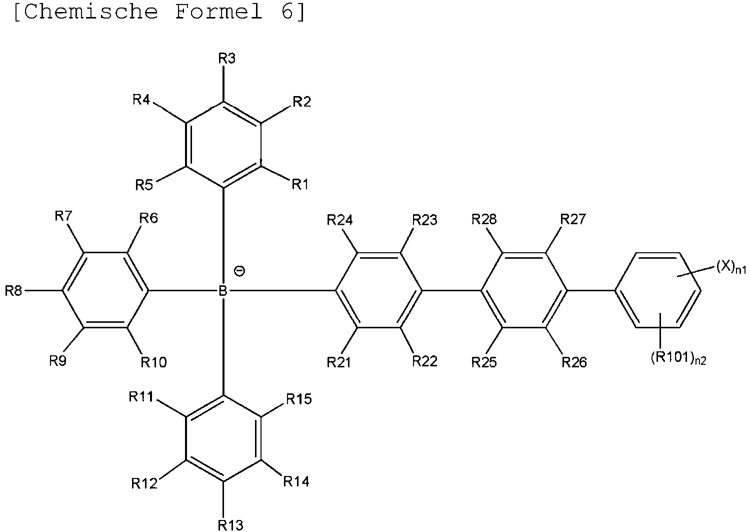 worin, in den chemischen Formeln 5 und 6,
R1 bis R15, X und n1 sind die gleichen wie in der chemischen Formel 1 definiert,
R21 bis R28 sind gleich oder verschieden und sind jeweils unabhängig Wasserstoff, Deuterium, eine Fluorgruppe, eine Fluoralkylgruppe, eine Cyanogruppe oder eine substituierte oder unsubstituierte Alkylgruppe,
R101 ist Wasserstoff, Deuterium, eine Halogengruppe, eine substituierte oder unsubstituierte Alkylgruppe, eine substituierte oder unsubstituierte Alkoxygruppe, eine substituierte oder unsubstituierte Arylgruppe oder eine substituierte oder unsubstituierte Heteroarylgruppe, und
n2 ist eine ganze Zahl von 0 bis 4, und wenn n2 2 oder höher ist, sind zwei oder mehr R101 gleich oder verschieden, und n1+n2 ist 1 bis 5.

6. Verbindung nach Anspruch 1, wobei R1 bis R19 gleich oder verschieden sind und jeweils unabhängig eine Fluorgruppe oder eine Fluoralkylgruppe darstellen.

7. Verbindung nach Anspruch 1, die ferner ein Gegenion umfasst.

8. Verbindung nach Anspruch 1, wobei die chemische Formel 1 durch eine beliebige der folgenden Verbindungen dargestellt ist:

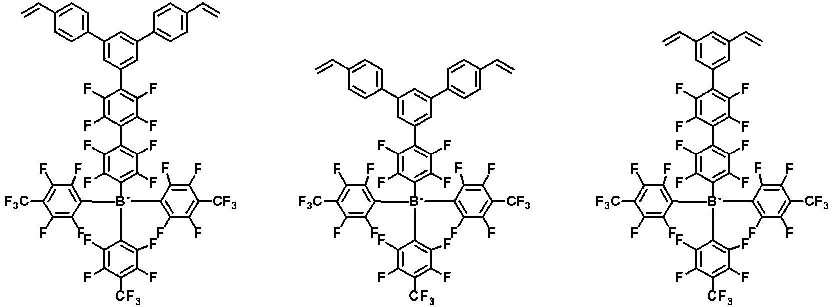

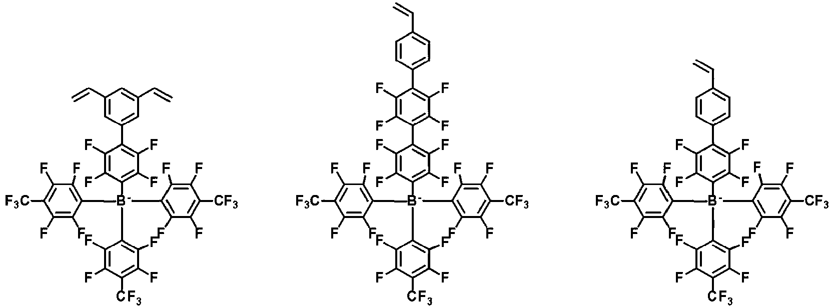

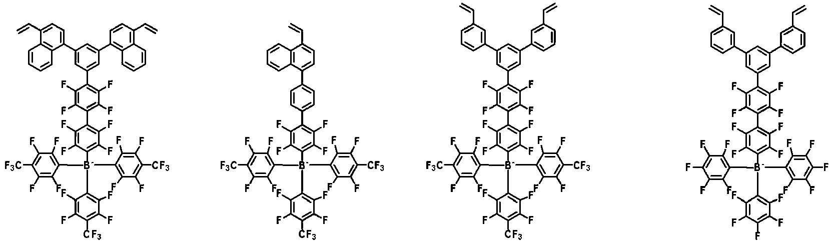

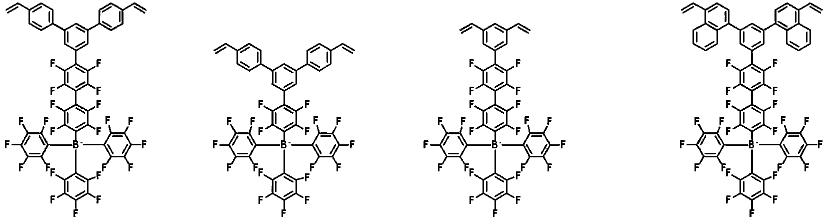

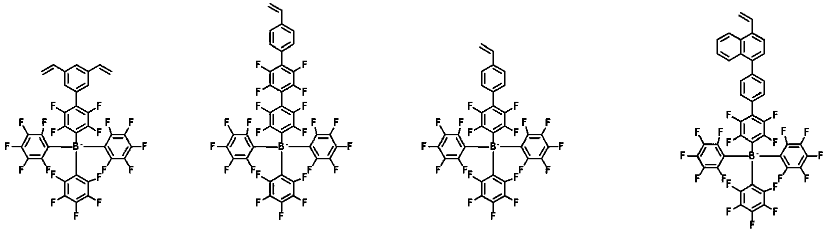

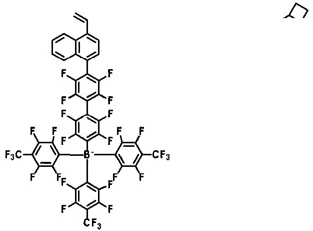

9. Beschichtungszusammensetzung, die die Verbindung nach mindestens einem der Ansprüche 1 bis 8 umfasst.

10. Organische lichtemittierende Vorrichtung, umfassend:
eine erste Elektrode;
eine zweite Elektrode; und
eine organische Materialschicht mit einer oder mehreren Schichten, die zwischen der ersten Elektrode und der zweiten Elektrode angeordnet ist,
wobei eine oder mehrere Schichten der organischen Materialschicht die Beschichtungszusammensetzung nach Anspruch 9 oder ein gehärtetes Produkt davon umfassen.

11. Organische lichtemittierende Vorrichtung nach Anspruch 10, wobei die organische Materialschicht, die die Beschichtungszusammensetzung oder das gehärtete Produkt davon umfasst, eine Lochtransportschicht oder eine Lochinjektionsschicht ist.

12. Verfahren zur Herstellung einer organischen lichtemittierenden Vorrichtung, wobei das Verfahren folgendes umfasst:
Vorbereiten eines Substrats;
Ausbilden einer ersten Elektrode auf dem Substrat;
Ausbilden einer organischen Materialschicht mit einer oder mehreren Schichten auf der ersten Elektrode; und
Ausbilden einer zweiten Elektrode auf der organischen Materialschicht,
wobei das Ausbilden der organischen Materialschicht das Ausbilden einer organischen Materialschicht mit einer oder mehreren Schichten unter Verwendung der Beschichtungszusammensetzung nach Anspruch 9 umfasst.

13. Verfahren nach Anspruch 12, bei dem das Ausbilden der organischen Materialschicht mit einer oder mehreren Schichten unter Verwendung der Beschichtungszusammensetzung folgendes umfasst:
Auftragen der Beschichtungszusammensetzung auf die erste Elektrode; und
Wärmebehandeln oder Lichtbehandeln der aufgetragenen Beschichtungszusammensetzung.

## Revendications

1. Composé représenté par la formule chimique 1 suivante : 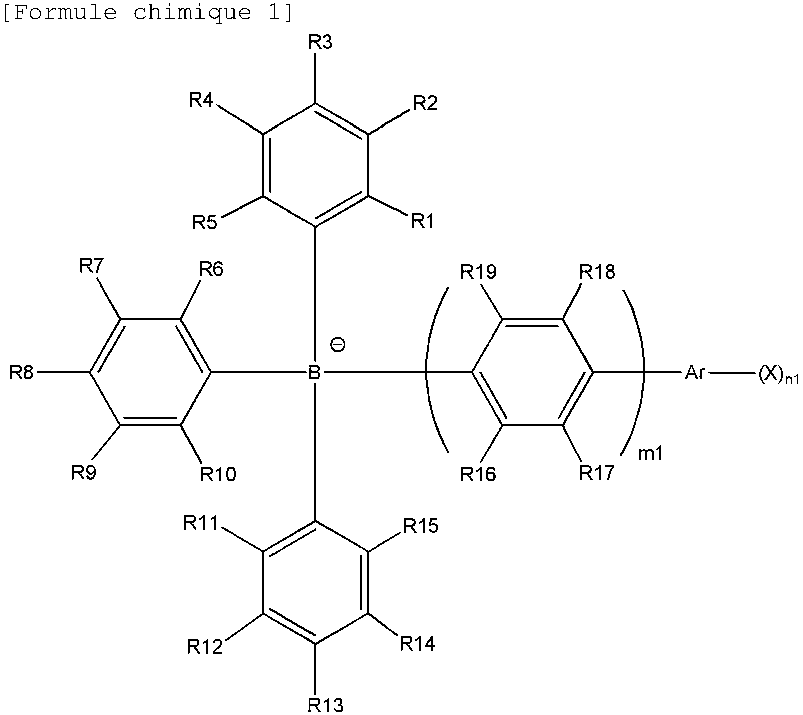 dans la formule chimique 1,
R1 à R19 sont identiques ou différents les uns des autres, et représentent chacun indépendamment un atome d'hydrogène, un atome de deutérium, un groupe fluoro, un groupe fluoroalkyle, un groupe cyano ou un groupe alkyle substitué ou non substitué,
Ar est un groupe aryle (n1+1)-valent substitué ou non substitué,
X est choisi parmi les structures suivantes : 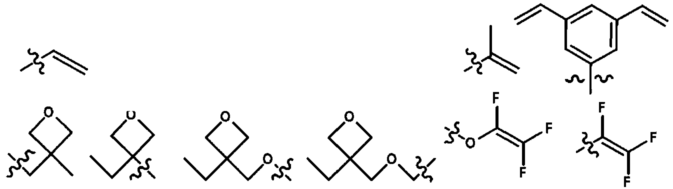 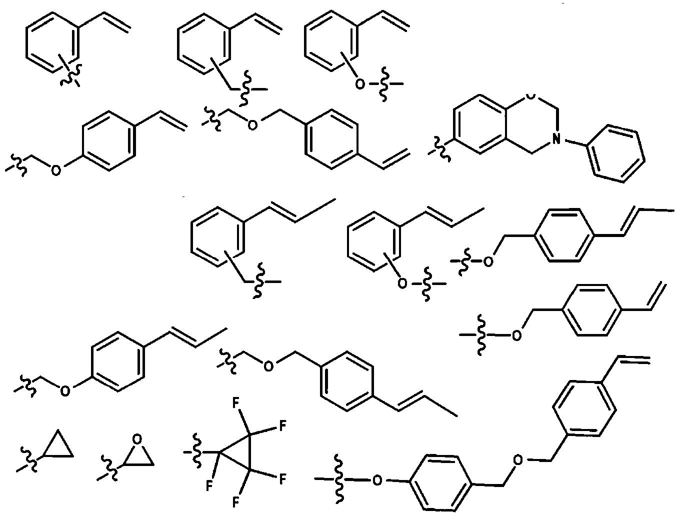 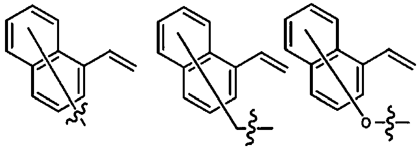 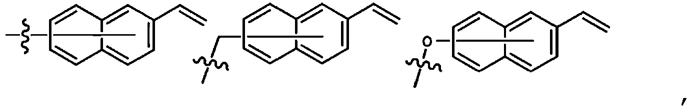 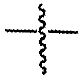
est un groupement à lier,
m1 est un nombre entier compris entre 1 et 3, et lorsque m1 est égal à 2 ou plus, deux ou plusieurs substituants entre parenthèses sont identiques ou différents les uns des autres, et
n1 est un nombre entier compris entre 1 et 5, et lorsque n1 est égal à 2 ou plus, deux ou plusieurs substituants entre parenthèses sont identiques ou différents les uns des autres.

2. Le composé de la revendication 1, dans lequel la formule chimique 1 est représentée par la formule chimique 2 ou 3 suivante : 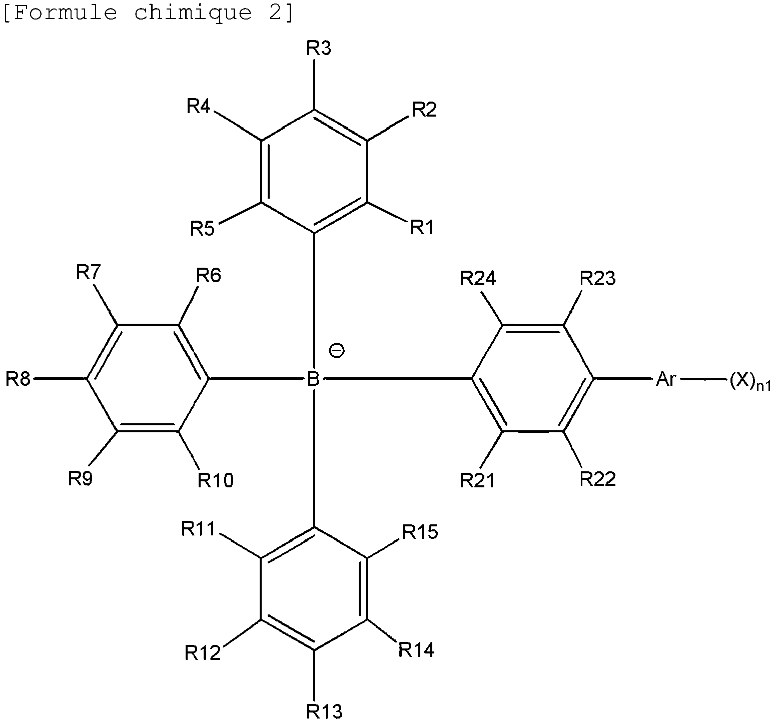 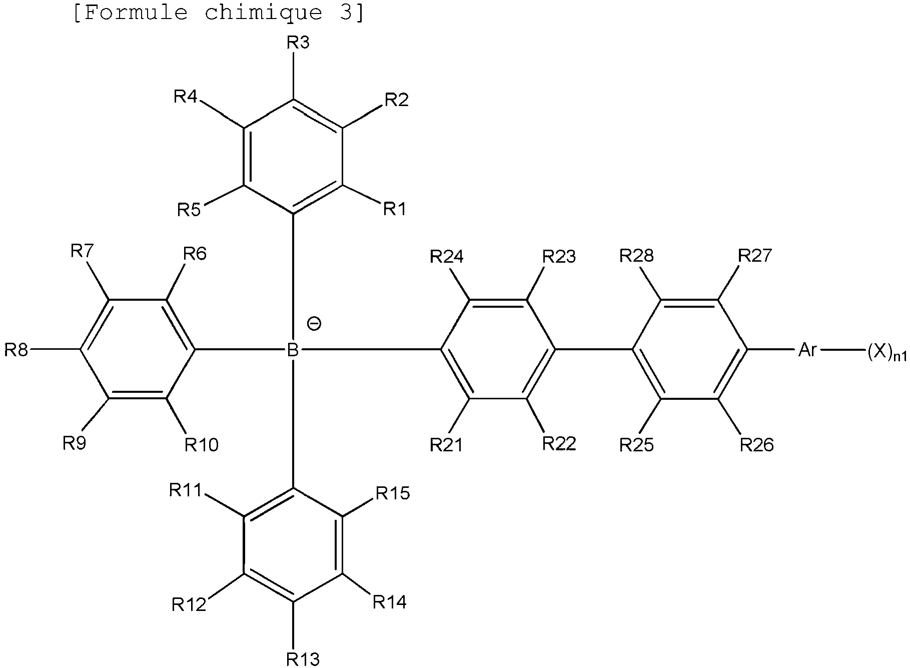 dans les formules chimiques 2 et 3,
R1 à R15, Ar, X et n1 sont identiques à ceux définis dans la formule chimique 1, et
R21 à R28 sont identiques ou différents les uns des autres, et sont chacun indépendamment un atome d'hydrogène, un atome de deutérium, un groupe fluoro, un groupe fluoroalkyle, un groupe cyano ou un groupe alkyle substitué ou non substitué.

3. Le composé de la revendication 1, dans lequel Ar est un groupe aryle (n1+1)-valent substitué ou non substitué ayant 6 à 30 atomes de carbone.

4. Le composé de la revendication 1, dans lequel la formule chimique 1 est représentée par la formule chimique 4 suivante : 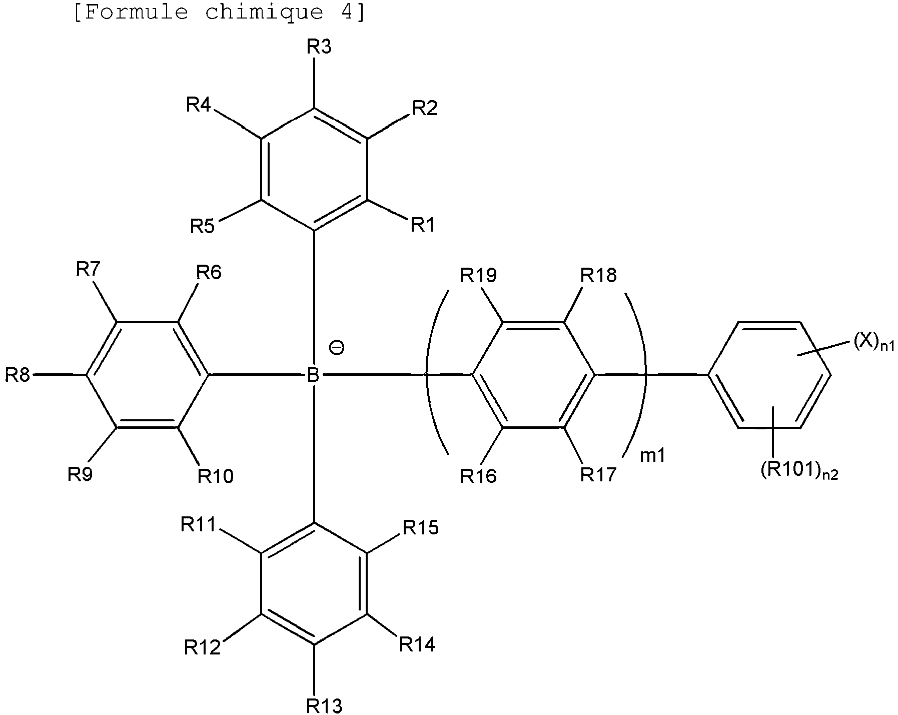 dans la formule chimique 4,
R1 à R19, X, n1 et m1 sont identiques à ceux définis dans la formule chimique 1,
R101 est un atome d'hydrogène ; un atome de deutérium ; un groupe halogène ; un groupe alkyle substitué ou non substitué ; un groupe alcoxy substitué ou non substitué ; un groupe aryle substitué ou non substitué ; ou un groupe hétéroaryle substitué ou non substitué, et
n2 est un nombre entier compris entre 0 et 4, et lorsque n2 est égal ou supérieur à 2, deux ou plusieurs R101 sont identiques ou différents les uns des autres, et n1+n2 est compris entre 1 et 5.

5. Le composé de la revendication 1, dans lequel la formule chimique 1 est représentée par la formule chimique 5 ou 6 suivante : 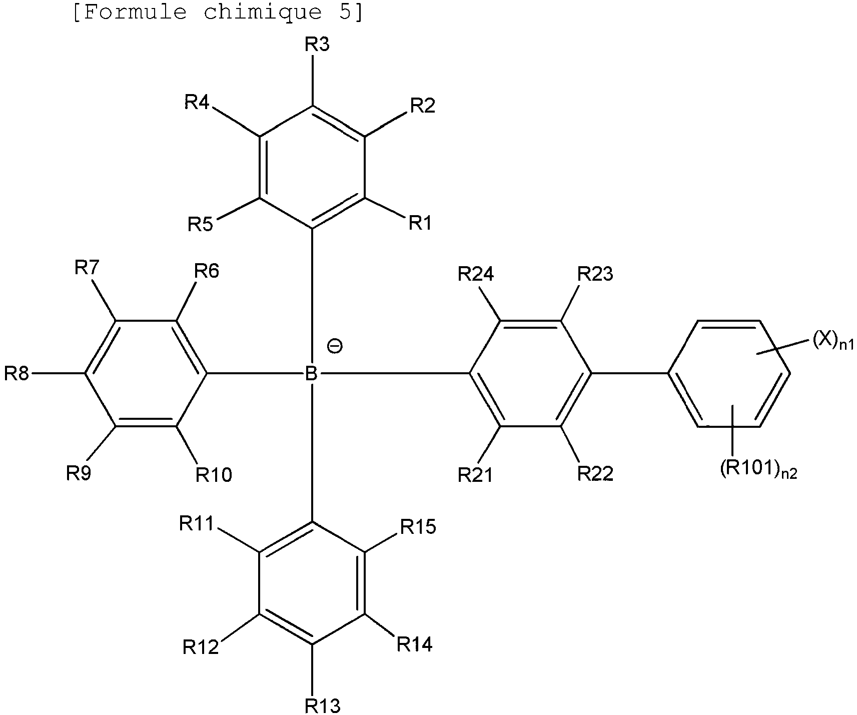 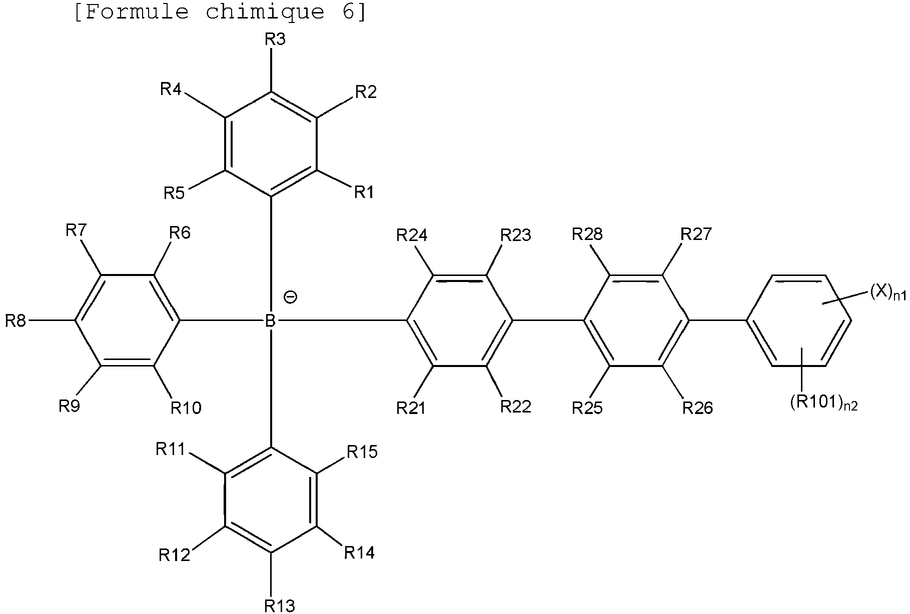 dans les formules chimiques 5 et 6,
R1 à R15, X et n1 sont identiques à ceux définis dans la formule chimique 1,
R21 à R28 sont identiques ou différents les uns des autres, et sont chacun indépendamment un atome d'hydrogène, un atome de deutérium, un groupe fluoro, un groupe fluoroalkyle, un groupe cyano ou un groupe alkyle substitué ou non substitué,
R101 est un atome d'hydrogène, un atome de deutérium, un groupe halogène, un groupe alkyle substitué ou non substitué, un groupe alcoxy substitué ou non substitué, un groupe aryle substitué ou non substitué ou un groupe hétéroaryle substitué ou non substitué, et
n2 est un nombre entier compris entre 0 et 4, et lorsque n2 est égal ou supérieur à 2, deux ou plusieurs R101 sont identiques ou différents les uns des autres, et n1+n2 est compris entre 1 et 5.

6. Le composé de la revendication 1, dans lequel R1 à R19 sont identiques ou différents les uns des autres, et sont chacun indépendamment un groupe fluoro ou un groupe fluoroalkyle.

7. Le composé de la revendication 1, comprenant en outre un contre-ion.

8. Le composé de la revendication 1, dans lequel la formule chimique 1 est représentée par l'un quelconque des composés suivants :

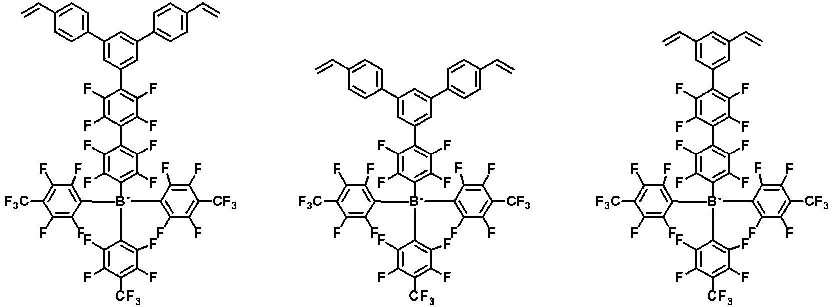

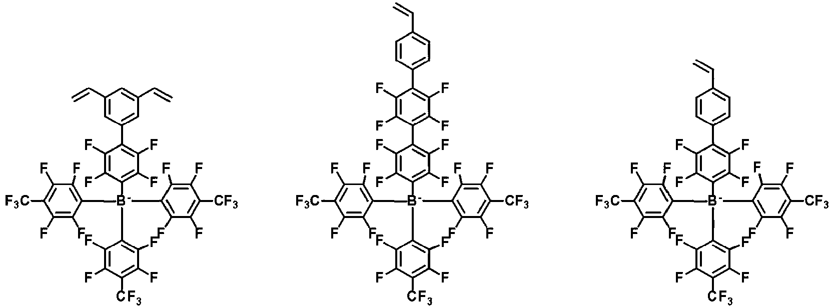

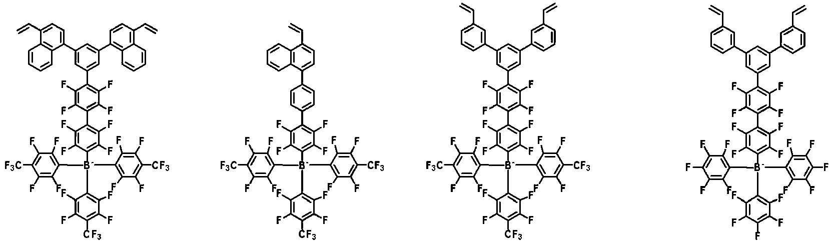

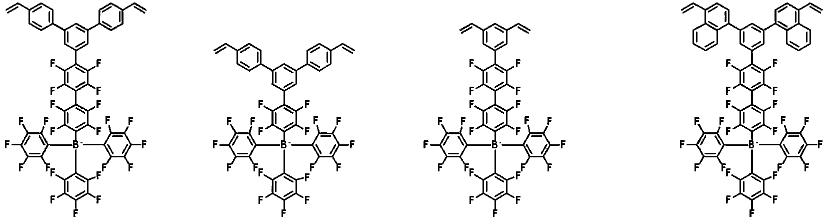

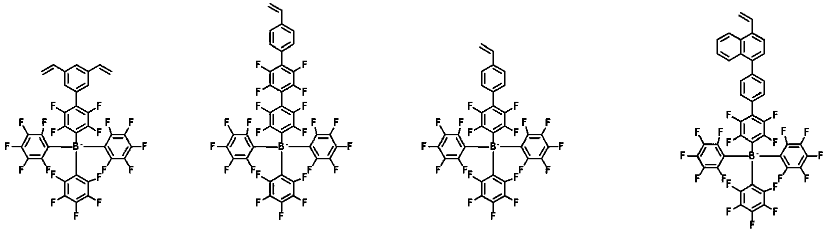

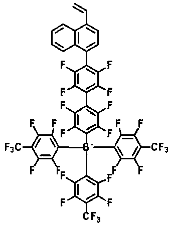

9. Composition de revêtement comprenant le composé de l'une quelconque des revendications 1 à 8.

10. Dispositif électroluminescent organique comprenant :
une première électrode ;
une deuxième électrode ; et
une couche de matériau organique comportant une ou plusieurs couches disposées entre la première électrode et la deuxième électrode,
dans lequel une ou plusieurs couches de la couche de matériau organique comprennent la composition de revêtement selon la revendication 9 ou un produit durci de celle-ci.

11. Le dispositif électroluminescent organique de la revendication 10, dans lequel la couche de matériau organique comprenant la composition de revêtement ou le produit durci de celle-ci est une couche de transport de trous ou une couche d'injection de trous.

12. Procédé de fabrication d'un dispositif électroluminescent organique, le procédé comprenant:
la préparation d'un substrat ;
la formation d'une première électrode sur le substrat ;
la formation d'une couche de matériau organique comportant une ou plusieurs couches sur la première électrode ; et
la formation d'une deuxième électrode sur la couche de matériau organique,
dans lequel la formation de la couche de matériau organique comprend la formation d'une couche de matériau organique comportant une ou plusieurs couches en utilisant la composition de revêtement de la revendication 9.

13. Le procédé de la revendication 12, dans lequel la formation de la couche de matériau organique comportant une ou plusieurs couches à l'aide de la composition de revêtement comprend :
le revêtement de la composition de revêtement sur la première électrode ; et
le traitement thermique ou le traitement par la lumière de la composition de revêtement appliquée.
